(19) Europäisches Patentamt
European Patent Office
Office européen des brevets

(11) EP 4 273 624 A1

(12) EUROPEAN PATENT APPLICATION

(43) Date of publication:
**08.11.2023 Bulletin 2023/45**

(21) Application number: **23170359.6**

(22) Date of filing: **27.04.2023**

(51) International Patent Classification (IPC):
***G03F 7/038*** *(2006.01)* ***G03F 7/004*** *(2006.01)*

(52) Cooperative Patent Classification (CPC):
**G03F 7/0387; G03F 7/0045; G03F 7/038**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.05.2022 JP 2022075700**

(71) Applicant: **SHIN-ETSU CHEMICAL CO., LTD.**
**Tokyo 1000005 (JP)**

(72) Inventors:
- **TAKEMURA, Katsuya**
  **Niigata (JP)**
- **IIO, Masashi**
  **Niigata (JP)**
- **URANO, Hiroyuki**
  **Niigata (JP)**

(74) Representative: **Sonnenhauser, Thomas Martin**
**Wuesthoff & Wuesthoff**
**Patentanwälte PartG mbB**
**Schweigerstraße 2**
**81541 München (DE)**

# (54) NEGATIVE PHOTOSENSITIVE RESIN COMPOSITION, PATTERNING PROCESS, INTERLAYER INSULATING FILM, SURFACE PROTECTION FILM, AND ELECTRONIC COMPONENT

(57) A negative photosensitive resin composition having a high resolution, mechanical strength, adhesion and the like, as well as excellent storage stability. A negative photosensitive resin composition, including: (A) one or more structures selected from a polyimide structure, a polyamide structure, a polybenzoxazole structure, a polyamideimide structure, and precursor structures thereof; (B) a photoacid generator; (C) one or more kinds of crosslinking agent selected from an amino condensate modified with formaldehyde or formaldehyde-alcohol, a phenol compound having on average two or more methylol groups or alkoxymethylol groups within one molecule, a compound in which a hydrogen atom of a hydroxyl group of polyhydric phenol is substituted with a glycidyl group or a group having a glycidyl group, a compound in which a hydrogen atom of a hydroxyl group of polyhydric phenol is substituted with a substituent represented by the formula (C-1), a compound represented by the formula (C-15), and a compound containing two or more nitrogen atoms having a glycidyl group represented by the formula (C-2); (D) an onium salt represented by the formula (1); and (E) a solvent.

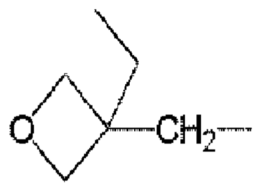
(C-1)

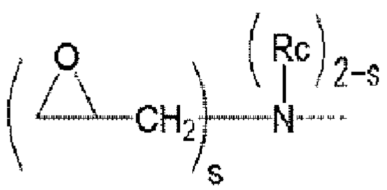 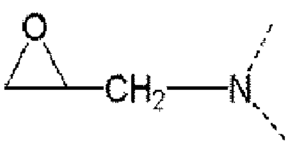
(C-2)

EP 4 273 624 A1

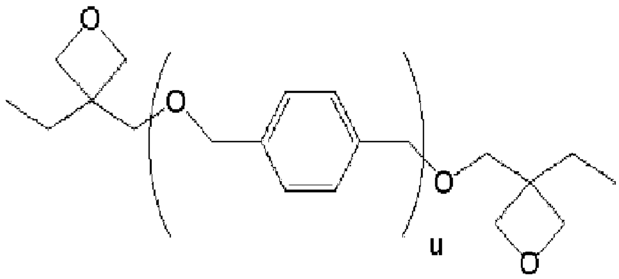

(C-15)

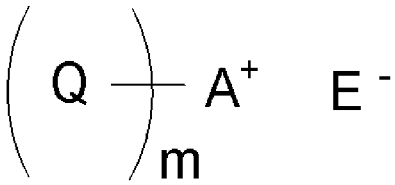

(1)

## Description

TECHNICAL FIELD

The present invention relates to a negative photosensitive resin composition obtained by using an alkali-soluble resin containing at least one or more structures selected from a polyimide structure, a polyamide structure, a polybenzoxazole structure, a polyamideimide structure, and precursor structures thereof.

Further, the present invention also provides a patterning process and a cured film forming process using the composition, and relates to an electronic component having the cured film.

BACKGROUND ART

Along with the size reduction and the improved performance of various electronic instruments including personal computers, digital cameras, mobile phones, and the like, there is a rapidly increasing demand for further miniaturization, thin profile, and high density of semiconductor devices. Accordingly, development of a photosensitive insulating material, which can accommodate an increase of substrate area for improved productivity and also has fineness and a high aspect ratio on substrates in the high-density packaging technologies typified by chip size packages, chip scale packages (CSP) or three-dimensional lamination, has been desired.

In high-density packaging technologies such as three-dimensional lamination, as photosensitive insulating materials that can be patterned on substrates, polyimide films have been used as protective coating or insulating layers, and their insulating properties, mechanical strength, adhesion to substrates, and the like are attracting attention, and development thereof has been currently active.

Heretofore, as a photosensitive polyimide-based material, a material using a polyamic acid, which is a precursor of a polyimide, such as a material in which a photosensitive group is introduced into a carboxyl group of a polyamic acid by an ester bond has been proposed (Patent Document 1 and Patent Document 2). However, in these technologies, in order to obtain a desired polyimide film after forming a patterned film, an imidization treatment at a high temperature exceeding 300°C is essential; therefore, to withstand such a high temperature, there are problems including restriction of the underlying base material or oxidation of the copper of wiring.

To overcome this drawback, a photosensitive polyimide obtained by using a solvent-soluble resin that has already been imidized for the purpose of lowering the post-curing temperature has been proposed (Patent Document 3 and Patent Document 4). According to Patent Document 3, the negative photosensitive resin composition obtained by using a polyimide is subjected to development using N-methyl-2-pyrrolidone (NMP) during the patterning. However, for N-methyl-2-pyrrolidone, there is a concern about environmental load and health hazard, particularly absorption respiratory organs toxicity. In particular, N-methyl-2-pyrrolidone is included in the list of SVHC (Substances of Very High Concern) in the European REACH (Registration, Evaluation, Authorization and Restriction of Chemicals) regulations. For these reasons, N-methyl-2-pyrrolidone is a solvent that should be avoided as much as possible. In addition, Patent Document 3 does not specifically describe the resolution performance in patterning.

Patent Document 4 discloses an example of a patterning process of a photosensitive resin composition using a material utilizing a polyamic acid, which is a precursor of a polyimide, such as a resin in which an ester bond is introduced into a carboxyl group of a polyamic acid. In this process, the heating for obtaining a desired polyimide film after further forming a film can be carried out at a relatively low temperature, i.e., 250°C. However, N-methyl-2-pyrrolidone is used as the solvent of this photosensitive resin composition, and an organic solvent of N-methyl-2-pyrrolidone is used in the development step. As described above, using an organic solvent of N-methyl-2-pyrrolidone for the developer should be avoided as much as possible. In addition, Patent Document 4 does not disclose specific resolution.

Further, Patent Document 5 relates to patterning of a negative photosensitive resin composition using a polyimide precursor. Although a N-methyl-2-pyrrolidone-based solvent is used for this photosensitive resin composition, cyclopentanone is used for the development of the photosensitive resin composition. Patent Document 5 specifically discloses the resolution performance, stating that an aspect ratio of 1 or more can be achieved. However, this aspect ratio is not a ratio of a finished film thickness or a pattern height to a pattern dimension, but a ratio of a film thickness to a dimension after the coating and drying. This resolution performance is not a practical numerical value and needs to be improved. In addition, although it is preferable to use a general-purpose organic solvent, such as cyclopentanone, as a developer, in the case of using an organic solvent, there may be a defect that the pattern shape immediately after the development is likely to form an overhang profile due to swelling of the film during the development.

On the other hand, the photosensitive resin composition proposed in Patent Document 6 is produced by using a base resin that is already imidized and has been constructed in view of low-temperature curing. Since the solvent for this composition is cyclopentanone and an aqueous alkaline solution is used in the development step, the use of N-methyl-2-pyrrolidone can be avoided. However, the resolution performance still needs to be improved. More specifically, the patterning using the photosensitive resin composition described in Patent Document 6 is carried out with an ultra-thin film, and the pattern size subjected to the resolution is large. This insufficient resolution performance is caused by the poor solubility of the polyimide resin as the base resin disclosed in Patent Document 6 in an aqueous alkaline solution used as the developer. Increasing the solubility in the developer is the key to improving the resolution performance in the patterning.

In fact, the necessary aspect ratio (finished film thickness (or pattern height)/pattern dimension) of a formed pattern is 1 or more and about 2 as the resolution performance of a photosensitive insulating material in high-density packaging technologies, such as three-dimensional lamination, that are in demand in recent years. That is, when a desired finished film thickness or pattern height is 10 μm, a pattern having a size of 10 um or less or a size close to 5 um needs be formed.

Patent Documents 7 and 8 disclose an example of a negative photosensitive resin composition having high resolution performance required for the high-density packaging technologies. Patent Documents 7 and 8 disclose a chemically amplified photosensitive resin composition that causes a crosslinking reaction using an acid serving as a catalyst generated from a photoacid generator, thus making it insoluble in a developer of an aqueous alkaline solution, thereby obtaining a negative pattern. The chemically amplified negative photosensitive resin composition has an advantage in that high resolution performance can be achieved, and an increase in the resolution can be achieved by further adding a basic compound. However, the base resin used in the photosensitive resin composition of Patent Document 7 is a novolak resin, and the base resin used in the photosensitive resin composition of Patent Document 8 is a polymer compound with a silicone skeleton, which are not a polyimide-based base resin having the insulating properties, mechanical strength, adhesion to substrates, and the like, which are considered important in high-density packaging technologies such as three-dimensional lamination.

In contrast, when a polyimide-based polymer compound is used as the base resin of the chemically amplified negative photosensitive resin composition, a problem of poor storage stability may occur time to time, for example, as the thickness of the film obtained by applying the photosensitive resin composition onto a substrate increases over time.

Therefore, it is expected that the miniaturization of a pattern in a rewiring technique of an insulating protective film will further be advanced along with the increases in density and integration of chips in the future; accordingly, for a photosensitive resin composition obtained by using a polymer having a polyimide or a polyimide precursor structure unit, a composition capable of realizing a high resolution without impairing the polyimide pattern obtained by heating or the excellent characteristics such as mechanical strength, adhesion, and the like of the protective coating is strongly desired.

It is also strongly desired that the photosensitive resin composition is a stable composition which does not change during storage.

More specifically, it is desired to rapidly develop a photosensitive resin composition satisfying all of these features.

CITATION LIST

PATENT LITERATURE

Patent Document 1: Japanese Laid-Open Patent Application Publication No. S49-115541
Patent Document 2: Japanese Laid-Open Patent Application Publication No. S55-45746
Patent Document 3: JP3232022B
Patent Document 4: Japanese Laid-Open Patent Application Publication No. 2005-49504
Patent Document 5: International Publication No. WO2013/168675
Patent Document 6: JP5417623B
Patent Document 7: JP5981465B
Patent Document 8: JP6352853B

SUMMARY OF INVENTION

TECHNICAL PROBLEM

The present invention was made in view of the above circumstances, and an object thereof is to provide a chemically amplified negative photosensitive resin composition that allows for alkaline development and that can form fine patterns and achieve a high resolution, and has excellent features such as mechanical strength, adhesion, and the like, as well as excellent storage stability.

Furthermore, the polymers containing polyamide, polyamideimide, polyimide, polyimide precursor, polybenzoxazole, and polybenzoxazole precursor that can be used for the composition of the present invention are intended to provide a chemically amplified negative photosensitive resin composition easily soluble in versatile and safe organic solvents.

Furthermore, another object of the present invention is to provide a negative photosensitive resin composition that can be cured at a low temperature, i.e., 200°C or less, and achieves a high glass transition point (Tg.), and the cured film thereof on which patterns are formed has excellent mechanical strength and heat resistance.

SOLUTION TO PROBLEM

In order to achieve the above objects, the present invention provides:
a negative photosensitive resin composition, comprising:

(A) an alkali-soluble resin including at least one or more structures selected from a polyimide structure, a polyamide structure, a polybenzoxazole structure, a polyamideimide structure, and precursor structures thereof;
(B) a photoacid generator;
(C) one or two or more kinds of crosslinking agent selected from an amino condensate modified with formaldehyde or formaldehyde-alcohol, a phenol compound having on average two or more methylol groups or alkoxymethylol groups within one molecule, a compound in which a hydrogen atom of a hydroxyl group of polyhydric phenol is substituted with a glycidyl group or a group having a glycidyl group, a compound in which a hydrogen atom of a hydroxyl group of polyhydric phenol is substituted with a substituent represented by the following formula (C-1), a compound represented by the following formula (C-15) having a substituent (C-1), and a compound containing two or more nitrogen atoms having a glycidyl group represented by the following formula (C-2);

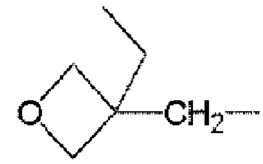
(C-1)

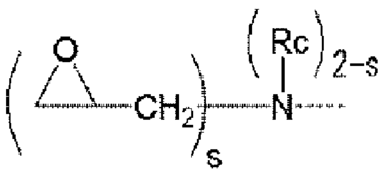
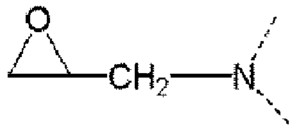
(C-2)

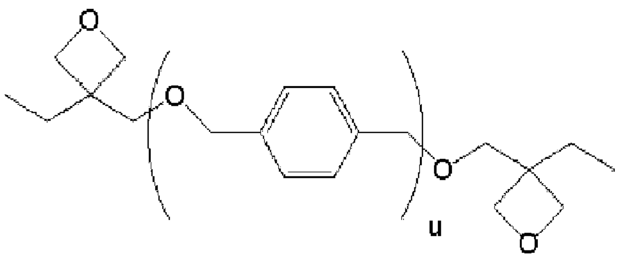
(C-15)

wherein the broken line represents a bond, Rc represents a linear, branched, or cyclic alkyl group having 1 to 6 carbon atoms; s represents 1 or 2; u is a number satisfying 1≤u≤3,
(D) an onium salt represented by the following general formula (1); and

$$\left(Q-\right)_m A^+ \quad E^- \qquad (1)$$

wherein A represents iodine, sulfur, phosphorus, or nitrogen; each Q is identical to or different from one another and represents a monovalent hydrocarbon group having 1 to 100 carbon atoms, which may be linked, substituted, or intervened by a heteroatom; $E^-$ represents an anion of an organic or inorganic acid salt; and m represents 2 when A is iodine, m represents 3 when A is sulfur, and m represents 4 when A is phosphorus or nitrogen,

(E) a solvent.

In the present invention, the photoacid generator as the component (B) generates an acid in the coated film of the photosensitive resin composition by being exposed to light. Furthermore, with the generated acid serving as a catalyst, a cross-linking reaction between the crosslinking agent as the component (C) and the alkali-soluble resin as the component (A) proceeds, making the component (A) insoluble in an alkaline developer, thereby giving a chemically amplified photosensitive resin composition capable of negative pattern formation.

Herein, the negative photosensitive resin composition in which the component (D) is added to the aforementioned composition exhibits excellent resolution performance, and has excellent features such as mechanical strength, adhesion, and the like, thus giving a negative photosensitive resin composition capable of alkaline development ensuring superior storage stability.

Further, the component (D) is preferably a quaternary ammonium salt represented by the following general formula (1-1), in which A in the general formula (1) is nitrogen,

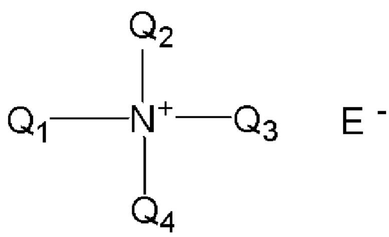

(1 − 1)

wherein each of $Q_1$, $Q_2$, $Q_3$, and $Q_4$ is identical to or different from one another and represents a monovalent hydrocarbon group having 1 to 100 carbon atoms, which may be linked, substituted, or intervened by a heteroatom; and E- represents an anion of an organic or inorganic acid salt as defined above.

Such a negative photosensitive resin composition makes it possible to achieve excellent resolution, thus giving a more suitable negative photosensitive resin composition.

Further, in the component (D), $E^-$ in the general formula (1) is preferably an anion of an organic carboxylic acid represented by the following general formula (6),

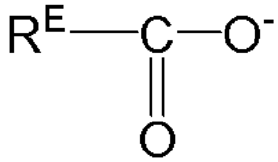

(6)

wherein $R^E$ represents a hydrocarbon group having 1 to 100 carbon atoms, which may be substituted with a heteroatom or intervened by a heteroatom.

Such a negative photosensitive resin composition makes it possible to give a more suitable negative photosensitive resin composition.

Further, the component (A) is preferably an alkali-soluble resin, comprising at least one or more structures selected from a polyimide structure, a polyamide structure, a polybenzoxazole structure, a polyamideimide structure, and precursor structures thereof, each of which is a reaction product of a diamine comprising one or more diamines represented by the following general formula (2) or the following general formula (3), and one or more of tetracarboxylic acid dianhydride represented by the following general formula (4) and a dicarboxylic acid or dicarboxylic acid halide represented by the following general formula (5),

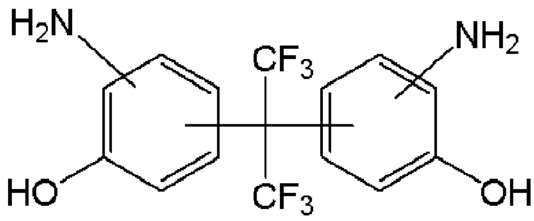

(2)

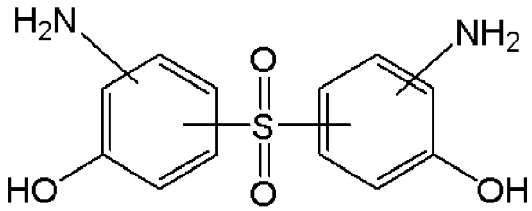

(3)

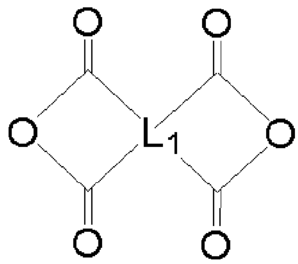

(4)

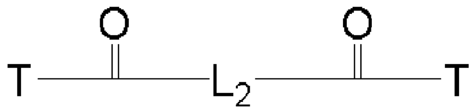

(5)

wherein $L_1$ represents a tetravalent hydrocarbon group having 1 to 100 carbon atoms, which may be substituted with a heteroatom or intervened by a heteroatom; wherein $L_2$ represents a divalent hydrocarbon group having 1 to 100 carbon atoms, which may be substituted with a heteroatom or intervened by a heteroatom; T represents any of a hydroxy group, a fluorine atom, a chlorine atom, a bromine atom, an iodine atom, $-OCO_2R^T$, $-OSO_2R^T$, and $-OSO_3R^7$, provided that $R^T$ represents a monovalent hydrocarbon group having 1 to 10 carbon atoms, which may be substituted with a heteroatom or intervened by a heteroatom.

Further, in the component (B), the acid generated by the photoacid generator is preferably an organic sulfonic acid represented by the following general formula (7),

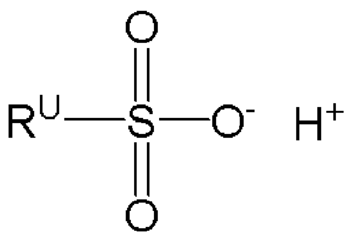

(7)

wherein $R^U$ represents a hydrocarbon group having 1 to 100 carbon atoms, which may be substituted with a heteroatom or intervened by a heteroatom.

Such a negative photosensitive resin composition makes it possible to increase a dissolution contrast, thus giving a negative photosensitive resin composition with a high resolution.

Further, the component (A) is preferably an alkali-soluble resin, comprising at least one or more structures selected from a polyimide structure, a polyamide structure, a polybenzoxazole structure, a polyamideimide structure, and precursor structures thereof, each of which is a reaction product of one or more of a tetracarboxylic acid dianhydride represented by the following general formula (8) and a dicarboxylic acid or dicarboxylic acid halide represented by the following general formula (9),

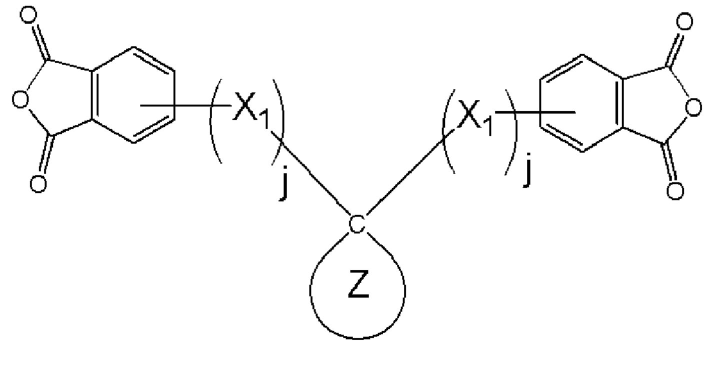

(8)

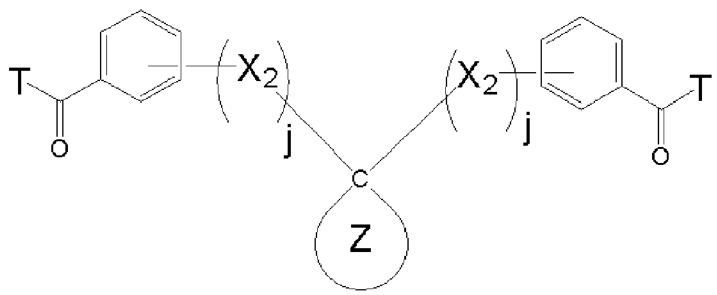

(9)

wherein Z represents an alicyclic structure, an alicyclic structure connected to an aromatic ring, a heteroatom-containing or heteroatom-intervened alicyclic structure, or a heteroatom-containing or heteroatom-intervened alicyclic structure connected to an aromatic ring, each of which has 3 to 20 carbon atoms; T represents any of a hydroxy group, a fluorine atom, a chlorine atom, a bromine atom, an iodine atom, $-OCO_2R^T$, $-OSO_2R^T$, and $-OSO_3R^T$; j represents 0 or 1; when j is 0, the phthalic anhydride structure and the cyclic structure Z in the general formula (8) and the benzoic acid structure and the cyclic structure Z in the general formula (9) are directly bonded; and when j is 1, $X_1$ and $X_2$ represent a divalent linkage group.

Such an alkali-soluble resin can be easily soluble in versatile and safe organic solvents. The resin is thus useful for the construction of a negative photosensitive resin composition.

In the present invention, the amide structure unit or the imide structure unit of the polymer having a polyamide, polyamideimide, polyimide structure, polybenzoxazole structure, or a precursor structure unit thereof obtained by reacting one or more of the tetracarboxylic acid dianhydride represented by the general formula (8) and the dicarboxylic acid or dicarboxylic acid halide represented by the general formula (9) is formed in advance at the time of polymer synthesis. Therefore, in the heat curing of the photosensitive resin composition containing the polymer after the pattern formation, no reaction such as an imide ring-closing reaction is necessary; thus, a high heating temperature such as that for an imidization reaction is not necessary. In addition, since an amide structure unit or an imide structure unit is formed, an elimination reaction does not occur. Thus, there is an advantage in that film shrinkage during the heat treatment is small.

Further, the alicyclic structure Z in the general formulae (8) and (9) is preferably a structure represented by the following general formula (10) or (11),

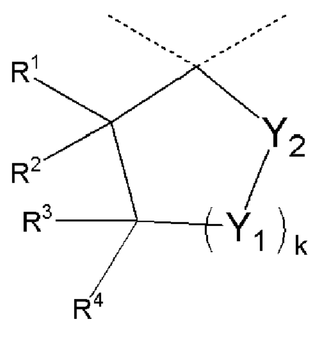

(10)

wherein the broken line represents a bond; and k represents 0 or an integer of 1 or more; when k = 0, $Y_2$ represents a divalent group selected from any of the following general formulae (13), (14), (15), and (16); when k = 1, $Y_1$ represents

a divalent group selected from any of the following general formulae (17), (18), and (19), and $Y_2$ represents a divalent group selected from any of the following general formulae (13), (14), (15), and (16); when k is 2 or more, $Y_1$ represents the following general formula (17), and $Y_2$ represents a divalent group selected from any of the following general formulae (13), (14), (15), and (16); $R^1$, $R^2$, $R^3$, and $R^4$, and $R^5$ and $R^6$ in the following formula (16) represent identical or different substituents, each representing a hydrogen atom, a methyl group, an ethyl group, a linear, branched, or cyclic alkyl group having 3 to 12 carbon atoms; or $R^1$, $R^2$, $R^3$, $R^4$, $R^5$ and $R^6$ are bonded together to form an alicyclic or aromatic ring,

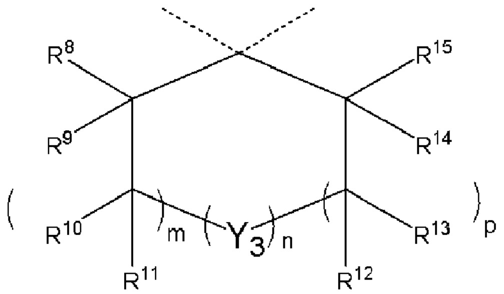
(11)

wherein the broken line represents a bond, and $R^8$, $R^9$, $R^{10}$, $R^{11}$, $R^{12}$, $R^{13}$, $R^{14}$, and $R^{15}$ represent identical or different substituents, each representing a hydrogen atom, a methyl group, an ethyl group, a linear, branched, or cyclic alkyl group having 3 to 12 carbon atoms; m and p represent 0 or an integer of 1 to 9; and n represents 0 or 1; $Y_3$ represents a divalent group selected from any of the following general formulae (12), (13), (14), (15), (16), (17), (18) and (19),

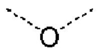 (12) 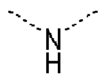 (13) 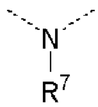 (14) 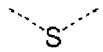 (15)

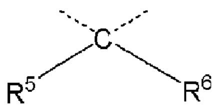 (16) 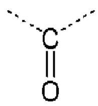 (17) 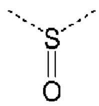 (18) 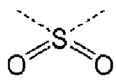 (19)

wherein the broken line represents a bond; $R^5$ and $R^6$ are as defined above; and $R^7$ represents a methyl group, an ethyl group, a linear, branched, or cyclic alkyl group having 3 to 12 carbon atoms.

When such an alkali-soluble resin is used, the resin can be easily soluble in versatile and safe organic solvents. The resin is thus useful for the construction of a negative photosensitive resin composition, and makes it possible to obtain a more suitable negative photosensitive resin composition.

Further, the divalent linkage groups $X_1$ and $X_2$ in the general formulae (8) and (9) preferably have a structure represented by any of the following general formulae (20), (21), (22), (23), (24), and (25),

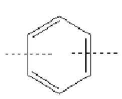 (20) 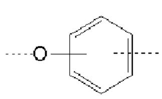 (21) 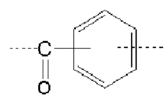 (22)

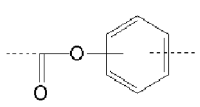 (23) 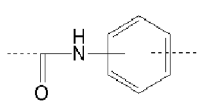 (24) 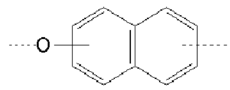 (25)

wherein the broken line represents a bond.

When such an alkali-soluble resin is used, the resin can be easily soluble in versatile and safe organic solvents. The resin is thus useful for the construction of a negative photosensitive resin composition, and makes it possible to obtain a more suitable negative photosensitive resin composition.

Further, the diamine represented by the general formula (2) is preferably a diamine represented by the following general formula (26).

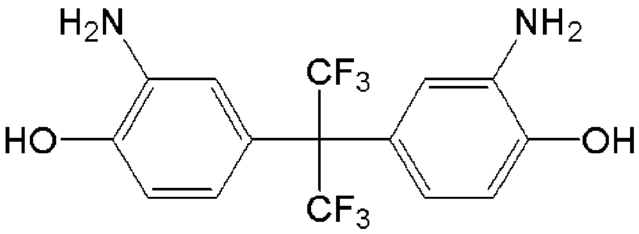

(2 6)

With such a negative photosensitive resin composition, an aqueous alkaline solution can be used as a developer in the development step upon the pattern formation.

Further, the component (A) is preferably an alkali-soluble resin comprising at least one or more structures selected from a polyimide structure, a polyamide structure, a polybenzoxazole structure, a polyamideimide structure, and precursor structures thereof, each of which is a reaction product further comprising a tetracarboxylic acid diester compound represented by the following general formula (27),

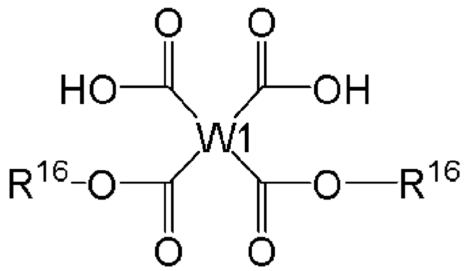

(2 7)

wherein W1 is a tetravalent organic group, and $R^{16}$ is represented by the following general formula (28),

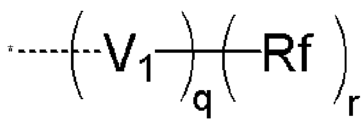

(2 8)

wherein the broken line represents a bond; $V_1$ represents a (r+1)-valent organic group; Rf represents a linear, branched or cyclic alkyl group or an aromatic group having 1 to 20 carbon atoms in which a part or all of the hydrogen atoms are substituted with a fluorine atom; r represents 1, 2 or 3; and q represents 0 or 1.

By using such an alkali-soluble resin, it is possible to obtain a suitable negative photosensitive resin composition more easily dissolved in versatile and safe organic solvents.

Further, $R^{16}$ in the general formula (27) is preferably an organic group selected from any of the groups represented by the following general formulae (29), (30), (31), and (32),

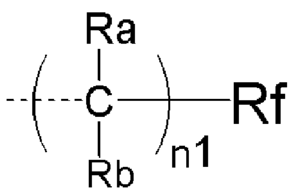

(2 9)

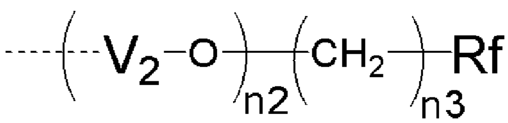

(3 0)

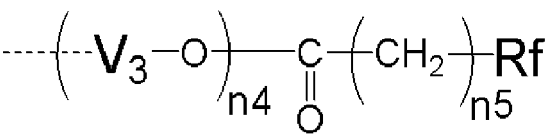

(3 1)

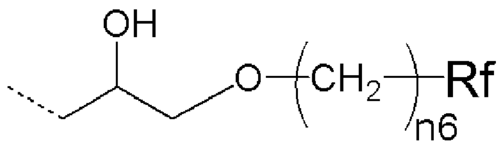

(32)

wherein the broken line represents a bond; Rf is as defined above; each of Ra and Rb is a hydrogen atom or an alkyl group having 1 to 3 carbon atoms; each of $V_2$ and $V_3$ is a linear or branched alkylene group having 1 to 6 carbon atoms; n1 is an integer of 0 to 6; n2 is an integer of 1 to 6; n3 is an integer of 0 to 6; n4 is an integer of 1 to 6; n5 is an integer of 0 to 6; and n6 is 0 or 1.

When such an alkali-soluble resin is used, it is possible to obtain a more suitable negative photosensitive resin composition.

Further, $R^{16}$ in the general formula (27) is preferably a group represented by the following general formula (28-1),

$$\cdots\cdots CH_2—CH_2—Rf \qquad (28-1)$$

wherein the broken line represents a bond; and Rf is as defined above.

When such an alkali-soluble resin is used, it is possible to obtain a more suitable negative photosensitive resin composition.

Further, the component (A) is preferably an alkali-soluble resin including at least one or more structures selected from a polyimide structure, a polyamide structure, a polybenzoxazole structure, a polyamideimide structure, and precursor structures thereof, which is a reaction product of one or more of a tetracarboxylic acid dianhydride in which the alicyclic structure Z in the general formula (8) is represented by the following general formula (33) or (34) and/or a dicarboxylic acid or dicarboxylic acid halide in which the alicyclic structure Z of the general formula (9) is selected from any of the following general formulae (35), (36), (37), (38), (39), and (40),

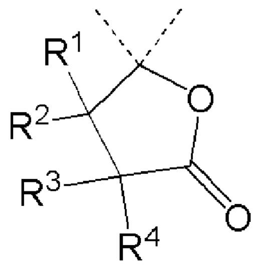

(33)

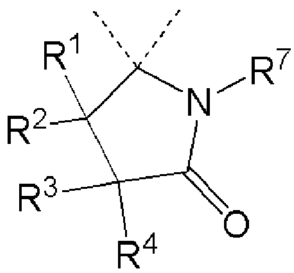

(34)

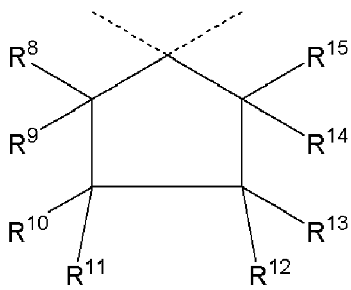

(35)

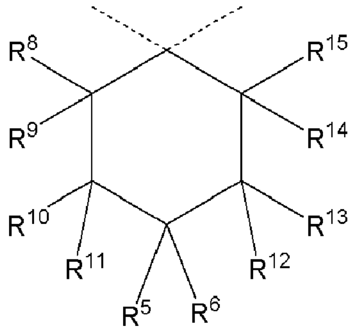

(3 6)

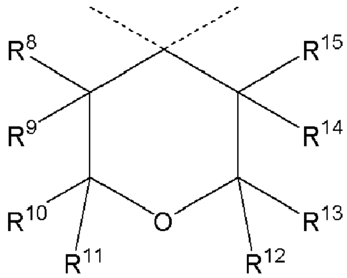

(3 7)

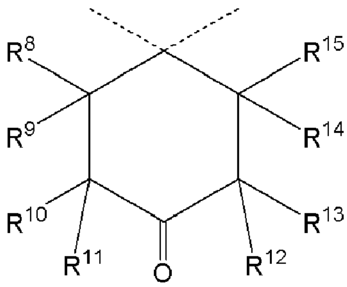

(3 8)

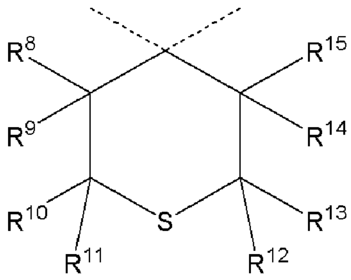

(3 9)

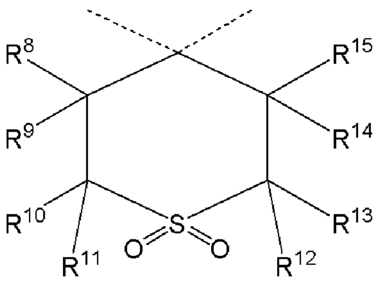

(4 0)

wherein the broken line represents a bond; $R^1$, $R^2$, $R^3$, $R^4$, $R^5$ and $R^6$ represent identical or different substituents, each representing a hydrogen atom, a methyl group, an ethyl group, a linear, branched, or cyclic alkyl group having 3 to 12 carbon atoms; or $R^1$, $R^2$, $R^3$, $R^4$, $R^5$ and $R^6$ are bonded together to form an alicyclic or aromatic ring; $R^7$ represents a methyl group, an ethyl group, a linear, branched, or cyclic alkyl group having 3 to 12 carbon atoms; $R^8$, $R^9$, $R^{10}$, $R^{11}$, $R^{12}$, $R^{13}$, $R^{14}$, and $R^{15}$ represent identical or different substituents, each representing a hydrogen atom, a methyl group,

an ethyl group, a linear, branched, or cyclic alkyl group having 3 to 12 carbon atoms.

When such an alkali-soluble resin is used, it is possible to obtain a more suitable negative photosensitive resin composition.

Further, the present invention provides a patterning process, comprising the steps of:

(1) applying the negative photosensitive resin composition described above onto a substrate to form a photosensitive material film;
(2) after heating the photosensitive material film, exposing the photosensitive material film to a high-energy beam having a wavelength of 190 to 500 nm or an electron beam through a photomask; and
(3) developing the exposed photosensitive material film using an aqueous alkaline solution as the developer.

Such a patterning process enables alkaline development using an aqueous alkaline solution.

Further, the patterning process of the present invention preferably further comprises the step of:
(4) post-curing the developed photosensitive material film by heating at a temperature of 100 to 300°C.

Such a patterning process is capable of increasing the crosslinking density of the film of the photosensitive resin composition and removing any residual volatile components, and is preferable in terms of adhesion to substrates, heat resistance, strength, and electric properties.

Further, the present invention provides an interlayer insulating film comprising a cured product of the negative photosensitive resin composition.

Such an interlayer insulating film can serve as an insulating film excellent in adhesion to substrates, heat resistance, electric properties, mechanical strength, and chemical resistance with respect to an alkaline stripping solution or the like.

Further, the present invention provides a surface protection film comprising a cured product of the negative photosensitive resin composition.

Such a surface protection film can serve as a protection film excellent in adhesion to substrates, heat resistance, electric properties, mechanical strength, and chemical resistance with respect to an alkaline stripping solution or the like.

Further, the present invention provides an electronic component having an interlayer insulating film of the negative photosensitive resin composition.

With such an electronic component, it is possible to provide an electronic component excellent in reliability.

Further, the present invention provides an electronic component having a surface protection film of the negative photosensitive resin composition.

With such an electronic component, it is possible to provide an electronic component excellent in reliability.

After patterning and heat-curing the photosensitive resin composition of the present invention, the cured film and the cured pattern become a very stable polyimide resin film, thus making it possible to form a cured film with significantly improved resistance to chemicals, especially to a very strong alkaline stripping solution that is used to strip resist patterns for plating used in the step of forming metal wires. These cured films on which patterns are formed can then be used as excellent protective coating or insulating protective coating of electric/electronic components.

ADVANTAGEOUS EFFECTS OF INVENTION

The present invention can provide a chemically amplified negative photosensitive resin composition that allows for alkaline development and that can form fine patterns and achieve a high resolution, and has excellent features such as mechanical strength, adhesion, and the like, as well as excellent storage stability.

Furthermore, the polymers containing polyamide, polyamideimide, polyimide, polyimide precursor, polybenzoxazole, and polybenzoxazole precursor that can be used for the composition of the present invention can provide a chemically amplified negative photosensitive resin composition easily soluble in versatile and safe organic solvents.

DESCRIPTION OF EMBODIMENTS

As described above, a photosensitive resin composition obtained by using a resin, which is a polymer containing at least one or more structures selected from a polyimide structure, a polyamide structure, a polybenzoxazole structure, a polyamideimide structure, and precursor structures thereof, and having excellent features such as mechanical strength, adhesion, or the like, as well as high resolution performance and excellent storage stability, has been in demand.

In order to achieve the above object, the present inventors have first analyzed, in a chemically amplified negative photosensitive resin composition which ensures high resolution performance, why the film thickness formed by coating a photosensitive resin composition on a substrate increases over time and causes poor storage stability when a polyimide-based polymer compound is used. Then, as a result of further intensive studies, the present inventors found that a composition having desirable storage stability can be obtained without impairing the resolution performance by using

an onium salt represented by the above general formula (1) in a chemically amplified negative photosensitive resin composition.

That is, the present inventors assumed that, a basic compound added to a chemically amplified photosensitive resin composition for the purpose of obtaining high resolution has a behavior of causing molecular condensation with a polyimide-based polymer compound during the storage, and an apparent molecular weight of the polymer compound increases, thereby causing the problematic increase in thickness over time of the film formed by application on a substrate. Then, the present inventors intensively studied resolutions of this problem to complete the present invention.

In the chemically amplified negative photosensitive resin composition, by adding a resin of a polymer compound, a photoacid generator, and also a crosslinking agent capable of causing a crosslinking reaction with the polymer compound by using an acid generated from the photoacid generator upon irradiation with light as a catalyst, a crosslinking reaction proceeds in an exposed portion and the polymer compound is insolubilized in a developer. As a result, a negative photosensitive resin composition is obtained.

At this time, a small amount of a basic compound capable of reacting with an acid generated from the photoacid generator is often added. By thus adding a small amount of the basic compound, the crosslinking reaction does not proceed when the light-exposure amount is low because the basic compound neutralizes the acid generated from the photoacid generator; however, at a light-exposure amount at which the amount of the generated acid is larger than the amount neutralized by the addition of the basic compound, the amount of the generated acid increases and the crosslinking reaction proceeds; as a result, the insolubilization in a developer proceeds. That is, by adding a small amount of the basic compound, it is possible to greatly change the solubility in the developer with a change in the light-exposure amount, thereby increasing the so-called dissolution contrast. The addition of a small amount of the base compound can increase the dissolution contrast in the developer; as a result, the high resolution performance of the chemically amplified photosensitive resin composition can be achieved.

However, when a basic compound is added to a photosensitive resin composition obtained by using a polymer compound, which is a polymer having at least one or more structures selected from a polyimide structure, a polyamide structure, a polybenzoxazole structure, a polyamideimide structure, and precursor structures thereof, since the basic compound and the imide structure or the amide structure are very strongly interacted with each other, intermolecular aggregation is assumed to proceed in the composition solution. Thus, the apparent molecular weight of the polymer compound increases during the storage of the solution, thus increasing the thickness of the film obtained by applying the photosensitive resin composition on a substrate over time, which causes the problem of poor storage stability.

Therefore, the present inventors conducted intensive study in light of the problems described above, and, as a result, they found that a photosensitive resin composition obtained by using a polymer of a polyamide, a polyamideimide, a polyimide, a polyimide precursor, a polybenzoxazole, or a polybenzoxazole precursor, which contains a specific onium salt, has desirable storage stability, is soluble in an organic solvent that is versatile and safe as a solvent of the composition, and can be used as a base resin of the photosensitive resin composition. With this finding, the inventors completed the present invention.

Specifically, the present invention is a negative photosensitive resin composition, comprising:

(A) an alkali-soluble resin including at least one or more structures selected from a polyimide structure, a polyamide structure, a polybenzoxazole structure, a polyamideimide structure, and precursor structures thereof;
(B) a photoacid generator;
(C) one or two or more kinds of crosslinking agent selected from an amino condensate modified with formaldehyde or formaldehyde-alcohol, a phenol compound having on average two or more methylol groups or alkoxymethylol groups within one molecule, a compound in which a hydrogen atom of a hydroxyl group of polyhydric phenol is substituted with a glycidyl group or a group having a glycidyl group, a compound in which a hydrogen atom of a hydroxyl group of polyhydric phenol is substituted with a substituent represented by the following formula (C-1), a compound represented by the following formula (C-15) having a substituent (C-1), and a compound containing two or more nitrogen atoms having a glycidyl group represented by the following formula (C-2);

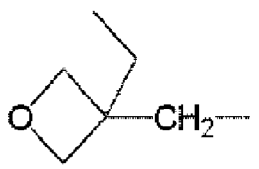

(C-1)

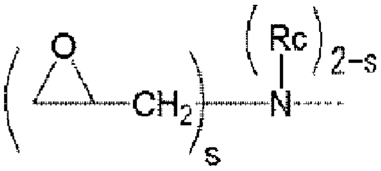 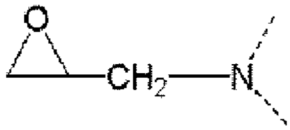 (C-2)

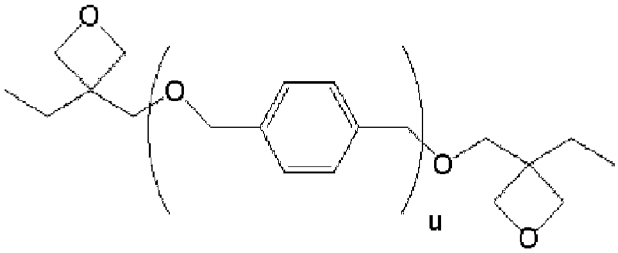 (C-15)

wherein the broken line represents a bond, Rc represents a linear, branched, or cyclic alkyl group having 1 to 6 carbon atoms; s represents 1 or 2; u is a number satisfying $1 \leq u \leq 3$;

(D) an onium salt represented by the following general formula (1); and

$$\left( Q \right)_m A^+ \quad E^- \qquad (1)$$

wherein A represents iodine, sulfur, phosphorus, or nitrogen; each Q is identical to or different from one another and represents a monovalent hydrocarbon group having 1 to 100 carbon atoms, which may be linked, substituted, or intervened by a heteroatom; E- represents an anion of an organic or inorganic acid salt; and m represents 2 when A is iodine, m represents 3 when A is sulfur, and m represents 4 when A is phosphorus or nitrogen,

(E) a solvent.

The present invention is described below in detail; however, the present invention is not limited to the examples described below.

(D) Onium Salt

In order to solve the problems described above, the present inventors have intensively searched for a compound as a replacement for a basic compound to be added for the purpose of increasing the dissolution contrast of a chemically amplified photosensitive resin composition, and also conducted study of a composition which does not impair the storage stability. As a result, the inventors found use of an onium salt represented by the following general formula (1),

$$\left( Q \right)_m A^+ \quad E^- \qquad (1)$$

wherein A represents iodine, sulfur, phosphorus, or nitrogen; each Q is identical to or different from one another and represents a monovalent hydrocarbon group having 1 to 100 carbon atoms, which may be linked, substituted, or intervened by a heteroatom; E- represents an anion of an organic or inorganic acid salt; and m represents 2 when A is iodine, m represents 3 when A is sulfur, and m represents 4 when A is phosphorus or nitrogen.

When the onium salt represented by the general formula (1) as the component (D) of the present invention is added to a negative photosensitive resin composition, the anion of the acid generated from the photoacid generator undergoes anion exchange with the anion of the organic or inorganic acid salt as $E^-$ of the onium salt represented by

the general formula (1) when the light-exposure amount is low, thereby capable of reducing the acidity of the generated acid and preventing the progress of the acid-catalyzed crosslinking reaction. On the other hand, at a light-exposure amount at which the amount of the generated acid is larger than the addition amount of the onium salt represented by the general formula (1), an excessive acid is generated from the acid subjected to the anion exchange, thus increasing the amount of the acid serving as a catalyst. This allows the crosslinking reaction to proceed, thereby allowing insolubilization in a developer to proceed.

That is, by adding the onium salt represented by the general formula (1) to the negative chemically amplified photosensitive resin composition, it is possible to greatly change the solubility in a developer with a change in light-exposure amount that is similar to the effect obtained by adding a small amount of a basic compound, thereby increasing the so-called dissolution contrast. The addition of the onium salt represented by the general formula (1) made it possible to increase the dissolution contrast, and, as a result, the high resolution performance of the chemically amplified photosensitive resin composition was achieved.

On the other hand, when the onium salt represented by the general formula (1) is added to a photosensitive resin composition obtained by using a polymer compound, which is a polymer having at least one or more structures selected from a polyimide structure, a polyamide structure, a polybenzoxazole structure, a polyamideimide structure, and precursor structures thereof, since the onium salt represented by the general formula (1) and the imide structure or the amide structure has no interaction, intermolecular aggregation does not proceed in the composition solution. Thus, it was found that the apparent molecular weight of the polymer compound does not increase during the storage of the solution, thus capable of preventing the problem of poor storage stability such as an increase in the thickness of the film obtained by applying the photosensitive resin composition on a substrate over time.

In the case of an iodonium salt in which A in the formula of the onium salt represented by the general formula (1) is iodine, as the onium salt of the general formula (1), the following structure can be suitably used as Q in view of easy availability and stability of the compound.

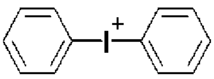
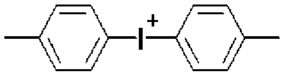
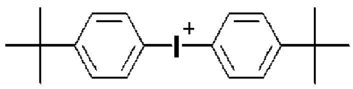
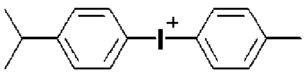

In the case of a sulfonium salt in which A in the formula of the onium salt represented by the general formula (1) is sulfur, Q is preferably a phenyl group having a substituent in view of easy availability and stability of the compound. Particularly preferable examples of the sulfonium salt include a triphenyl sulfonium salt containing a phenyl group having a substituent.

Further, in the case of a sulfonium salt in which A in the formula of the onium salt represented by the general formula (1) is sulfur, a sulfonium salt having the following structure can be preferably used.

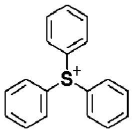
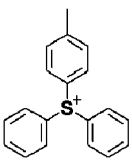
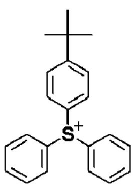
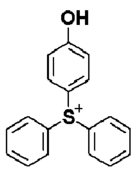
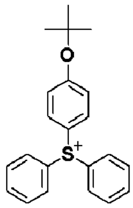
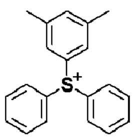
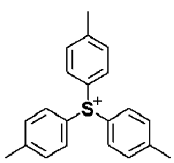
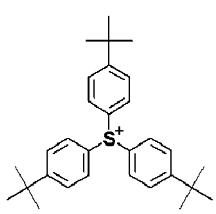
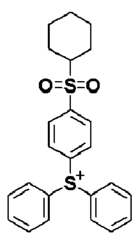

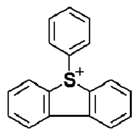
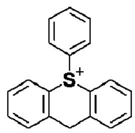
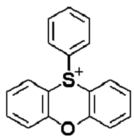
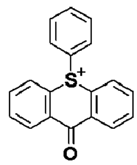
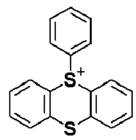

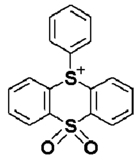
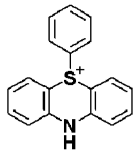
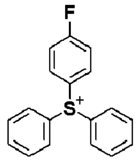
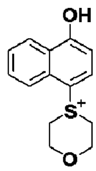
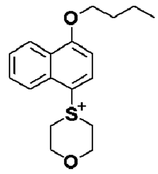

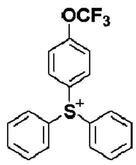
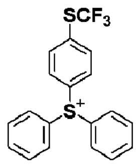
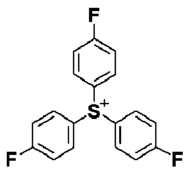
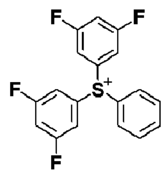
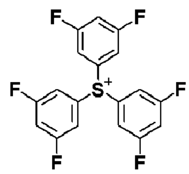

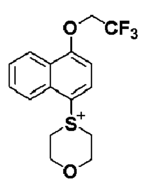
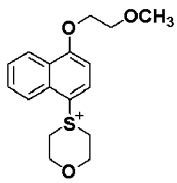
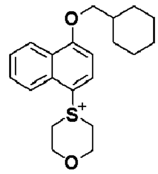
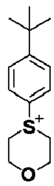
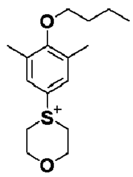

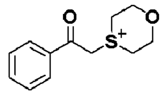
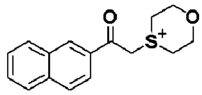
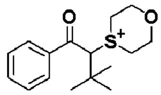
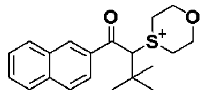

In the case of a phosphonium salt in which A in the formula of the onium salt represented by the general formula (1) is phosphorus, each Q may be identical to or different from one another, which may be linked, substituted, or intervened by a heteroatom, and represents a monovalent hydrocarbon group having 1 to 100 carbon atoms, preferably a monovalent hydrocarbon group having 1 to 20 carbon atoms, and more preferably a monovalent aromatic hydrocarbon group having 6 to 20 carbon atoms. In view of availability and stability of the compound, a tetraphenyl phosphonium salt or a tetratolyl phosphonium salt having a substituent is preferable.

Suitable examples of E in the general formula (1) are described later.

Ammonium Salt

On the other hand, in the case of an ammonium salt in which A in the formula of the onium salt represented by the general formula (1) is nitrogen, a quaternary ammonium salt represented by the following general formula (1-1) is more preferable,

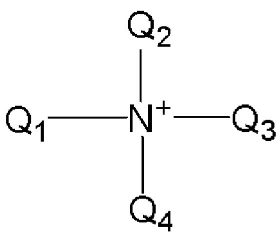

(1 − 1)

wherein each of $Q_1$, $Q_2$, $Q_3$, and $Q_4$ is identical to or different from one another and represents a monovalent hydrocarbon group having 1 to 100 carbon atoms, which may be linked, substituted, or intervened by a heteroatom; and $E^-$ represents an anion of an organic or inorganic acid salt as defined above.

Preferable specific examples of the structure represented by the general formula (1-1) include, but are not limited to, the following.

In the formula of the quaternary ammonium salt represented by the general formula (1-1), each of $Q_1$, $Q_2$, $Q_3$, and $Q_4$ is identical to or different from one another and represents a monovalent hydrocarbon group having 1 to 100 carbon atoms, which may be linked, substituted, or intervened by a heteroatom.

In the formula, suitable examples of the hydrocarbon group as $Q_1$, $Q_2$, $Q_3$, and $Q_4$ include any of saturated or unsaturated, linear, branched, or cyclic hydrocarbon groups. Specific examples thereof include alkyl groups having 1 to 10 carbon atoms such as a methyl group, an ethyl group, a propyl group, an isopropyl group, an n-butyl group, a sec-butyl group, a tert-butyl group, a tert-pentyl group, an n-pentyl group, an n-hexyl group, an n-octyl group, a 2-ethylhexyl group, an n-nonyl group, or an n-decyl group; cyclic saturated hydrocarbyl groups having 4 to 10 carbon atoms such as a cyclopentyl group, a cyclohexyl group, a cyclopentyl methyl group, a cyclopentyl ethyl group, a cyclopentyl butyl group, a cyclohexyl methyl group, a cyclohexyl ethyl group, a cyclohexyl butyl group, a norbornyl group, a tricyclo[5.2.1.$0^{2,6}$]decanyl group, an adamantyl group, or an adamantyl methyl group; alkenyl groups such as a vinyl group, or an allyl group; aryl groups having 6 to 10 carbon atoms such as a phenyl group, or a naphthyl group; groups obtained by combining these groups; and the like.

Further, in these groups, a part or all of the hydrogen atoms may be substituted with a group containing a heteroatom such as an oxygen atom, a sulfur atom, nitrogen atom or a halogen atom, and a part of the $-CH_2-$ constituting these groups may be substituted with a group containing a heteroatom such as an oxygen atom, a sulfur atom, or a nitrogen atom, thereby containing a hydroxyl group, a cyano group, a halogen atom, a carbonyl group, an ether bond, a thioether bond, an ester bond, a sulfonic acid ester bond, a carbonate bond, a carbamate bond, a lactone ring, a sultone ring, a carboxylic acid anhydride, and the like.

Preferable examples of the cation of the quaternary ammonium salt represented by the general formula (1-1) further include the following.

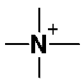
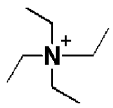
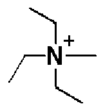
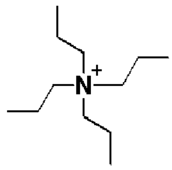
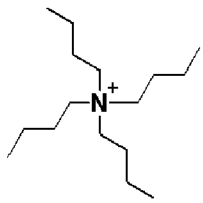
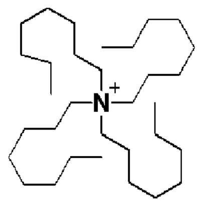

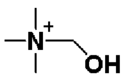
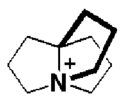
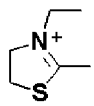
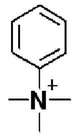
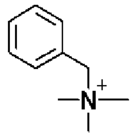
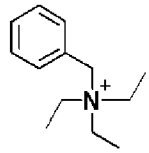
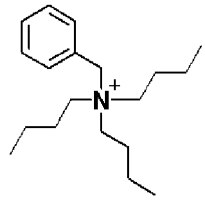

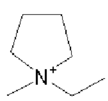
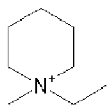
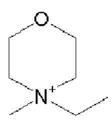

Further, $E^-$ in the general formula (1) or the general formula (1-1) is preferably an anion of an organic carboxylic acid represented by the following general formula (6),

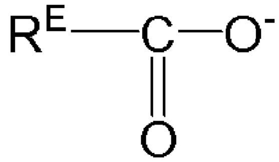
(6)

wherein $R^E$ is preferably a hydrocarbon group having 1 to 100 carbon atoms, which may be substituted with a heteroatom or intervened by a heteroatom.

Suitable examples of $R^E$ in the general formula (6) include alkyl groups having 1 to 10 carbon atoms such as a methyl group, an ethyl group, a propyl group, isopropyl group, an n-butyl group, a sec-butyl group, a tert-butyl group, a tert-pentyl group, an n-pentyl group, an n-hexyl group, an n-octyl group, a 2-ethylhexyl group, an n-nonyl group, or an n-decyl group; cyclic saturated hydrocarbyl groups having 4 to 10 carbon atoms such as cyclopentyl group, cyclohexyl group, cyclopentyl methyl group, cyclopentyl ethyl group, cyclopentyl butyl group, cyclohexyl methyl group, cyclohexyl ethyl group, cyclohexyl butyl group, norbornyl group, tricyclo[5.2.1.$0^{2,6}$]decanyl group, adamantyl group, or adamantyl methyl group; alkenyl groups such as vinyl group, or allyl group; aryl groups having 6 to 10 carbon atoms such as phenyl group, or naphthyl group; groups obtained by combining these groups; and the like.

Examples of the anion of the organic carboxylic acid represented by the general formula (6) include anions of fatty acids of acetic acid, propionic acid, butyric acid, valeric acid, caproic acid, enanthic acid, caprylic acid, pelargonic acid, capric acid, lauric acid, myristic acid, pentadecylic acid, palmitic acid, palmitoleic acid, margaric acid, stearic acid, oleic acid, vaccenic acid, linoleic acid, (9,12,15)-linolenic acid, (6,9,12)-linolenic acid, eleostearic acid, arachidic acid, arachidonic acid, eicosapentaenoic acid, docosahexaenoic acid, and sorbic acid.

Further, examples of the anion of the organic carboxylic acid represented by the general formula (6) include: anions of carboxylic acids containing a hydroxyl group such as lactic acid, malic acid, or citric acid; aromatic carboxylic acids such as benzoic acid, phthalic acid, isophthalic acid, terephthalic acid, salicylic acid, m-hydroxybenzoic acid, p-hydroxybenzoic acid, cinnamic acid, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid or 8-ethynyl-2-naphthoic acid; and dicarboxylic acids such as oxalic acid, malonic acid, succinic acid, glutaric acid, adipic acid, fumaric acid, maleic acid, cyclohexanedicarboxylic acid, 3-hydroxyphthalic acid, 5-norbornene-2,3-dicarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene, or 2,7-dicarboxynaphthalene.

Specific examples of the onium salt represented by the general formula (1) or the ammonium salt represented by the general formula (1-1) include arbitrary combinations of anions and cations exemplified above. These onium salts or ammonium salts may be readily prepared by an ion exchange reaction using any known organic chemistry techniques.

The content of the component (D) in the negative photosensitive resin composition of the present invention containing the onium salt represented by the general formula (1) or the ammonium salt represented by the general formula (1-1) is preferably 0.1 to 10 parts by mass, more preferably 0.1 to 5 parts by mass relative to 100 parts by mass of the alkali-soluble polymer, i.e., the component (A). Only one kind, or a combination of two or more kinds of the onium salt represented by the general formula (1) or the ammonium salt represented by the general formula (1-1) may be used.

(A) Alkali-Soluble Resin

In the following, the component (A) of the polymer compound, which is a polymer having at least one or more structures selected from a polyimide structure, a polyamide structure, a polybenzoxazole structure, a polyamideimide structure, and precursor structures thereof to be used for the chemically amplified negative photosensitive resin composition of the present invention is specifically described.

In the patterning, development using N-methyl-2-pyrrolidone (NMP) should be avoided in view of environmental burden and health hazards, in particular, in view of the concerns about the absorption respiratory organs toxicity. Furthermore, although the use of versatile organic solvents such as cyclopentanone as a developer has less concerns about toxicity, and the like, it is more preferable to use an aqueous alkaline solution, such as a 2.38% tetramethyl ammonium hydroxide aqueous solution commonly used in the manufacture of semiconductors in view of the environmental burden.

Therefore, the component (A) of the polymer compound described above is an alkali-soluble resin that can be developed by an aqueous alkaline solution.
In this case, the component (A) is preferably an alkali-soluble resin, comprising at least one or more structures selected from a polyimide structure, a polyamide structure, a polybenzoxazole structure, a polyamideimide structure, and precursor

structures thereof, each of which is a reaction product of a diamine comprising one or more diamines represented by the following general formula (2) or the following general formula (3), and one or more of tetracarboxylic acid dianhydride represented by the following general formula (4) and a dicarboxylic acid or dicarboxylic acid halide represented by the following general formula (5),

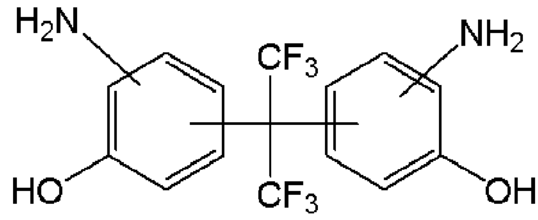

(2)

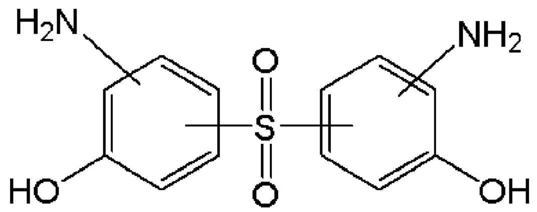

(3)

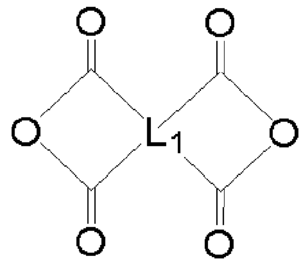

(4)

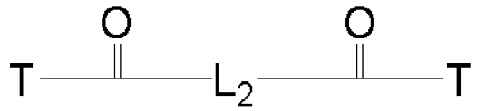

(5)

wherein $L_1$ represents a tetravalent hydrocarbon group having 1 to 100 carbon atoms, which may be substituted with a heteroatom or intervened by a heteroatom; $L_2$ represents a divalent hydrocarbon group having 1 to 100 carbon atoms, which may be substituted with a heteroatom or intervened by a heteroatom; T represents any of a hydroxy group, a fluorine atom, a chlorine atom, a bromine atom, an iodine atom, $-OCO_2R^T$, $-OSO_2R^T$, and - $OSO_3R^T$, provided that $R^T$ represents a monovalent hydrocarbon group having 1 to 10 carbon atoms, which may be substituted with a heteroatom or intervened by a heteroatom.

Further, in this case, the component (A) is preferably an alkali-soluble resin, comprising at least one or more structures selected from a polyimide structure, a polyamide structure, a polybenzoxazole structure, a polyamideimide structure, and precursor structures thereof obtained by reacting a diamine including one or more of the diamine represented by the general formula (2) and the diamine represented by the general formula (3), with one or more of tetracarboxylic acid dianhydride represented by the following general formula (8) and a dicarboxylic acid or dicarboxylic acid halide represented by the following general formula (9),

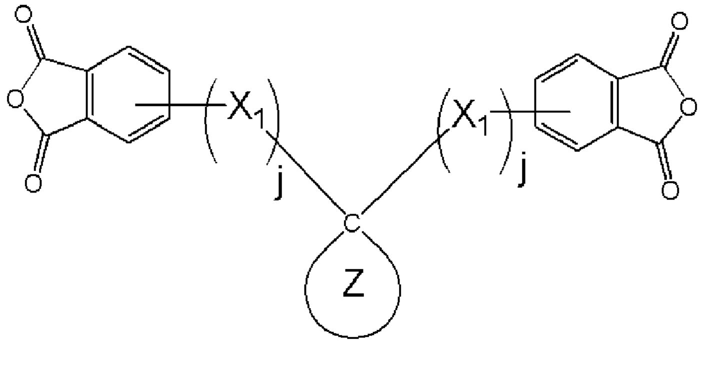

(8)

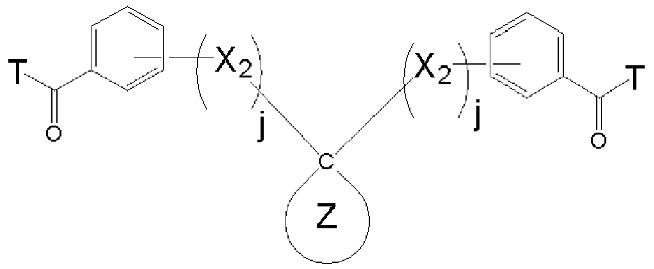

(9)

wherein Z represents an alicyclic structure, an alicyclic structure connected to an aromatic ring, a heteroatom-containing or heteroatom-intervened alicyclic structure, or a heteroatom-containing or heteroatom-intervened alicyclic structure connected to an aromatic ring, each of which has 3 to 20 carbon atoms, T represents any of a hydroxy group, a fluorine atom, a chlorine atom, a bromine atom, an iodine atom, $-OCO_2R^T$, $-OSO_2R^T$, and $-OSO_3R^7$; j represents 0 or 1; when j is 0, the phthalic anhydride structure and the cyclic structure Z in the general formula (8) and the benzoic acid structure and the cyclic structure Z in the general formula (9) are directly bonded; and when j is 1, $X_1$ and $X_2$ represent a divalent linkage group.

When the alkali-soluble resin (polymer) having a polyamide, polyamideimide, polyimide structure, polybenzoxazole structure, or precursor structure units thereof obtained by reacting one or more of the tetracarboxylic acid dianhydride represented by the general formula (8) and the dicarboxylic acid or dicarboxylic acid halide represented by the general formula (9) is used as a base resin of a photosensitive resin composition, since the polymer is easily soluble in a versatile and safe organic solvent, it is useful in constructing the composition.

Further, although the polyamide, polyamideimide, polyimide, polyimide precursor, polybenzoxazole, polybenzoxazole precursor, which are polymers having a polyamide, polyamideimide, polyimide structure, polybenzoxazole structure, or precursor structure units thereof obtained by reacting a diamine including one or more of the diamine represented by the general formula (2) and the diamine represented by the general formula (3), with one or more of the tetracarboxylic acid dianhydride represented by the general formula (4) and the dicarboxylic acid or dicarboxylic acid halide represented by the general formula (5), or by reacting the tetracarboxylic acid dianhydride represented by the general formula (8) or the dicarboxylic acid or dicarboxylic acid halide represented by the general formula (9), is a resin soluble in an aqueous alkaline solution, the patterning using a photosensitive resin composition containing this polymer and the films obtained after the heating have excellent resistance to strongly alkaline plating stripping solutions.

Furthermore, the protective coating obtained by the patterning and heating using the photosensitive resin composition containing the polymer of the polyamide, polyamideimide, polyimide, polyimide precursor, polybenzoxazole, polybenzoxazole precursor as the base resin has excellent mechanical strength and adhesion. That is, the cured film obtained by patterning using the polymer of the polyamide, polyamideimide, polyimide, polyimide precursor, polybenzoxazole, polybenzoxazole precursor as the base resin is excellent as surface protective coating, insulating protective coating, and interlayer insulating film for electric/electronic components.

Further, the present invention preferably includes an alkali-soluble resin including at least one or more structures selected from a polyimide structure, a polyamide structure, a polybenzoxazole structure, a polyamideimide structure, and precursor structures thereof obtained by reacting one or more of a tetracarboxylic acid dianhydride, dicarboxylic acid, or dicarboxylic acid halide in which the alicyclic structure Z of the general formula (8) or (9) has a structure of the following general formula (10) or (11),

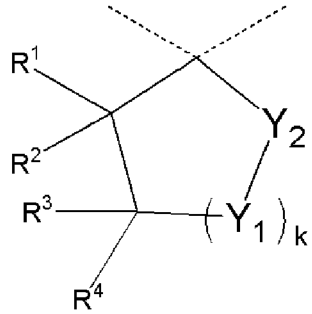

(10)

wherein the broken line represents a bond; and k represents 0 or an integer of 1 or more; when k = 0, $Y_2$ represents a divalent group selected from any of the following general formulae (13), (14), (15), and (16); when k = 1, $Y_1$ represents a divalent group selected from any of the following general formulae (17), (18), and (19), and $Y_2$ represents a divalent group selected from any of the following general formulae (13), (14), (15), and (16); when k is 2 or more, $Y_1$ represents the following general formula (17), and $Y_2$ represents a divalent group selected from any of the following general formulae (13), (14), (15), and (16); $R^1$, $R^2$, $R^3$, and $R^4$, and $R^5$ and $R^6$ in the following formula (16) represent identical or different substituents, each representing a hydrogen atom, a methyl group, an ethyl group, a linear, branched, or cyclic alkyl group having 3 to 12 carbon atoms; or $R^1$, $R^2$, $R^3$, $R^4$, $R^5$ and $R^6$ are bonded together to form an alicyclic or aromatic ring;

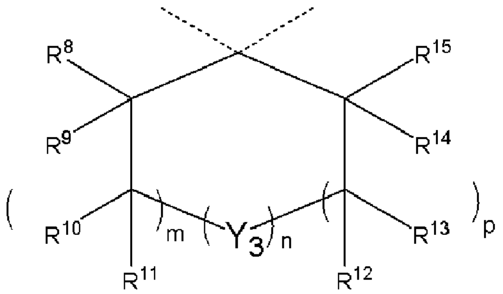

(11)

wherein the broken line represents a bond, and $R^8$, $R^9$, $R^{10}$, $R^{11}$, $R^{12}$, $R^{13}$, $R^{14}$, and $R^{15}$ represent identical or different substituents, each representing a hydrogen atom, a methyl group, an ethyl group, a linear, branched, or cyclic alkyl group having 3 to 12 carbon atoms; m and p represent 0 or an integer of 1 to 9; and n represents 0 or 1; $Y_3$ represents a divalent group selected from any of the following general formulae (12), (13), (14), (15), (16), (17), (18) and (19);

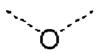 (12) 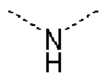 (13) 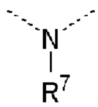 (14) 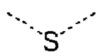 (15)

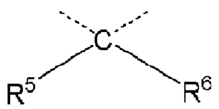 (16) 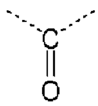 (17) 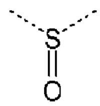 (18) 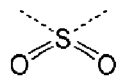 (19)

wherein the broken line represents a bond; and $R^5$ and $R^6$ are as defined above; $R^7$ represents a methyl group, an ethyl group, a linear, branched, or cyclic alkyl group having 3 to 12 carbon atoms.

Further, the alkali-soluble resin as the component (A) is preferably a polymer including at least one or more structures selected from a polyimide structure, a polyamide structure, a polybenzoxazole structure, a polyamideimide structure, and precursor structures thereof obtained by reacting one or more of tetracarboxylic acid dianhydride, dicarboxylic acid, and dicarboxylic acid halide in which the divalent linkage groups $X_1$ and $X_2$ of the general formulae (8) and (9) have any of the structures represented by the following general formulae (20), (21), (22), (23), (24), and (25);

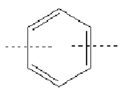 (20) 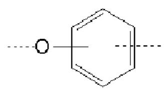 (21) 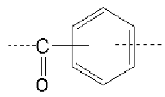 (22)

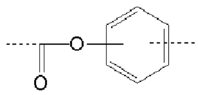 (23) 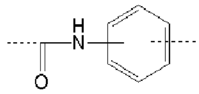 (24) 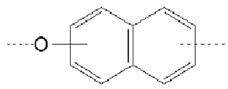 (25)

wherein the broken line represents a bond.

In the alkali-soluble resin as the component (A), specific examples of the preferable structures of the alicyclic structures Z of the general formulae (8) and (9) that can be represented by the general formula (10) include, but are not limited to, the following,

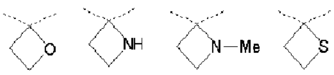

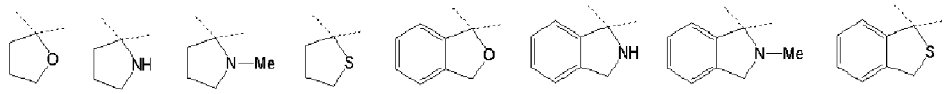

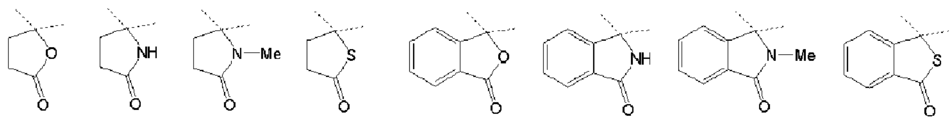

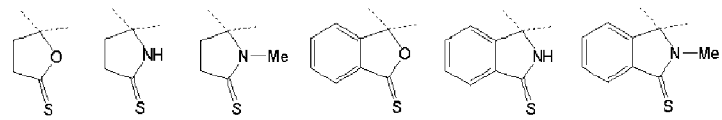

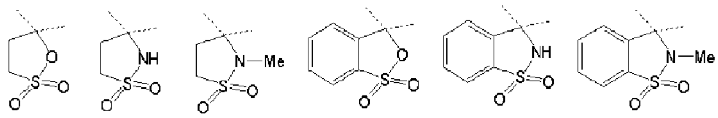

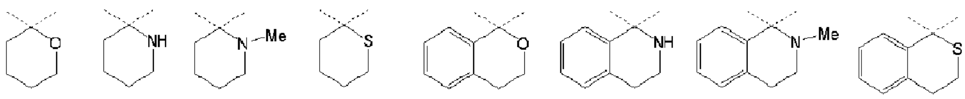

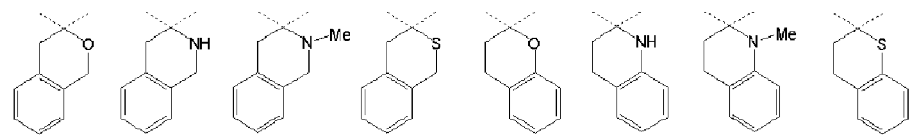

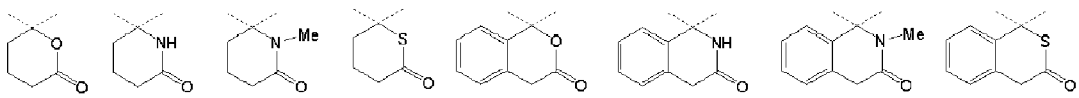

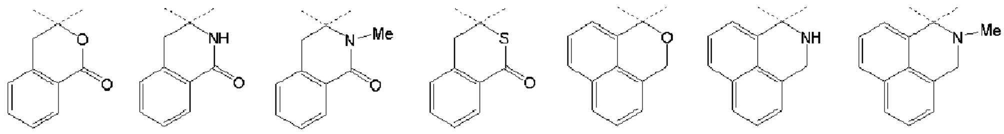

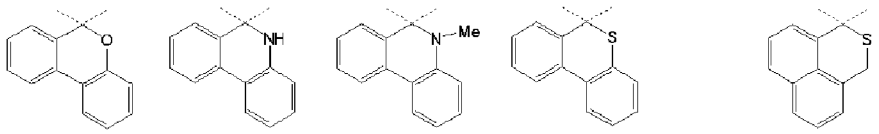

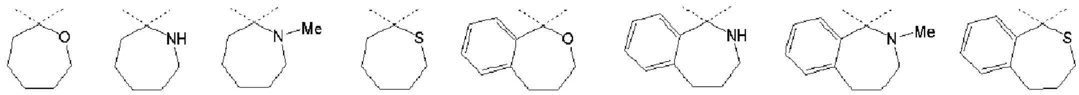

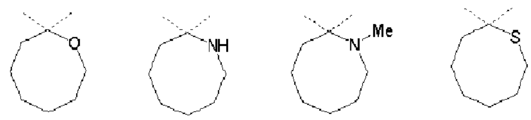

wherein the broken line represents a bond.

In the alkali-soluble resin as the component (A), specific examples of the preferable structures of the alicyclic structures Z of the general formulae (8) and (9) that can be represented by the general formula (11) include, but are not limited to, the following,

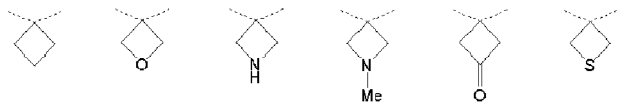

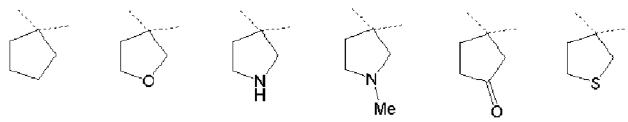

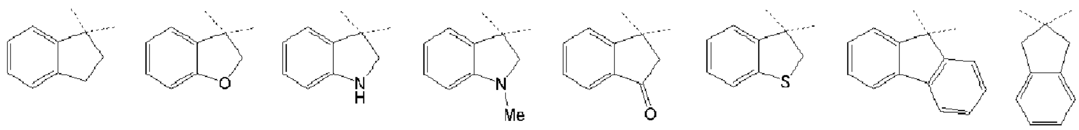

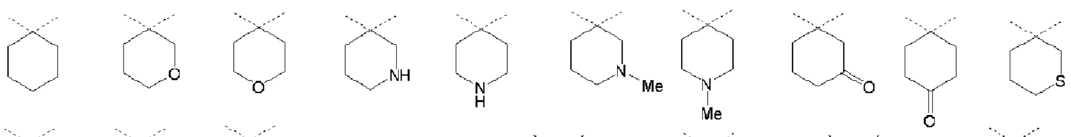

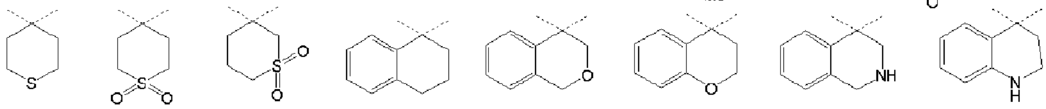

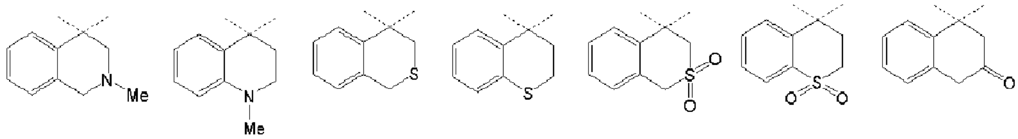

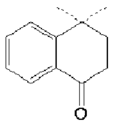 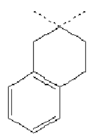 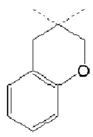 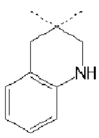 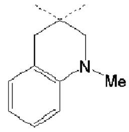 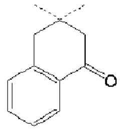 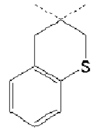 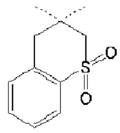

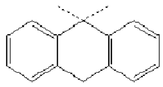 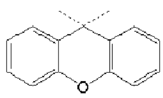 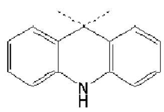 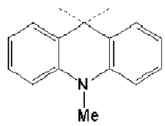 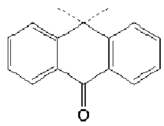

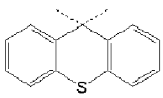 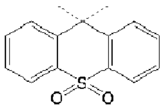 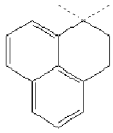 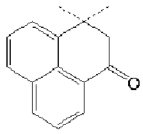 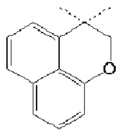 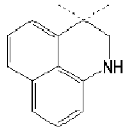

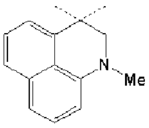 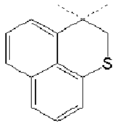 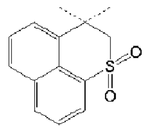 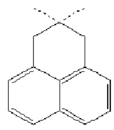 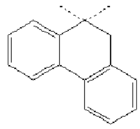 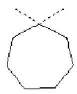 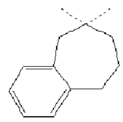

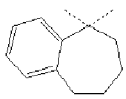 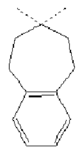 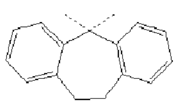 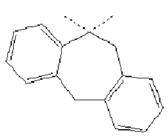 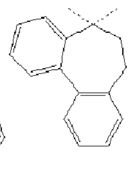 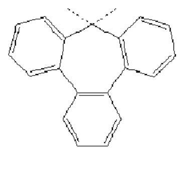 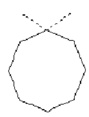

wherein the broken line represents a bond.

In the alkali-soluble resin as the component (A), when j is 0 in the general formulae (8) and (9), the phthalic anhydride structure and the cyclic structure Z in the general formula (8) and the benzoic acid structure and the cyclic structure Z in the general formula (9) are directly bonded to each other. Therefore, preferred examples of the structure in which the phthalic anhydride structure or the benzoic acid structure is directly bonded at the broken line representing the bond in the aforementioned structure include the structures represented by the following general formulae (8-1), (8-2), (8-3), and (9-1) to (9-6),

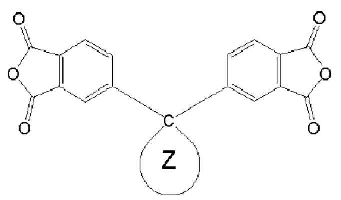

(8－1)

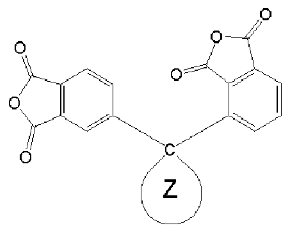

(8－2)

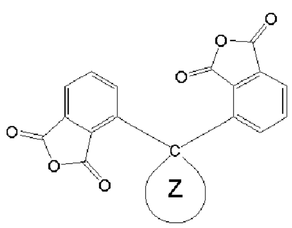

(8－3)

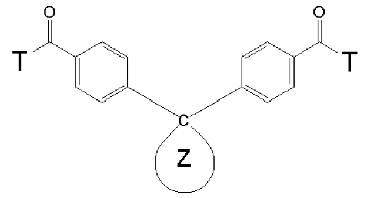

(9－1)

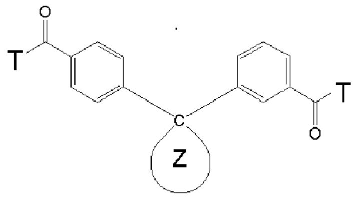

(9－2)

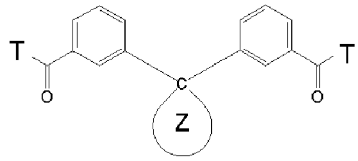

(9－3)

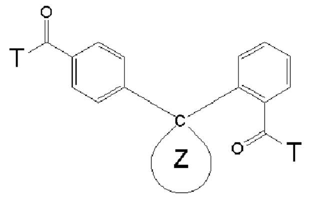

(9－4)

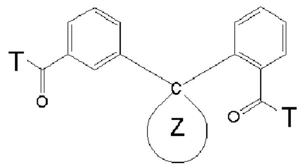

(9－5)

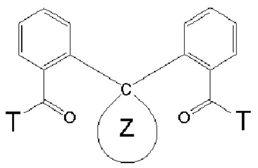

(9－6)

wherein Z and T are as defined above.

In the general formula (8), the general formula (8-1) is particularly preferable in view of the easiness of the synthesis method and availability. On the other hand, in the general formula (9), the general formula (9-1) is particularly preferable in view of the easiness of the synthesis method and availability.

On the other hand, in the alkali-soluble resin as the component (A), when j is 1 in the general formulae (8) and (9), $X_1$ and $X_2$ each represent a divalent linkage group. In this case, a polymer including at least one or more structures selected from a polyimide structure, a polyamide structure, a polybenzoxazole structure, a polyamideimide structure, and precursor structures thereof obtained by reacting one or more of a tetracarboxylic acid dianhydride, dicarboxylic acid, and dicarboxylic acid halide in which the linkage groups $X_1$ and $X_2$ have any of the structures represented by the following general formulae (20), (21), (22), (23), (24), and (25) is preferable,

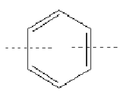

(2 0)

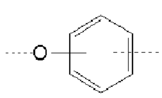

(2 1)

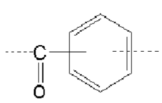

(2 2)

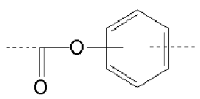

(2 3)

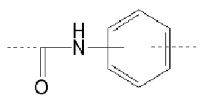

(2 4)

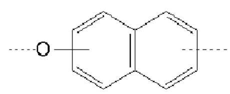

(2 5)

wherein the broken line represents a bond.

In the general formula (8), when j is 1, specific examples of preferred structures include, but are not limited to, the following,

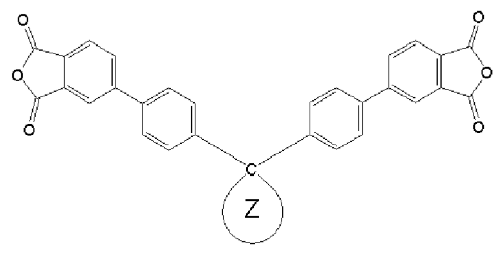

(8－4)

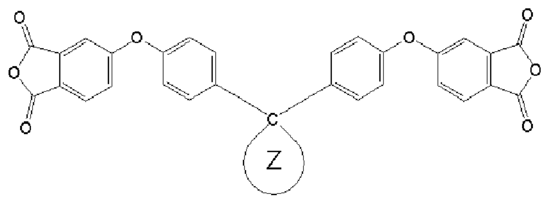

(8−5)

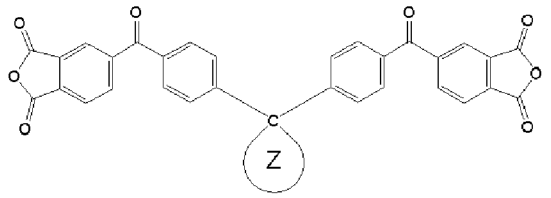

(8−6)

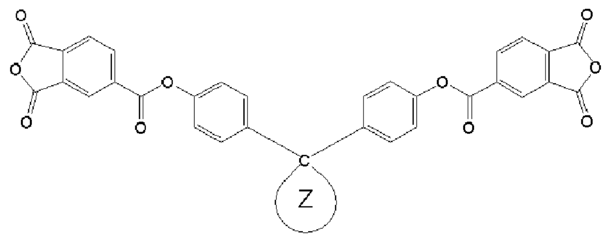

(8-7)

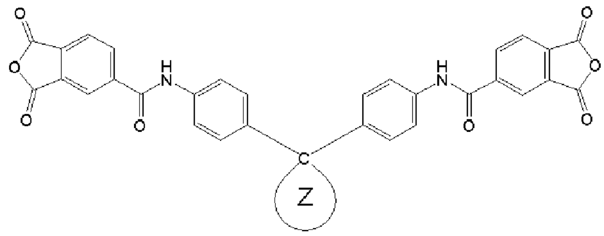

(8−8)

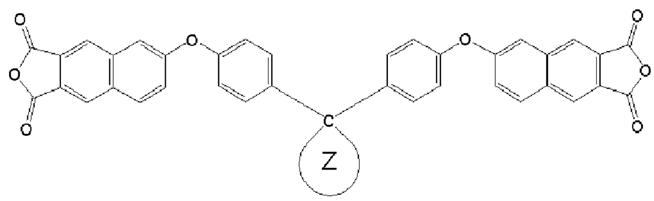

(8−9)

wherein Z is as defined above.

In these general formulae (8-4) to (8-9), the general formulae (8-5), (8-7) and (8-8) are preferable in view of the easiness of the synthesis method and availability. In particular, the general formulae (8-5) and (8-7) are preferable.

In the general formula (9), when j is 1, specific examples of preferred structures include, but are not limited to, the following.

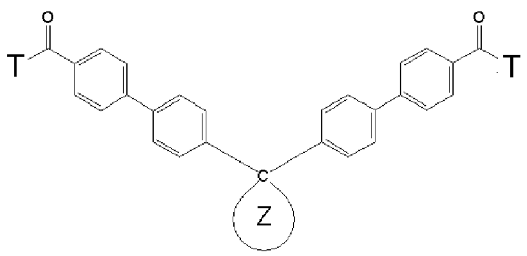

(9−7)

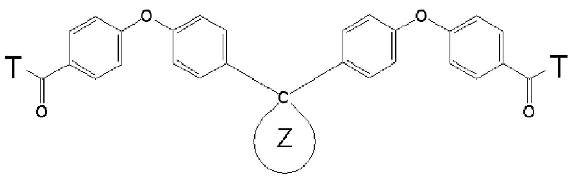

(9-8)

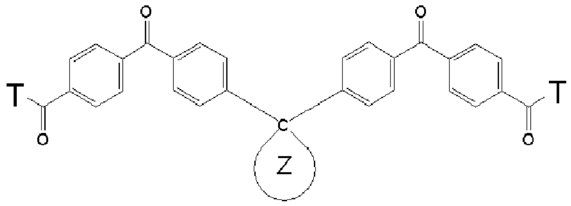

(9-9)

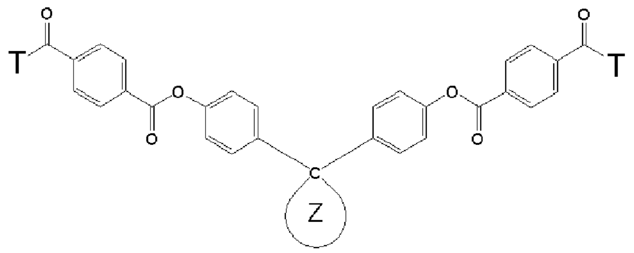

(9-10)

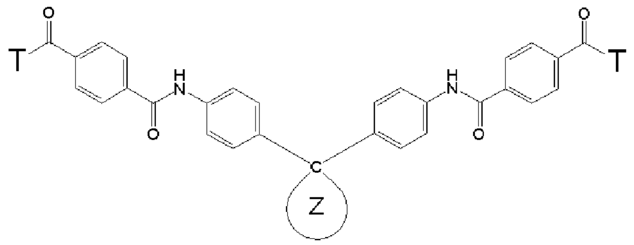

(9-11)

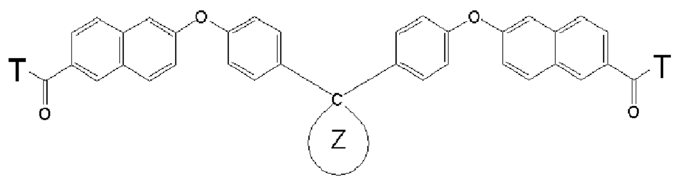

(9-12)

In these general formulae (9-7) to (9-12), the general formulae (9-8), (9-10) and (9-11) are preferable in view of the easiness of the synthesis method and availability. In particular, the general formulae (9-8) and (9-10) are preferable.

Further, the component (A) is preferably an alkali-soluble resin including at least one or more structures selected from a polyimide structure, a polyamide structure, a polybenzoxazole structure, a polyamideimide structure, and precursor structures thereof, which is a reaction product of one or more of a tetracarboxylic acid dianhydride in which the alicyclic structure Z in the general formula (8) is represented by the following general formula (33) or (34) and/or a dicarboxylic acid or dicarboxylic acid halide in which the alicyclic structure Z of the general formula (9) is selected from any of the following general formulae (35), (36), (37), (38), (39), and (40),

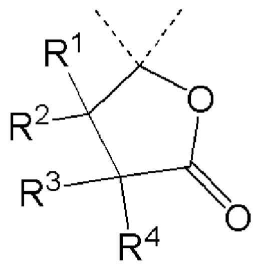

（３３）

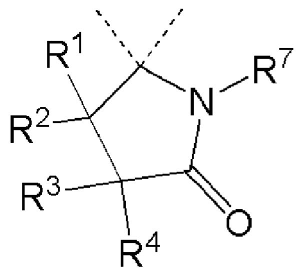

（３４）

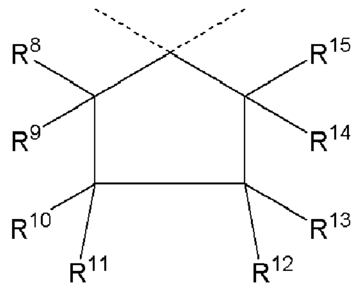

（３５）

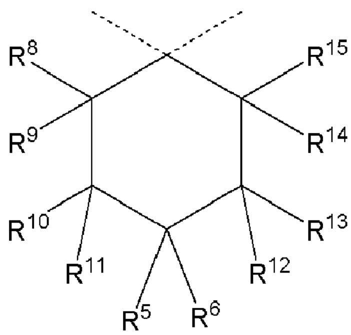

（３６）

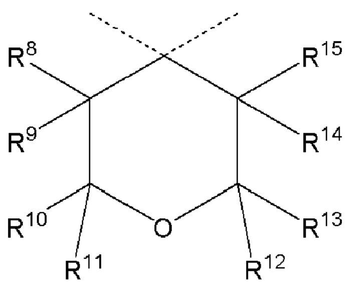

（３７）

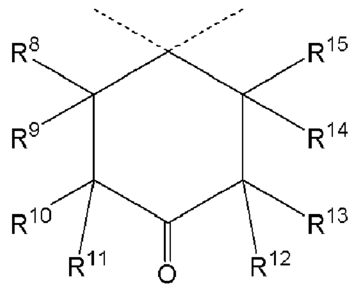

(38)

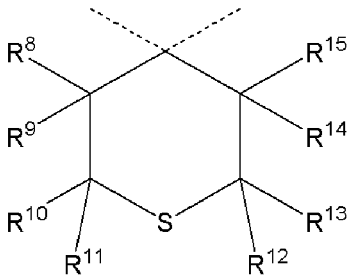

(39)

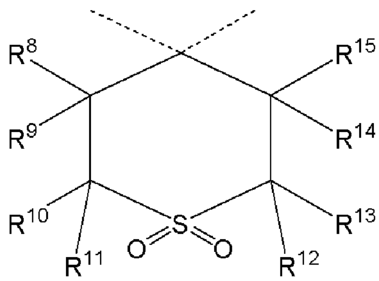

(40)

wherein the broken line represents a bond; $R^1$, $R^2$, $R^3$, $R^4$, $R^5$ and $R^6$ represent identical or different substituents, each representing a hydrogen atom, a methyl group, an ethyl group, a linear, branched, or cyclic alkyl group having 3 to 12 carbon atoms; or $R^1$, $R^2$, $R^3$, $R^4$, $R^5$ and $R^6$ are bonded together to form an alicyclic or aromatic ring; $R^7$ represents a methyl group, an ethyl group, a linear, branched, or cyclic alkyl group having 3 to 12 carbon atoms; $R^8$, $R^9$, $R^{10}$, $R^{11}$, $R^{12}$, $R^{13}$, $R^{14}$, and $R^{15}$ represent identical or different substituents, each representing a hydrogen atom, a methyl group, an ethyl group, a linear, branched, or cyclic alkyl group having 3 to 12 carbon atoms.

The tetracarboxylic acid dianhydride in which the alicyclic structure Z in the general formula (8) is selected from any of the general formulae (33) and (34) can be easily obtained or synthesized. On the other hand, the dicarboxylic acid in which the alicyclic structure Z in (9) is selected from any of the above formulae (35), (36), (37), (38), (39), and (40) can also easily be obtained or synthesized. The dicarboxylic acid halide can be easily obtained by reacting these dicarboxylic acids with a halogenating agent.

Further, in this case, the alkali-soluble resin as the component (A) is preferably a polymer, including at least one or more structures selected from a polyimide structure, a polyamide structure, a polybenzoxazole structure, a polyamideimide structure, and precursor structures thereof obtained by reacting the diamine represented by the general formula (26) as the diamine represented by the general formula (2), and one or more of the tetracarboxylic acid dianhydride represented by the general formula (4) and the dicarboxylic acid or dicarboxylic acid halide represented by the formula (5).

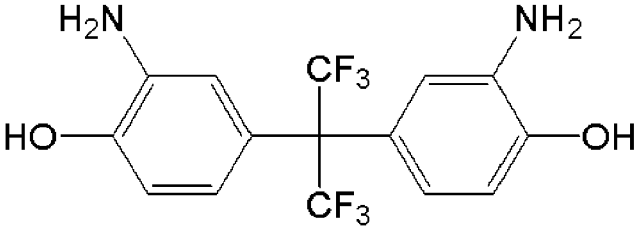

(26)

In the component (A), when the diamine represented by the general formula (2) is a diamine represented by

the general formula (26) and the resin obtained by the reaction contains a polyamide, polyamideimide, polyimide, polyimide precursor, polybenzoxazole, or a polybenzoxazole precursor, which is a polymer having a polyamide, polyamideimide, or polyimide structure unit, a developer of an aqueous alkaline solution can be used in the development step at the time of patterning. The use of the aqueous alkaline solution as the developer facilitates measurement and control of the dissolution rate of the base resin with respect to the aqueous alkaline solution as the developer, thus contributing to improvement of the resolution of the photosensitive resin composition.

Further, it is preferable when the alkali-soluble resin as the component (A) is a polymer further including a tetracarboxylic acid diester compound represented by the following general formula (27), and at least one or more structures selected from a polyimide structure, a polyamide structure, a polybenzoxazole structure, a polyamideimide structure, and precursor structures thereof obtained by a reaction, the alkali-soluble resin is further easily soluble in a versatile and safe organic solvent,

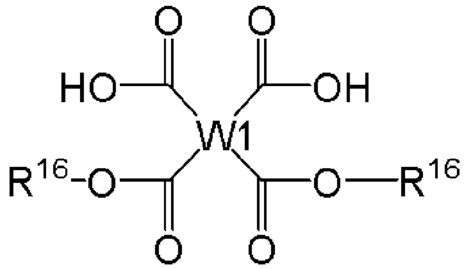

(27)

wherein W1 represents a tetravalent organic group, and $R^{16}$ is represented by the following general formula (28),

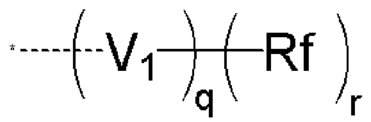

(28)

wherein the broken line represents a bond; $V_1$ represents a (r+1)-valent organic group; Rf represents a linear, branched or cyclic alkyl group or an aromatic group having 1 to 20 carbon atoms in which a part or all of the hydrogen atoms are substituted with a fluorine atom; r represents 1, 2 or 3; and q represents 0 or 1.

The present invention can further provide a negative photosensitive resin composition in which the alkali-soluble resin as the component (A) is a polymer including a tetracarboxylic acid diester compound in which $R^{16}$ in the general formula (27) is an organic group selected from the groups represented by the following formulae (29), (30), (31), and (32), and at least one or more structures selected from a polyimide structure, a polyamide structure, a polybenzoxazole structure, a polyamideimide structure, and precursor structures thereof, which are obtained by a reaction,

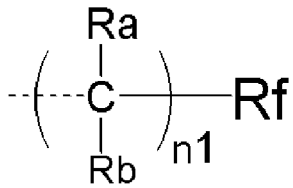

(29)

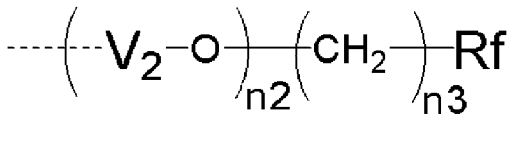

(30)

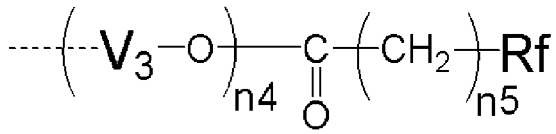

(31)

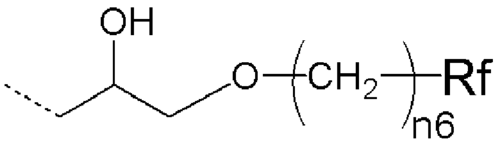 (3 2)

wherein the broken line represents a bond; Rf is as defined above; each of Ra and Rb is a hydrogen atom or an alkyl group having 1 to 3 carbon atoms; each of $V_2$ and $V_3$ is a linear or branched alkylene group having 1 to 6 carbon atoms; n1 is an integer of 0 to 6; n2 is an integer of 1 to 6; n3 is an integer of 0 to 6; n4 is an integer of 1 to 6; n5 is an integer of 0 to 6; and n6 is 0 or 1.

The present invention further provides a negative photosensitive resin composition in which the alkali-soluble resin as the component (A) is a polymer including a tetracarboxylic acid diester compound in which $R^{16}$ in the general formula (27) is a group represented by the following general formula (28-1), and at least one or more structures selected from a polyimide structure, a polyamide structure, a polybenzoxazole structure, a polyamideimide structure, and precursor structures thereof, which are obtained by a reaction,

$*\text{--------}CH_2\text{-}CH_2\text{-}Rf$ (28-1)

wherein the broken line represents a bond; and Rf is as defined above.

Preferable specific examples of the organic group represented by the general formula (29) include, but are not limited to, the following,

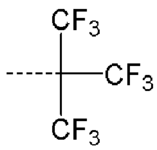 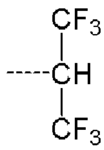 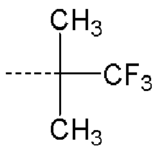

$\text{-----}CH_2\text{-}CF_3$

$\text{-}CH_2\text{-}CH_2\text{-}CF_3$

$\text{-----}CH_2\text{-}CF_2\text{-}CF_3$

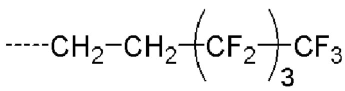

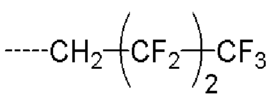 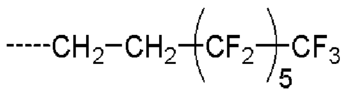

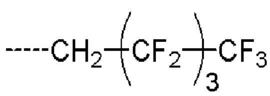 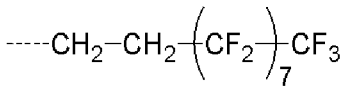

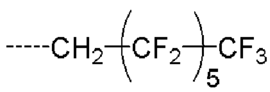

$\text{-----}CH_2\text{-}CH_2\text{-}CH_2\text{-}CF_3$

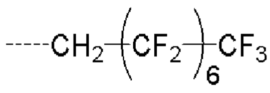
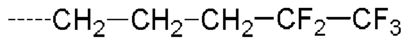
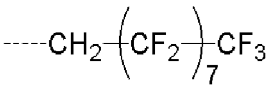
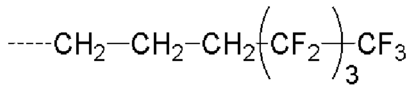
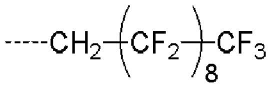
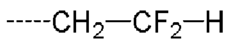
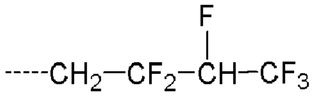
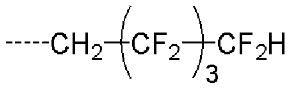
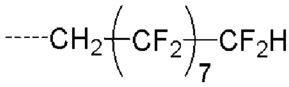
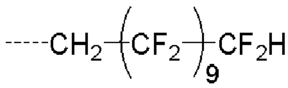
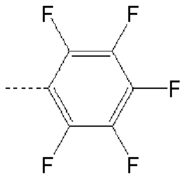
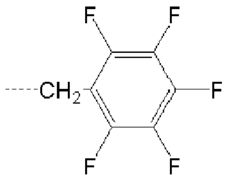
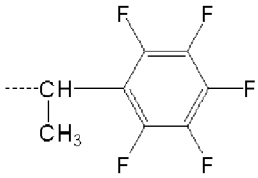
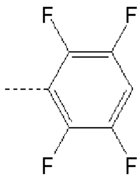
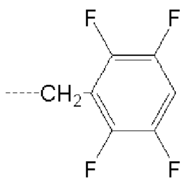
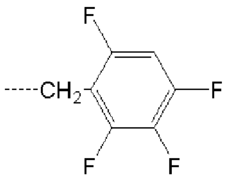
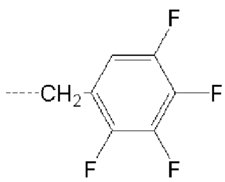
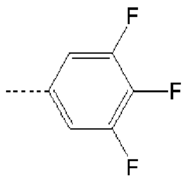
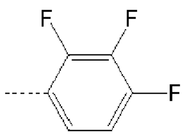
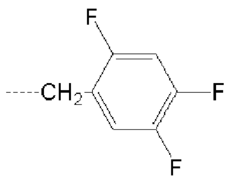
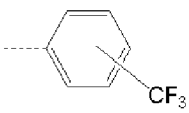
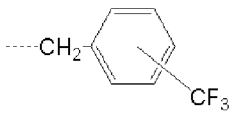
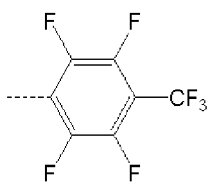
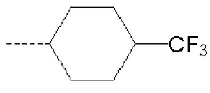
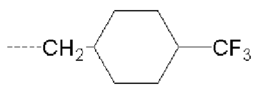

wherein the broken line represents a bond.

Preferable specific examples of the organic group represented by the general formula (30) include, but are not limited to, the following,

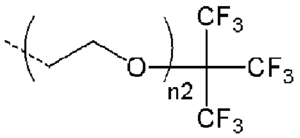
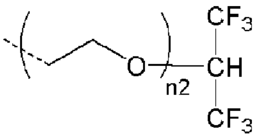
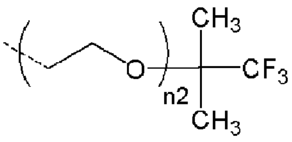

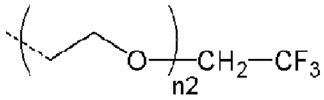
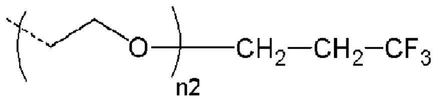

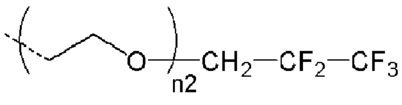
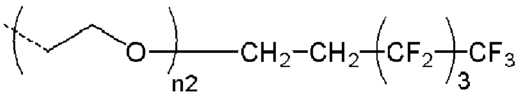

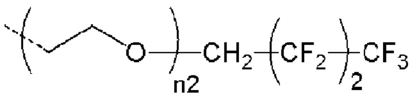
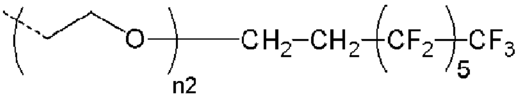

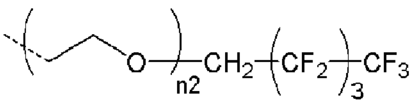
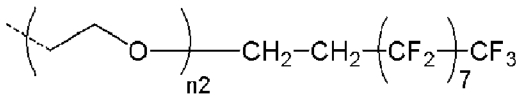

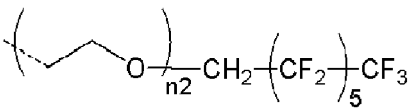
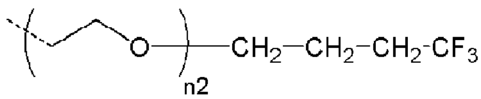

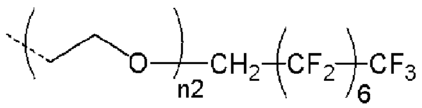
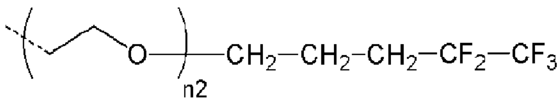

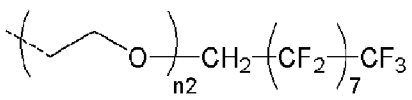
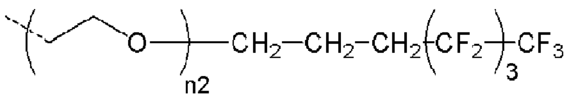

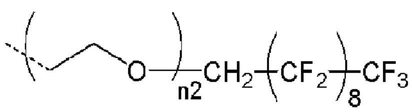
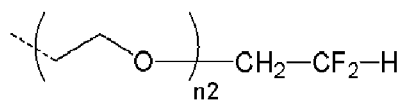

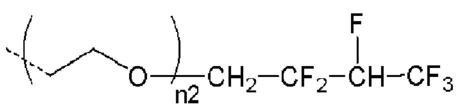
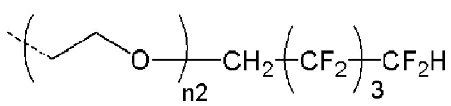

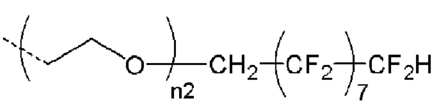
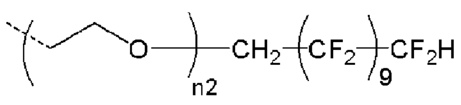

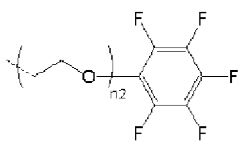
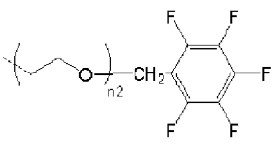
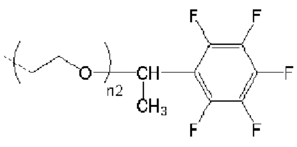

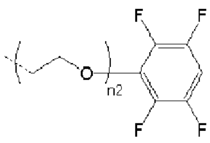
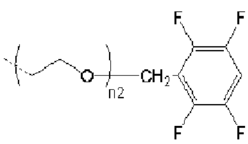
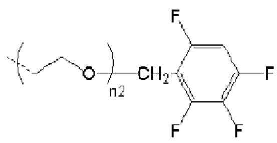
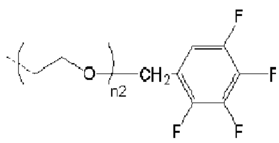

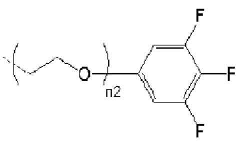
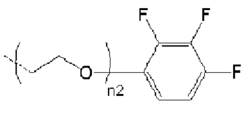
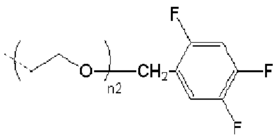

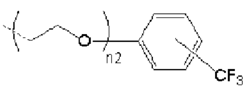
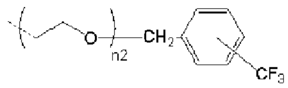
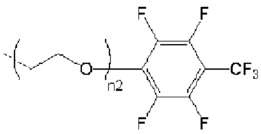

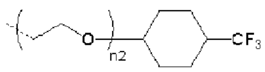
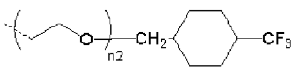

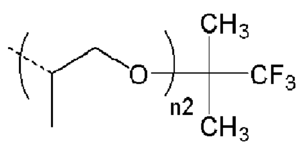
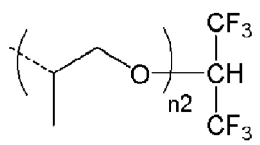
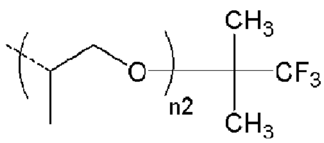

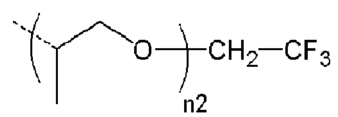
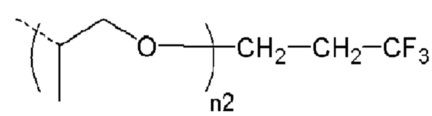

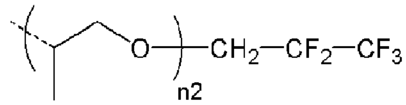
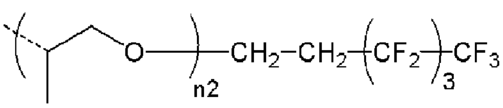

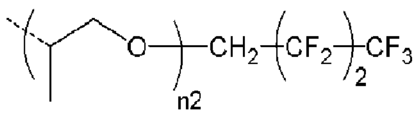
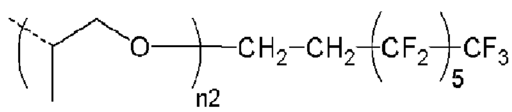

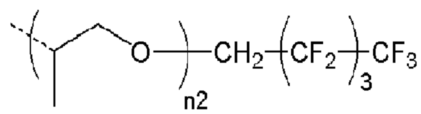
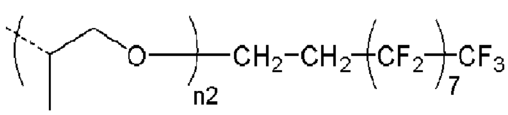

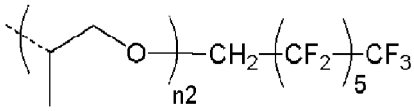
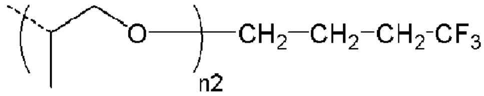

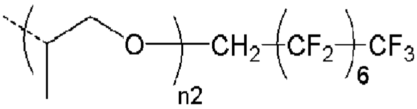
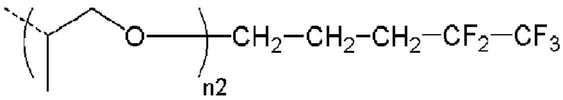

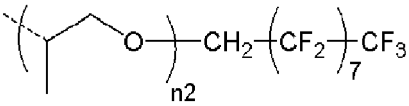
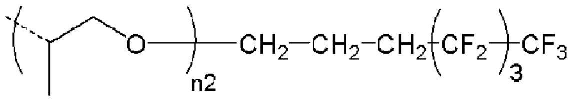

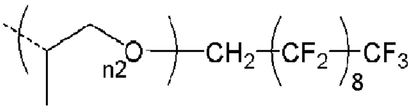
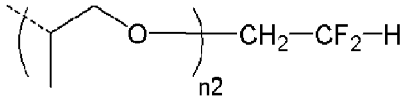

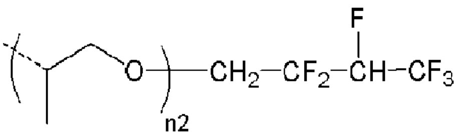
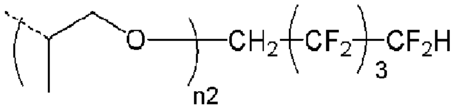

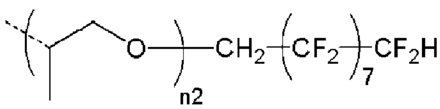
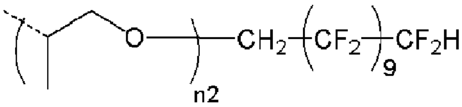

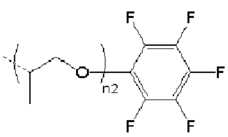
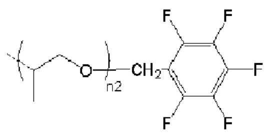
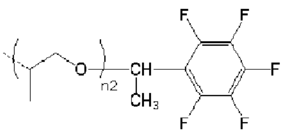

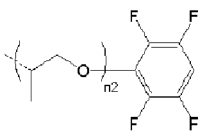
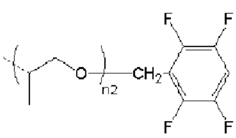
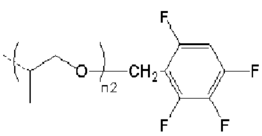
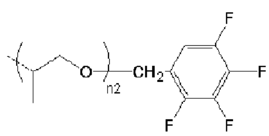

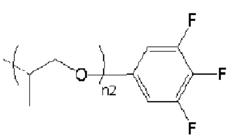
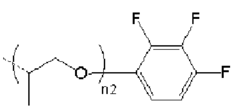
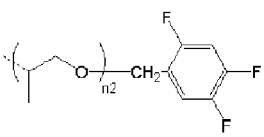

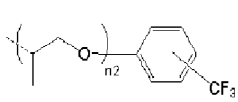
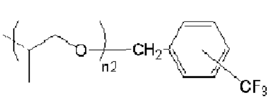
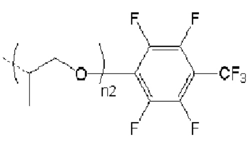

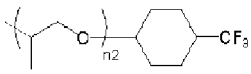 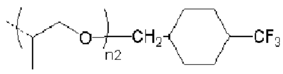

wherein the broken line represents a bond; and n2 represents an integer of 1 to 6, preferably an integer of 1 to 3, more preferably 1 or 2, and further more preferably 1.

Preferable specific examples of the organic group represented by the general formula (31) include, but are not limited to, the following,

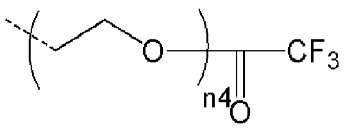 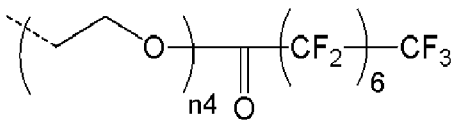

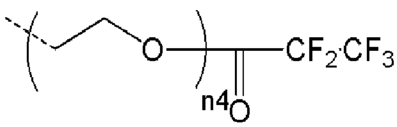 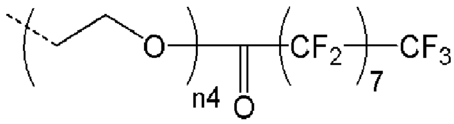

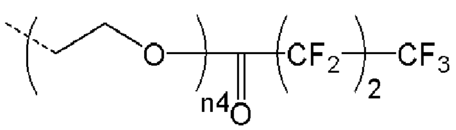 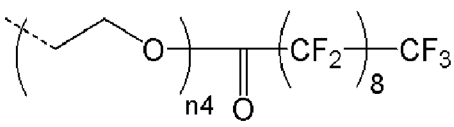

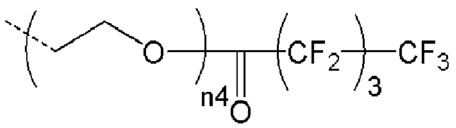 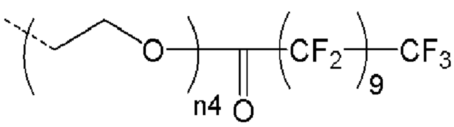

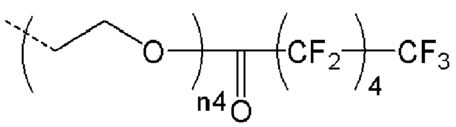 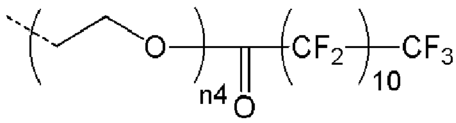

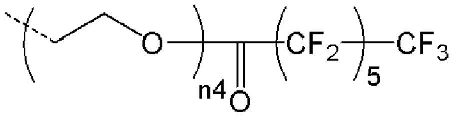 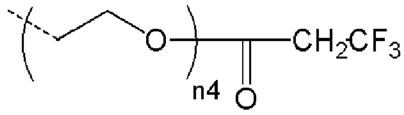

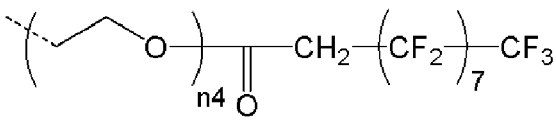

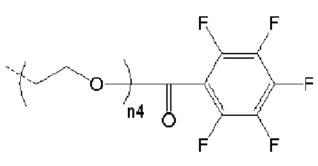 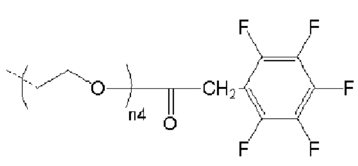 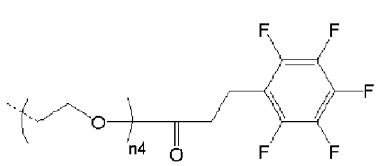

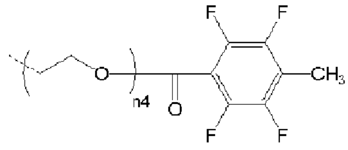

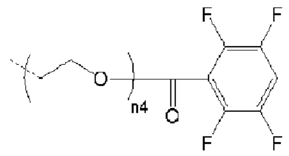

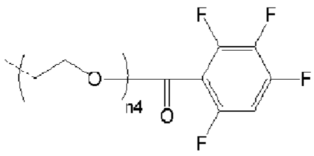

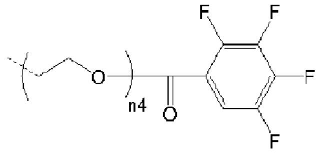

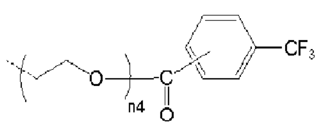

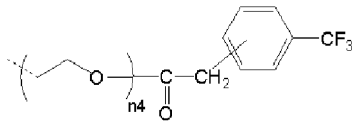

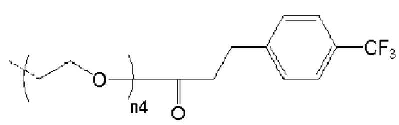

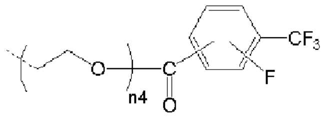

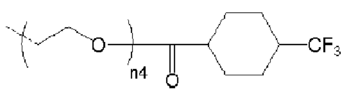

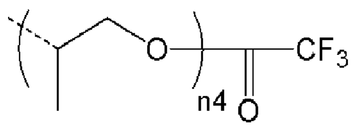

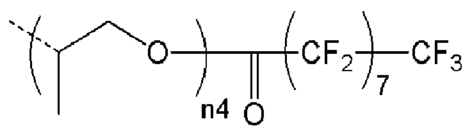

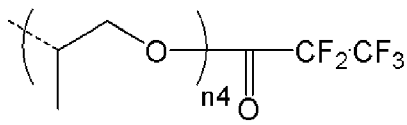

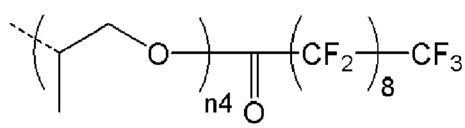

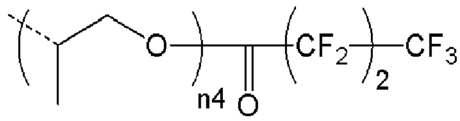

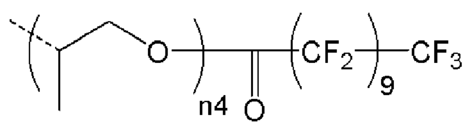

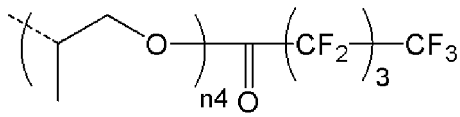

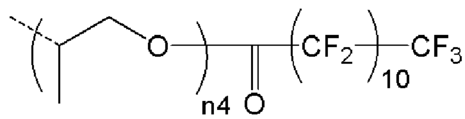

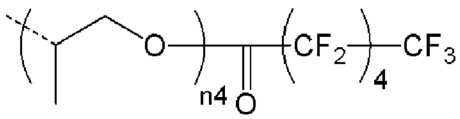

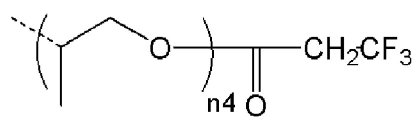

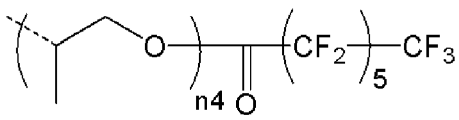
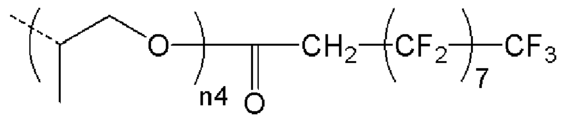
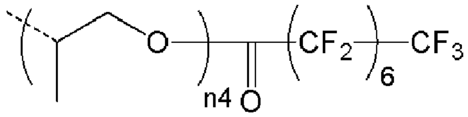
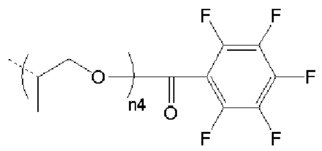
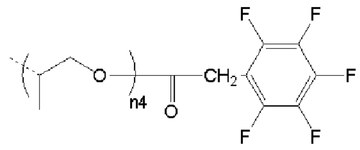
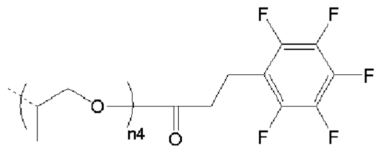
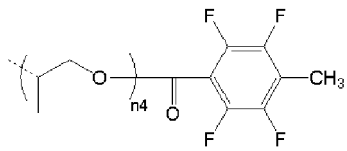
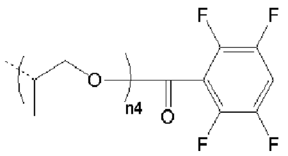
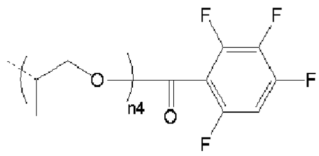
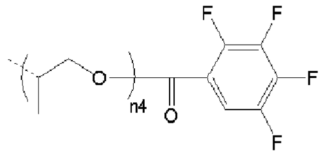
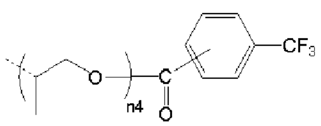
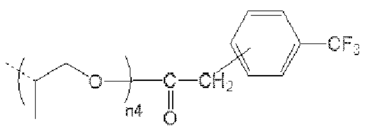
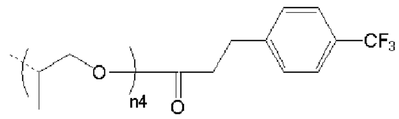
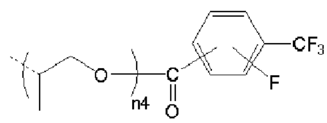
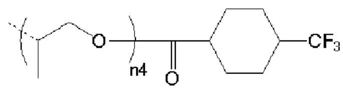
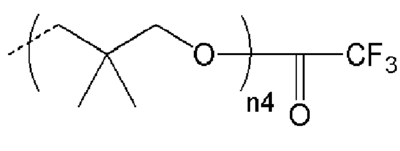
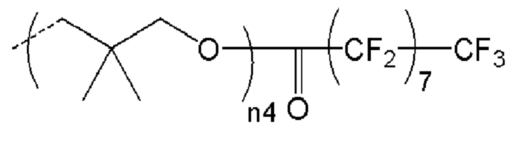
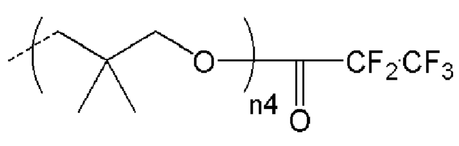
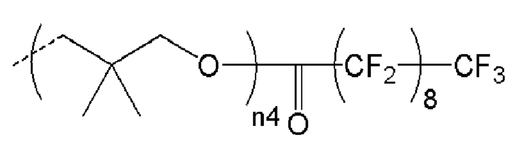

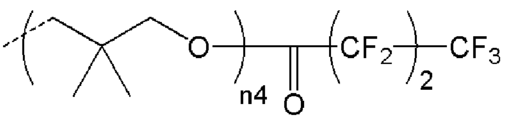

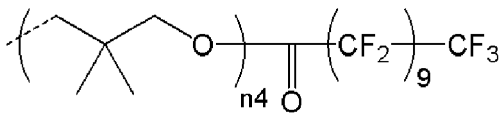

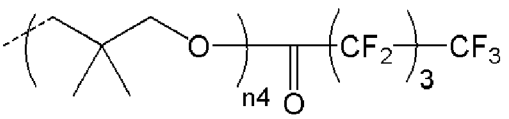

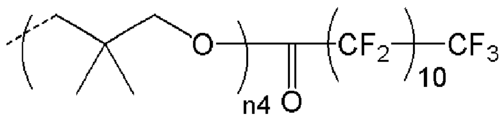

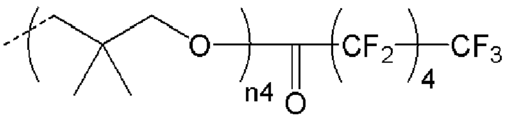

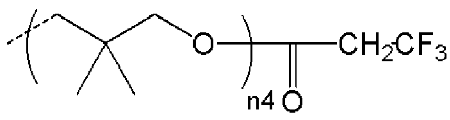

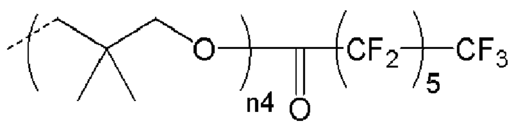

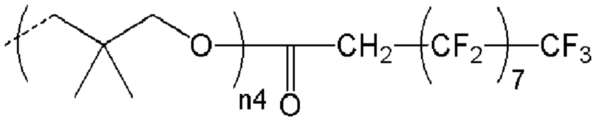

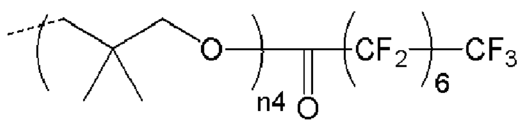

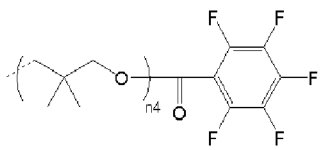

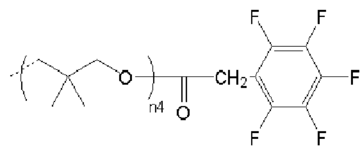

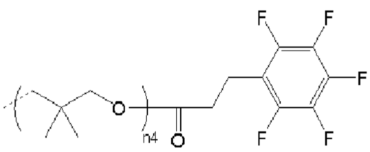

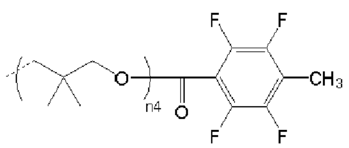

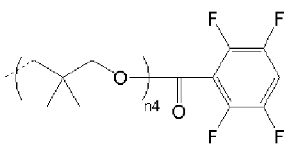

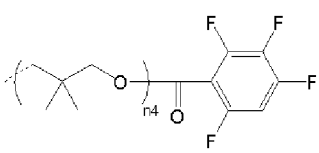

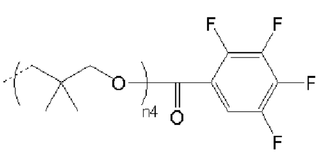

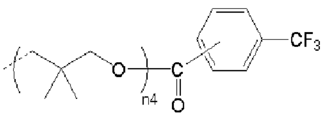

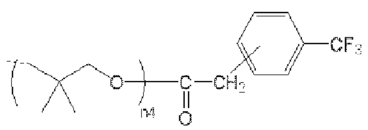

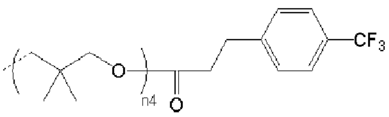

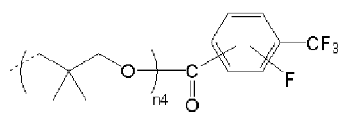

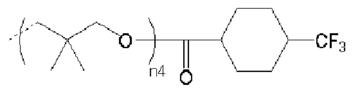

wherein the broken line represents a bond; and n4 represents an integer of 1 to 6, preferably an integer of 1 to 3, more preferably 1 or 2, and most preferably 1.

Preferable specific examples of the organic group represented by the general formula (32) include, but are not limited to, the following,

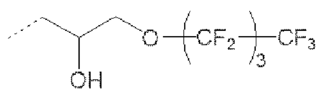
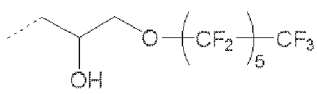
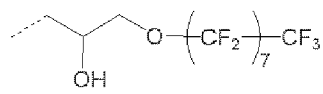

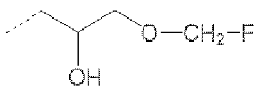
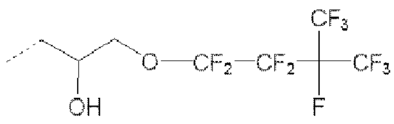
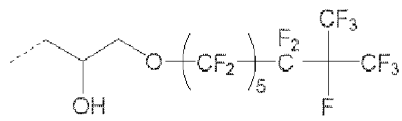

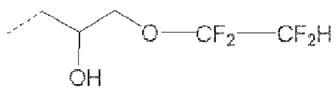
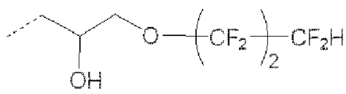
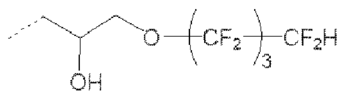

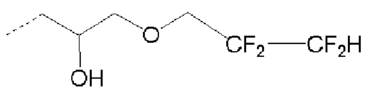
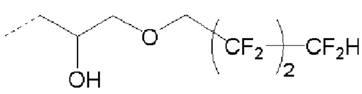

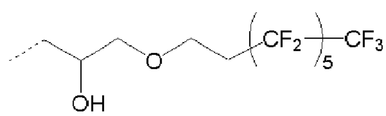

wherein the broken line represents a bond.

After patterning of the photosensitive resin composition containing, as the base resin, the polymer described above containing the tetracarboxylic acid diester compound represented by the general formula (27) and obtained by a reaction, during the heating upon post-curing, a ring-closing reaction of imidization proceeds in the structure unit of the polyimide precursor; at this time, the introduced $R^{16}$ is eliminated and removed from the system, and thus a decrease in the thickness of the formed film is observed. Therefore, in order to minimize the film loss at the time of post-curing, $R^{16}$ more preferably has a small molecular weight.

Examples of preferable methods for producing the tetracarboxylic acid diester compound represented by the general formula (27) include a method of introducing $R^{16}$ by reacting a tetracarboxylic acid dianhydride represented by the following general formula (41) and a compound having a hydroxyl group at its terminal represented by the following general formula (42) in the presence of a basic catalyst such as pyridine,

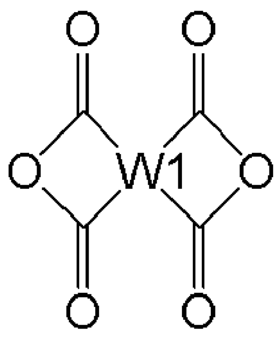

(41)

wherein W1 is as defined above,

$$HO-(V_1)_q-(Rf)_r \quad (42)$$

wherein $V_1$, Rf, q and r are as defined above.

Suitable examples of the tetracarboxylic acid dianhydride represented by the general formula (41) include aromatic acid dianhydrides, alicyclic acid dianhydrides, aliphatic acid dianhydrides, and the like. Examples of the aromatic acid dianhydride include, but not limited to, pyromellitic acid dianhydride, 3,3',4,4'-biphenyl tetracarboxylic acid dianhydride, 2,3,3',4'-biphenyl tetracarboxylic acid dianhydride ,2,3,2',3'-biphenyl tetracarboxylic acid dianhydride, 3,3',4,4'-terphenyl tetracarboxylic acid dianhydride, 3,3',4,4'-oxyphthalic acid dianhydride, 2,3,3',4'-oxyphthalic acid dianhydride, 2,3,2',3'-oxyphthalic acid dianhydride, diphenylsulfone-3,3',4,4'-tetracarboxylic acid dianhydride, benzophenone-3,3',4,4'-tetracarboxylic acid dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,4-(3,4-dicarboxyphenoxy)benzene dianhydride, p-phenylene bis(trimellitic acid monoesteric anhydride), bis(1,3-dioxo-1,3-dihydroisobenzofuran-5-carboxylic acid) 1,4-phenylene, 2,2-bis(4-(4-aminophenoxy) phenyl)propane, 1,2,5,6-naphthalene tetracarboxylic acid dianhydride, 2,3,6,7-naphthalene tetracarboxylic acid dianhydride, 9,9-bis(3,4-dicarboxyphenyl)fluorene dianhydride, 2,3,5,6-pyridine tetracarboxylic acid dianhydride, 3,4,9,10-perylene tetracarboxylic acid dianhydride, 2,2-bis(3,4-dicarboxyphenyl)hexafluoropropane dianhydride, 2,2-bis(4-(3,4-dicarboxybenzoyloxy)phenyl)hexafluoropropane dianhydride, 1,6-difluoropromellitic acid dianhydride, 1-trifluoromethyl pyromellitic acid dianhydride, 1,6-ditrifluoromethyl pyromellitic acid dianhydride, 2,2'-bis(trifluoromethyl)-4,4'-bis(3,4-dicarboxyphenoxy)biphenyl dianhydride, 2,2'-bis[(dicarboxyphenoxy)phenyl]propane dianhydride, 2,2'-bis[(dicarboxyphenoxy)phenyl]hexafluoropropane dianhydride, or acid dianhydride compounds in which these aromatic rings are substituted with an alkyl group, an alkoxy group, a halogen atom or the like.

Examples of the alicyclic acid dianhydride include, but are not limited to, 1,2,3,4-cyclobutanetetracarboxylic acid dianhydride, 1,2,3,4-cyclopentanetetracarboxylic acid dianhydride, 1,2,4,5-cyclohexane tetracarboxylic acid dianhydride, 1,2,4,5-cyclopentane tetracarboxylic acid dianhydride, 1,2,3,4-tetramethyl-1,2,3,4-cyclobutane tetracarboxylic acid dianhydride, 1,2-dimethyl-1,2,3,4-cyclobutane tetracarboxylic acid dianhydride, 1,3-dimethyl-1,2,3,4-cyclobutane tetracarboxylic acid dianhydride, 1,2,3,4-cycloheptane tetracarboxylic acid dianhydride, 2,3,4,5-tetrahydrofuran tetracarboxylic acid dianhydride,3,4-dicarboxy-1-cyclohexyl succinic acid dianhydride, 2,3,5-tricarboxycyclopentyl acetic acid dianhydride, 3,4-dicarboxy-1,2,3,4-tetrahydro-1-naphthalene succinic acid dianhydride, bicyclo[3,3,0]octane-2,4,6,8-tetracarboxylic acid dianhydride, bicyclo[4,3,0]nonane - 2,4,7,9-tetracarboxylic acid dianhydride, bicyclo[4,4,0]decane-2,4,7,9-tetracarboxylic acid dianhydride, bicyclo[4,4,0]decane-2,4,8,10-tetracarboxylic acid dianhydride, tricyclo[6,3,0,0<2,6>]undecane-3,5,9,11-tetracarboxylic acid dianhydride, bicyclo[2,2,2]octane-2,3,5,6-tetracarboxylic acid dianhydride, bicyclo[2,2,2]oct-7-ene-2,3,5,6-tetracarboxylic acid dianhydride, bicyclo[2,2,1]heptanetetracarboxylic acid dianhydride, bicyclo[2,2,1]heptane-5-carboxymethyl-2,3,6-tricarboxylic acid dianhydride, 7-oxabicyclo[2,2,1]heptane-2,4,6,8-tetracarboxylic acid dianhydride, octahydronaphthalene-1,2,6,7-tetracarboxylic acid dianhydride, tetradecahydroanthracene-1,2,8,9-tetracarboxylic acid dianhydride, 3,3',4,4'-dicyclohexane tetracarboxylic acid dianhydride, 3,3',4,4'-oxydicyclohexane tetracarboxylic acid dianhydride, 5-(2,5-dioxotetrahydro-3-furanyl)-3-methyl-3-cyclohexene-1,2-dicarboxylic acid anhydride, and "RIKACID" (registered trademark) BT-100 (all trade names, manufactured by New Japan Chemical Co., Ltd.) and derivatives thereof, as well as acid dianhydride compounds in which their alicyclic rings are substituted with an alkyl group, an alkoxy group, a halogen atom or the like.

Examples of the aliphatic acid dianhydride include, but are not limited to, 1,2,3,4-butanetetracarboxylic acid dianhydride, 1,2,3,4-pentanetetracarboxylic acid dianhydride, a derivative thereof, and the like.

These aromatic acid dianhydrides, alicyclic acid dianhydrides, or aliphatic acid dianhydrides may be used singly or in combination of two or more.

The tetracarboxylic acid dianhydride represented by the general formula (41) and the compound represented by the general formula (42) having a hydroxyl group at its terminal are reacted by stirring, dissolving, and mixing of them in a reaction solvent at a reaction temperature of 20 to 50°C for 4 to 10 hours in the presence of a basic catalyst such as pyridine to proceed a half-esterification reaction of the acid dianhydride, thereby obtaining a solution in which the desired tetracarboxylic acid diester compound represented by the general formula (27) is dissolved in a reaction solvent.

The obtained tetracarboxylic acid diester compound may be isolated, or the obtained solution may be used as it is for the reaction with a diamine in the subsequent step described below.

The reaction solvent is preferably a solvent capable of sufficiently dissolving the tetracarboxylic acid diester compound and the polymer having the structure unit of the polyimide precursor obtained by the subsequent polycondensation reaction of the tetracarboxylic acid diester compound and a diamine; examples thereof include N-methyl-2-pyrrolidone, N,N-dimethylacetamide, N,N-dimethylformamide, dimethyl sulfoxide, tetramethylurea, γ-butyrolactone, and the like. Further, ketones, esters, lactones, ethers, halogenated hydrocarbons, hydrocarbons and the like may also be used. Specific examples include acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, hexane, heptane, benzene, toluene, xylene and the like. They may be used singly or two or more of them may be mixed. However, as explained above, it is desirable to avoid the use of N-methyl-2-pyrrolidone.

On the other hand, the polymer as the component (A) in the present invention may simultaneously contain the diamine represented by the following general formula (43) as another diamine, and may be a polymer having a structure obtained by reacting a diamine including one or more of the diamine represented by the general formula (2) and the diamine represented by the general formula (3) and one or more of the tetracarboxylic acid dianhydride represented by the general formula (4) and the dicarboxylic acid or dicarboxylic acid halide represented by the general formula (5), or one or more of the tetracarboxylic acid dianhydride represented by the general formula (8) and the dicarboxylic acid or dicarboxylic acid halide represented by the general formula (9).

$$H_2N\text{-}G\text{-}NH_2 \qquad (43)$$

G in the structure unit (43) is a divalent organic group, which is not limited insofar as it is a divalent organic group; however, G is preferably a divalent organic group having 6 to 40 carbon atoms, and more preferably a cyclic organic group having 1 to 4 aromatic rings or aliphatic rings having a substituent, or an aliphatic group or a siloxane group with no cyclic structure. More preferable examples of G include a structure represented by the following formula (44) or (45). Further, the structure of G may be one kind or a combination of two or more kinds,

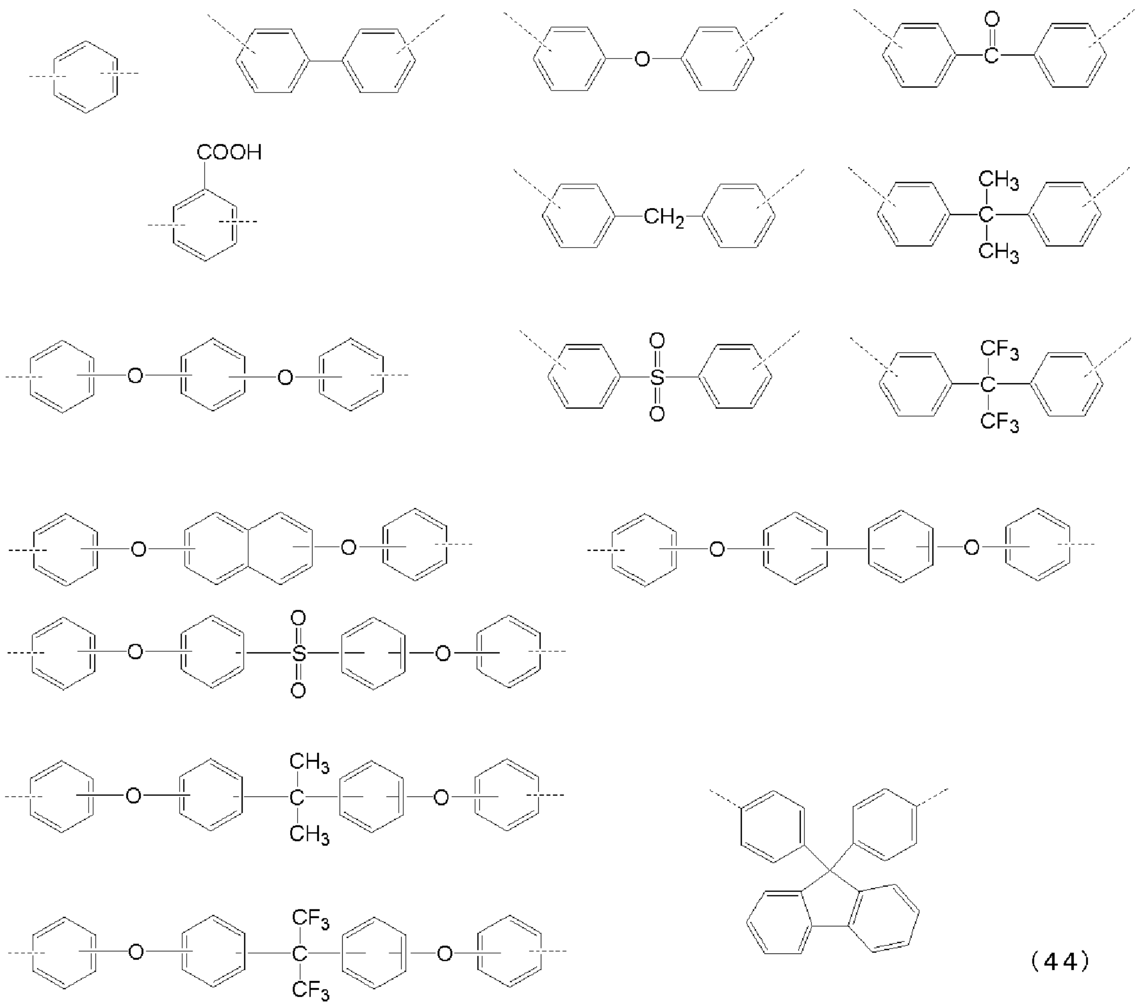

(44)

wherein the broken line represents a bond with an amino group;

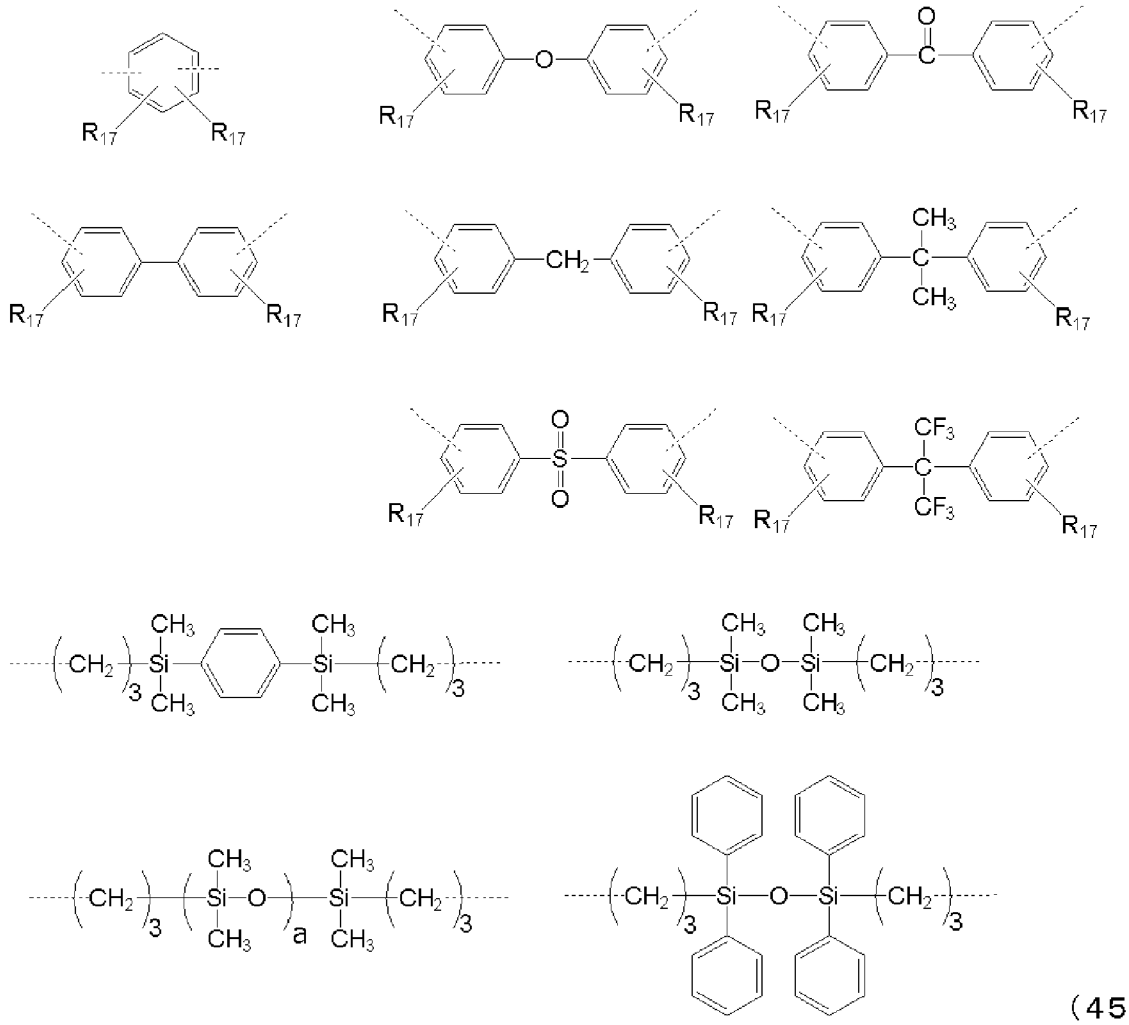

(45)

wherein the broken line represents a bond with an amino group; $R_{17}$ each independently represent a methyl group, an ethyl group, a propyl group, an n-butyl group, or a trifluoromethyl group; and "a" represents a positive number of 2 to 20.

On the other hand, the alkali-soluble resin as the component (A) may be a polymer having a structure obtained by reacting a diamine including one or more of the diamine represented by the general formula (2) and the diamine represented by the general formula (3) with one or more of the tetracarboxylic acid dianhydrides represented by the general formula (4),

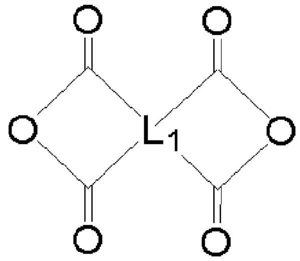

(4)

wherein L1 represents a tetravalent hydrocarbon group having 1 to 100 carbon atoms, which may be substituted with a heteroatom or intervened by a heteroatom.

L1 in the formula of the tetracarboxylic acid dianhydride represented by the general formula (4) is preferably a tetravalent organic group similar to W1 in the general formula (41). Further, preferable examples of the tetracarboxylic acid dianhydride represented by the general formula (4) include the tetracarboxylic acid dianhydride represented by the general formula (41).

Further, the alkali-soluble resin as the component (A) may be a polymer having a structure obtained by reacting

a diamine including one or more of the diamine represented by the general formula (2) and the diamine represented by the general formula (3) with one or more of the dicarboxylic acid or dicarboxylic acid halide represented by the following general formula (5) and other dicarboxylic acids or dicarboxylic acid halides represented by the general formula (5),

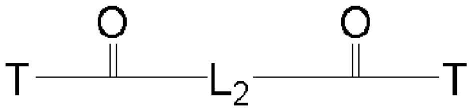
(5)

wherein L2 represents a divalent hydrocarbon group having 1 to 100 carbon atoms, which may be substituted with a heteroatom or intervened by a heteroatom; T represents any of a hydroxy group, a fluorine atom, a chlorine atom, a bromine atom, an iodine atom, $-OCO_2R^T$, $-OSO_2R^T$, and $-OSO_3R^T$, provided that $R^T$ represents a monovalent hydrocarbon group having 1 to 10 carbon atoms, which may be substituted with a heteroatom or intervened by a heteroatom.

In the formula, L2 is a divalent organic group of an aromatic group or a cycloaliphatic aliphatic group or an aliphatic chain length structure having 4 to 40 carbon atoms. L2 is further preferably a divalent organic group represented by the following general formula (46). Further, the structure of L2 may be one kind or a combination of two or more kinds,

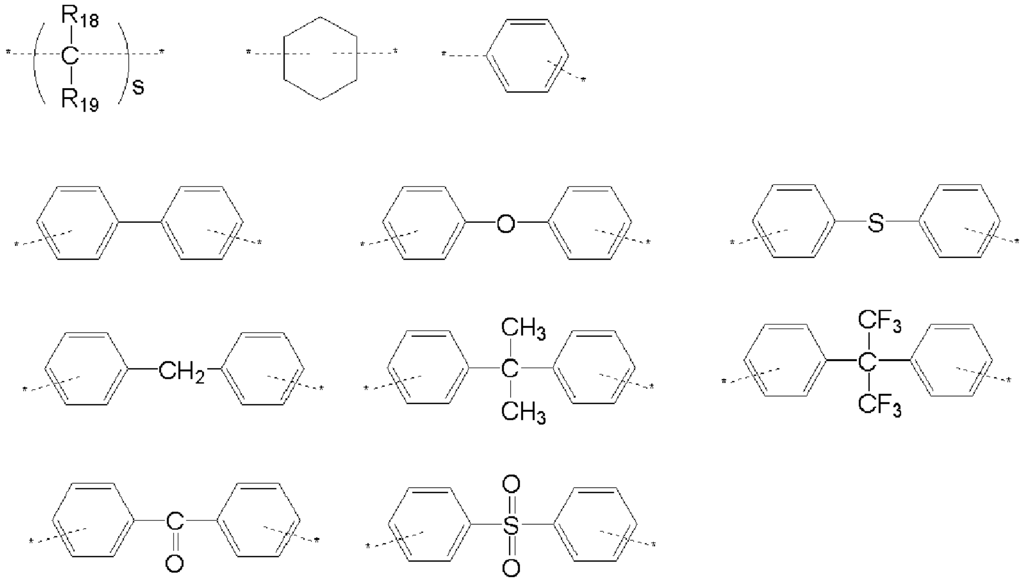
(46)

wherein $R_{18}$ and $R_{19}$ each independently represent hydrogen, fluorine, or an alkyl group having 1 to 6 carbon atoms; s is an integer of 1 to 30; and the broken line represents a bond with a carboxy or carboxyhalide group.

When L2 in the dicarboxylic acid or dicarboxylic acid halide represented by the general formula (5) is a divalent organic group having an aliphatic chain length structure, the photosensitive resin composition containing, as the base resin, a polymer, which is a polyamide, polyamideimide, polyimide, polyimide precursor, polybenzoxazole or a polybenzoxazole precursor, of the present invention desirably has improved mechanical strength, in particular, the elongation, of the cured film.

Examples of the dicarboxylic acid compounds represented by the general formula (5) include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, octafluoroadipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic, acid, tetracosanedioic acid, pentacosanedioic acid, hexacosanedioic acid, heptacosanedioic acid, octacosanedioic acid, nonacosanedioic acid, triacontandioic acid, hentriacontandioic acid, dotriacontandioic acid, diglycolic acid, and the like.

Examples of the dicarboxylic acid compound having an aromatic ring include, but are not limited to, phthalic acid, isophthalic acid, terephthalic acid, 4,4'-diphenyletherdicarboxylic acid, 3,4'-diphenyletherdicarboxylic acid, 3,3'-diphenyletherdicarboxylic acid, 4,4'-biphenyldicarboxylic acid, 3,4'-biphenyldicarboxylic acid, 3,3'-biphenyldicarboxylic

acid, 4,4'-benzophenonedicarboxylic acid, 3,4'-benzophenonedicarboxylic acid, 3,3'-benzophenonedicarboxylic acid, 4,4'-hexafluoroisopropylidenedibenzoic acid, 4,4'-dicarboxydiphenylamide, 1,4-phenylenediethanoic acid, bis(4-carboxyphenyl)sulfide, 2,2-bis(4-carboxyphenyl)-1,1,1,3,3,3,-hexafluoropropane, bis(4-carboxyphenyl)tetraphenyldisiloxane, bis(4-carboxyphenyl)tetramethyldisiloxane, bis(4-carboxyphenyl)sulfone, bis(4-carboxyphenyl)methane, 5-tert-butyl isophthalic acid, 5-bromo isophthalic acid, 5-fluoro isophthalic acid, 5-chloro isophthalic acid, 2,2-bis(p-carboxyphenyl)propane, 2,6-naphthalenedicarboxylic acid, and the like. They may be used singly or as a mixture.

Method for Producing Alkali-Soluble Resin (Component (A))

The method for producing an alkali-soluble resin (Component (A)) of the photosensitive resin composition of the present invention is shown below.
The alkali-soluble resin as the component (A) of the photosensitive resin composition of the present invention is a polymer having at least one or more structures selected from a polyamide, polyamideimide, polyimide, polybenzoxazole structure, and precursor structure units thereof obtained by reacting a diamine including one or more diamines represented by the general formula (2) and the general formula (3), with one or more of tetracarboxylic acid dianhydride represented by the general formula (4) or (8) and a dicarboxylic acid or dicarboxylic acid halide represented by the general formula (5) or (9).
Examples of the polyamide structure unit include a polyamide structure units of the following general formulae (47), (48), (49) and (50), which are obtained by reacting a diamine including one or more of the diamine represented by the general formula (2) and the diamine represented by the general formula (3) with one or more of the dicarboxylic acids or dicarboxylic acid halides represented by the general formula (5) or (9).

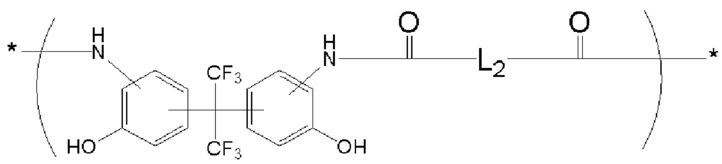

(47)

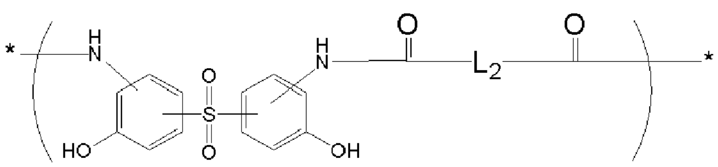

(48)

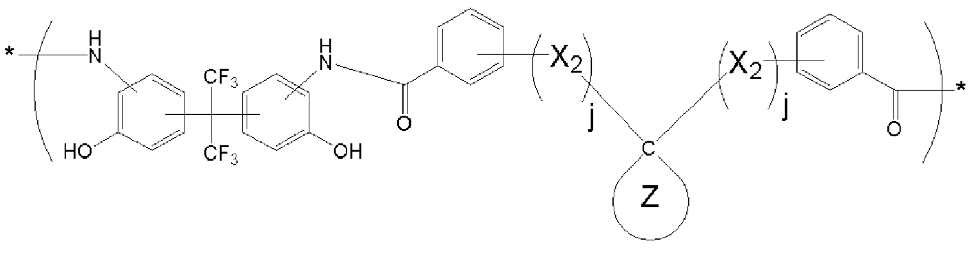

(49)

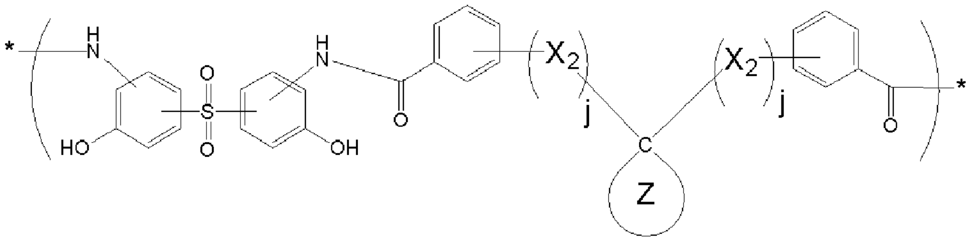

(50)

Examples of the polyimide structure unit include polyamide/polyimide structure units of the following general formulae (51), (52), (53), and (54), which are obtained by reacting a diamine including one or more of the diamine represented by the general formula (2) and the diamine represented by the general formula (3) with the tetracarboxylic acid dianhydride represented by the general formula (4) or (8).

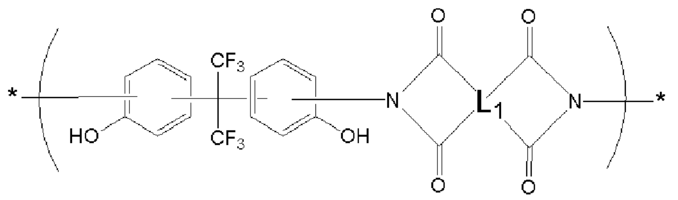

(51)

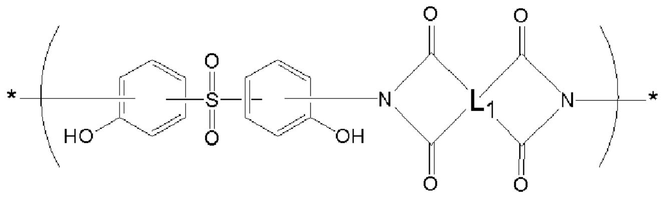

(52)

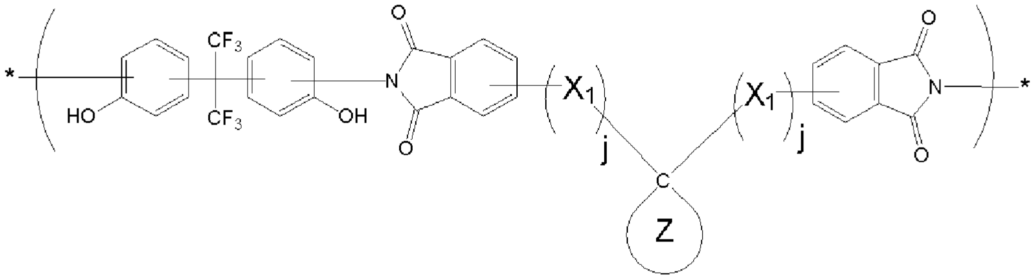

(53)

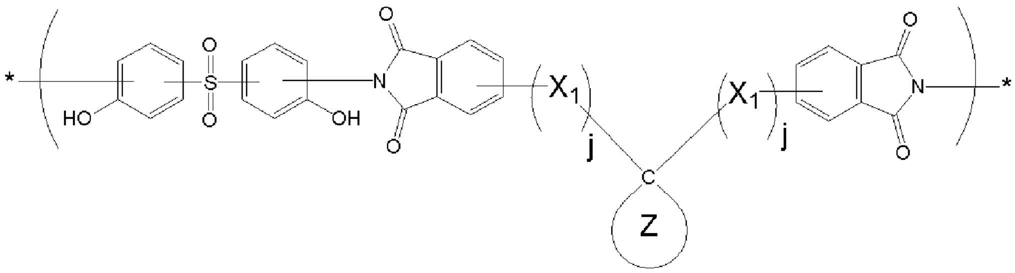

(54)

The polymer including the polyamide structure units of the above structure units (47), (48), (49) and (50) is obtainable by subjecting a dicarboxylic acid in which T of the general formula (5) is a hydrogen atom or a dicarboxylic acid in which T of the general formula (9) is a hydrogen atom to a reaction in the presence of a dehydration condensation agent or a reaction to convert the dicarboxylic acid into an acid halide compound using a halogenating agent, followed by a reaction with a diamine. Alternatively, the polymer may also be obtained by reacting a dicarboxylic acid halide in which T of the general formula (5) is a halogen atom or a dicarboxylic acid halide in which T of the general formula (9) is a halogen atom with a diamine.

The halogenating agent for converting the dicarboxylic acid into an acid halide compound may be a synthesis method of converting the dicarboxylic acid into an acid chloride using a chlorinating agent such as thionyl chloride or dichlorooxalic acid, followed by a reaction with a diamine.

A basic compound may be used in the reaction of converting the dicarboxylic acid into an acid chloride using a chlorinating agent. Examples of the basic compound include pyridine, dimethylaminopyridine, 1,8-diazabicyclo[5.4.0]undec-7-ene, 1,5-diazabicyclo[4.3.0]non-5-ene, and the like.

The solvent used in this method involving conversion into an acid chloride or the solvent used in the reaction for obtaining a polyamide structure using a dicarboxylic acid halide in which T of the general formula (5) is a halogen atom or a dicarboxylic acid halide in which T of the general formula (9) is a halogen atom that are prepared in advance is preferably a solvent that well dissolves a polymer having a polyamide structure obtained by a polycondensation reaction with an acid chloride and a dicarboxylic acid halide and further with a diamine. Specific examples thereof include N-methyl-2-pyrrolidone, N,N-dimethylacetamide, N,N-dimethylformamide, dimethyl sulfoxide, tetramethylurea, hexamethylphosphoric acid triamide, γ-butyrolactone, and the like. In addition to the polar solvents, ketones, esters, lactones, ethers, halogenated hydrocarbons, hydrocarbons, and the like may also be used. Examples include acetone, diethyl

ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene and the like. These organic solvents may be used singly or in a combination of two or more.

On the other hand, the polymer is also obtainable by reacting a diamine including one or more of the diamine represented by the general formula (2) and the diamine represented by the general formula (3) with a dicarboxylic acid in which T of the general formula (5) is a hydrogen atom or a dicarboxylic acid in which T of the general formula (9) is a hydrogen atom in the presence of a dehydration condensation agent. Specifically, the polymer having the structure units (47), (48), (49), and (50) is obtainable by adding and mixing a known dehydration condensation agent (for example, dicyclohexylcarbodiimide, 1-ethoxycarbonyl-2-ethoxy-1,2-dihydroquinoline, 1,1-carbonyldioxy-di(1,2,3)-benzotriazole, N,N'- disuccinimidyl carbonate, and the like) under ice cooling with a reaction solution in which the dicarboxylic acid in which T of the general formula (5) is a hydrogen atom or the dicarboxylic acid in which T of the general formula (9) is a hydrogen atom is dissolved in a reaction solvent similar to that described above so as to convert the dicarboxylic acid in which T of the general formula (5) is a hydrogen atom or the dicarboxylic acid in which T of the general formula (9) is a hydrogen atom into a polyacid anhydride, and another solution or dispersion in which the diamine represented by the general formula (2) or (3) is dissolved or dispersed in a solvent is added thereto dropwise to conduct polycondensation.

In the manufacture of the polymer containing the above structure units (47), (48), (49), and (50), diamines other than the diamine represented by the general formula (2) or the diamine represented by the general formula (3), for example, a different diamine represented by the general formula (43), can be used at the same time to obtain the polymer containing a polyamide structure unit of the present invention.

Next, a method for producing the polyimide structures represented by the general formulae (51), (52), (53), and (54) is described. The polyimide structures represented by the general formulae (51), (52), (53), and (54) are obtained by first reacting a diamine including one or more of the diamine represented by the general formula (2) and the diamine represented by the general formula (3) with the tetracarboxylic acid dianhydride represented by the general formula (4) or (8) to synthesize an amic acid, followed by thermal dehydration, thereby forming a polyimide structure.

The polyimide structure can be produced by dissolving a diamine in a solvent having a high boiling point and high polarity, such as γ-butyrolactone or N-methyl-2-pyrrolidone, adding an acid anhydride thereto, followed by a reaction at 0 to 80°C, preferably 10 to 50°C, to form an amic acid, then adding a nonpolar solvent such as xylene, heating the mixture to 100 to 200°C, preferably 130 to 180°C, followed by an imidization reaction while removing water from the reaction system.

In the manufacture of the polymers containing the polyimide structures represented by the general formulae (37) and (38), a tetracarboxylic acid dianhydride other than the tetracarboxylic acid dianhydride represented by the general formula (4), i.e., the tetracarboxylic acid dianhydride represented by the general formula (41) may be used at the same time to obtain a polymer containing a polyamide structure unit of the present invention.

In the manufacture of the polymer having the polyimide structures represented by the general formulae (51), (52), (53), and (54), diamines other than the diamine including one or more of the diamine represented by the general formula (2) and the diamine represented by the general formula (3), for example, a different diamine represented by the general formula (43), may be used at the same time to obtain the polymer having a polyamide structure unit of the present invention.

The polymer having the polyamideimide structure including at least one or more structures represented by the general formulae (47), (48), (49) and (50) and/or at least one or more structures represented by the general formulae (51), (52), (53) and (54) is produced by reacting a diamine including one or more of the diamine represented by the general formula (2) and the diamine represented by the general formula (3) with the tetracarboxylic acid dianhydride represented by the general formula (4) or (8) to form an amic acid, followed by a thermal dehydration of the dicarboxylic acid represented by the general formula (5) or (9) added to the same system as that of the amic acid, thereby forming a polyamideimide structure.

As another method for producing a polyamideimide structure, in the manufacture of the polymer having polyimide structures represented by the general formulae (47), (48), (49) and (50), an amic acid oligomer having an amino group at its terminal is synthesized by reacting the tetracarboxylic acid dianhydride represented by the general formula (4) or (8) using an excessive diamine including one or more of the diamine represented by the general formula (2) and the diamine represented by the general formula (3), and then reacting the terminal amino group of the amic acid oligomer and the dicarboxylic acid represented by the general formula (5) or (9) by a method similar to the method for obtaining the polyamide structure described above, thereby obtaining a polyamideimide structure.

As with the case shown above, in the manufacture of a polymer having a polyamideimide structure, diamines other than the diamine represented by the general formula (2) or the diamine represented by the general formula (3), for example, a different diamine represented by the general formula (43), can be used at the same time.

Next, a method of introducing the tetracarboxylic acid diester compound represented by the general formula

(27) is described.

As a method for introducing the tetracarboxylic acid diester compound represented by the general formula (27) into the polymer of the present invention having a polyamide, polyamideimide, or polyimide structure unit obtained by reacting a diamine including one or more diamines represented by the general formula (2) and the general formula (3) with one or more of tetracarboxylic acid dianhydride represented by the general formula (4) or (8) or a dicarboxylic acid or dicarboxylic acid halide represented by the general formula (5) or (9), an amic acid oligomer having an amino group at its terminal is synthesized by reacting the tetracarboxylic acid dianhydride represented by the general formula (4) or (8) using an excessive diamine including one or more of the diamine represented by the general formula (2) and the diamine represented by the general formula (3), and then reacting the terminal amino group of the amic acid oligomer and the tetracarboxylic acid diester compound represented by the general formula (27) by a method similar to the method for producing the polyamide structure described above, thereby introducing the tetracarboxylic acid diester compound represented by the general formula (27).

As another method, an amic acid oligomer having an amino group at its terminal is synthesized by reacting one or more of the dicarboxylic acid or dicarboxylic acid halide represented by the general formula (5) and (9) using an excessive diamine including one or more of the diamine represented by the general formula (2) and the diamine represented by the general formula (3), and then reacting the terminal amino group of the amic acid oligomer and the tetracarboxylic acid diester compound represented by the general formula (27) by a method similar to the method for obtaining the polyamide structure described above, thereby introducing the tetracarboxylic acid diester compound represented by the general formula (27).

As the alkali-soluble resin as the component (A) of the photosensitive resin composition of the present invention, the preferable molecular weight of the polymer of the present invention having a polyamide, polyamideimide, polyimide, polybenzoxazole structure unit obtained by reacting a diamine including one or more of the diamine represented by the general formula (2) and the diamine represented by the general formula (3) with one or more of the tetracarboxylic acid dianhydride represented by the general formula (4) or (8) and the dicarboxylic acid or dicarboxylic acid halide represented by the general formula (5) or (9) is preferably 5,000 to 100,000, more preferably 7,000 to 30,000. When the molecular weight is 5,000 or more, the photosensitive resin composition containing the polymer having the polyimide precursor as the base resin can be easily formed into a film with a desired thickness on a substrate. When the molecular weight is 100,000 or less, the viscosity of the photosensitive resin composition does not excessively increase, and there is no risk of failure of film formation.

The both terminals of the polymer of the present invention may be blocked with a terminal blocking agent in order to control the molecular weight in the condensation polymerization reaction and to suppress changes in molecular weight of the obtained polymer over time, i.e., to suppress the gelation. Examples of the terminal blocking agent which reacts with the acid dianhydride include monoamine, monohydric alcohol, and the like. Examples of the terminal blocking agent that reacts with the diamine compound include acid anhydrides, monocarboxylic acids, monoacid chloride compounds, monoactive ester compounds, dicarbonate esters, vinyl ethers, and the like. By reacting a terminal blocking agent, various organic groups can be introduced as terminal groups.

Examples of the monoamine used as agents to block the terminals of acid anhydride groups include, but are not limited to, aniline, 5-amino-8-hydroxyquinoline, 4-amino-8-hydroxyquinoline, 1-hydroxy-8-aminonaphthalene, 1-hydroxy-7-aminonaphthalene, 1-hydroxy-6-aminonaphthalene, 1-hydroxy-5-aminonaphthalene, 1-hydroxy-4-aminonaphthalene, 1-hydroxy-3-aminonaphthalene, 1-hydroxy-2-aminonaphthalene, 1-amino-7-hydroxynaphthalene, 2-hydroxy-7-aminonaphthalene, 2-hydroxy-6-aminonaphthalene, 2-hydroxy-5-aminonaphthalene, 2-hydroxy-4-aminonaphthalene, 2-hydroxy-3-aminonaphthalene, 1-amino-2-hydroxynaphthalene, 1-carboxy-8-aminonaphthalene, 1-carboxy-7-aminonaphthalene, 1-carboxy-6-aminonaphthalene, 1-carboxy-5-aminonaphthalene, 1-carboxy-4-aminonaphthalene, 1-carboxy-3-aminonaphthalene, 1-carboxy-2-aminonaphthalene, 1-amino-7-carboxynaphthalene, 2-carboxy-7-aminonaphthalene, 2-carboxy-6-aminonaphthalene, 2-carboxy-5-aminonaphthalene, 2-carboxy-4-aminonaphthalene, 2-carboxy-3-aminonaphthalene, 1-amino-2-carboxynaphthalene, 2-aminonicotinic acid, 4-aminonicotinic acid, 5-aminonicotinic acid, 6-aminonicotinic acid, 4-aminosalicylic acid, 5-aminosalicylic acid, 6-aminosalicylic acid, ameride, 2-aminobenzoic acid, 3-aminobenzoic acid, 4-aminobenzoic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 5-amino-8-mercaptoquinoline, 4-amino-8-mercaptoquinoline, 1-mercapto-8-aminonaphthalene, 1-mercapto-7-aminonaphthalene, 1-mercapto-6-aminonaphthalene, 1-mercapto-5-aminonaphthalene, 1-mercapto-4-aminonaphthalene, 1-mercapto-3-aminonaphthalene, 1-mercapto-2-aminonaphthalene, 1-amino-7-mercaptonaphthalene, 2-mercapto-7-aminonaphthalene, 2-mercapto-6-aminonaphthalene, 2-mercapto-5-aminonaphthalene, 2-mercapto-4-aminonaphthalene, 2-mercapto-3-aminonaphthalene, 1-amino-2-mercaptonaphthalene, 3-amino-4,6-dimercaptopyrimidine, 2-aminothiophenol, 3-aminothiophenol, 4-aminothiophenol, 2-ethynylaniline, 3-ethynylaniline, 4-ethynylaniline, 2,4-diethynylaniline, 2,5-diethynylaniline, 2,6-diethynylaniline, 3,4-diethynylaniline, 3,5-diethynylaniline, 1-ethynyl-2-aminonaphthalene, 1-ethynyl-3-aminonaphthalene, 1-ethynyl-4-aminonaphthalene, 1-ethynyl-5-aminonaphthalene, 1-ethynyl-6-aminonaphthalene, 1-ethynyl-7-aminonaphthalene, 1-ethynyl-8-aminonaphthalene, 2-ethynyl-1-aminonaphthalene, 2-ethynyl-3-aminonaphthalene, 2-ethynyl-4-aminonaphthalene, 2-ethynyl-5-aminonaphthalene, 2-ethynyl-6-aminonaphthalene, 2-ethynyl-7-aminonaphthalene, 2-ethynyl-8-aminonaphthalene, 3,5-diethynyl-1-aminonaphthalene, 3,5-diethynyl-2-aminonaphthalene, 3,6-diethynyl-1-aminonaphthalene, 3,6-diethynyl-2-aminonaphthalene, 3,7-diethynyl-1-aminonaphthalene, 3,7-diethynyl-2-aminonaphthalene, 4,8-diethynyl-1-aminonaphthalene, 4,8-diethynyl-2-aminonaphthalene, and the like. These terminal blocking agents may be used singly or two or more kinds thereof may be used in combination.

On the other hand, examples of the monohydric alcohol used as agents to block the terminals of acid anhydride groups include, but are not limited to, methanol, ethanol, 1-propanol, 2-propanol, 1-butanol, 2-butanol, 1-pentanol, 2-pentanol, 3-pentanol, 1-hexanol, 2-hexanol, 3-hexanol, 1-heptanol, 2-heptanol, 3-heptanol, 1-octanol, 2-octanol, 3-octanol, 1-nonanol, 2-nonanol, 1-decanol, 2-decanol, 1-undecanol, 2-undecanol, 1-dodecanol, 2-dodecanol, 1-tridecanol, 2-tridecanol, 1-tetradecanol, 2-tetradecanol, 1-pentadecanol, 2-pentadecanol, 1-hexadecanol, 2-hexadecanol, 1-heptadecanol, 2-heptadecanol, 1-octadecanol, 2-octadecanol, 1-nonadecanol, 2-nonadecanol, 1-icosanol, 2-methyl-1-propanol, 2-methyl-2-propanol, 2-methyl-1-butanol, 3-methyl-1-butanol, 2-methyl-2-butanol, 3-methyl-2-butanol, 2-propyl-1-pentanol, 2-ethyl-1-hexanol, 4-methyl-3-heptanol, 6-methyl-2-heptanol, 2,4,4-trimethyl-1-hexanol, 2,6-dimethyl-4-heptanol, isononyl alcohol, 3,7-dimethyl-3-octanol, 2,4-dimethyl-1-heptanol, 2-heptylundecanol, ethylene glycol monoethyl ether, ethylene glycol monomethyl ether, ethylene glycol monobutyl ether, propylene glycol 1-methyl ether, diethylene glycol monoethyl ether, diethylene glycol monomethyl ether, diethylene glycol monobutyl ether, cyclopentanol, cyclohexanol, cyclopentane monomethylol, dicyclopentane monomethylol, tricyclodecane monomethylol, norborneol, terpineol and the like. These terminal blocking agents may be used singly or two or more kinds thereof may be used in combination.

Examples of the acid anhydride, monocarboxylic acid, monoacid chloride compound and monoactive ester compound used as the agents to block the terminals of amino group include, but are not limited to, an acid anhydride such as phthalic anhydride, maleic anhydride, nadic anhydride, cyclohexane dicarboxylic anhydride or 3-hydroxyphthalic anhydride; monocarboxylic acids such as 2-carboxyphenol, 3-carboxyphenol, 4-carboxyphenol, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-carboxybenzenesulfonic acid, 3-carboxybenzenesulfonic acid, 4-carboxybenzenesulfonic acid, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid or 8-ethynyl-2-naphthoic acid, and monoacid chloride compounds obtained by the acid chlorination of carboxyl group thereof; monoacid chloride compounds obtained by the acid chlorination of only monocarboxyl group of dicarboxylic acids, such as terephthalic acid, phthalic acid, maleic acid, cyclohexanedicarboxylic acid, 3-hydroxyphthalic acid, 5-norbornene-2,3-dicarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene and 2,7-dicarboxynaphthalene; active ester compounds obtained by a reaction of a monoacid chloride compound with N-hydroxybenzotriazole or N-hydroxy-5-norbornene-2,3-dicarboximide; and the like.

Examples of dicarbonate ester compounds used as the agents to block the terminal of the amino group include di-tert-butyl dicarbonate, dibenzyl dicarbonate, dimethyl dicarbonate, diethyl dicarbonate, and the like.

Examples of vinyl ether compounds used as the agents to block the terminal of the amino group include chloroformic acid esters such as tert-butyl chloroformate, n-butyl chloroformate, isobutyl chloroformate, benzyl chloroformate, allyl chloroformate, ethyl chloroformate or isopropyl chloroformate; isocyanate compounds such as butyl isocyanate, 1-naphthyl isocyanate, octadecyl isocyanate and phenyl isocyanate; butyl vinyl ether, cyclohexyl vinyl ether, ethyl vinyl ether, 2-ethylhexyl vinyl ether, isobutyl vinyl ether, isopropyl vinyl ether, n-propyl vinyl ether, tert-butyl vinyl ether, benzyl vinyl ether and the like.

Examples of other compounds used as the agents to block the terminal of the amino group include benzyl chloroformate, benzoyl chloride, fluorenylmethyl chloroformate, 2,2,2-trichloroethyl chloroformate, allyl chloroformate, methanesulfonic acid chloride, p-toluenesulfonic acid chloride, phenyl isocyanate and the like.

The proportion of the agent for blocking the terminals of the acid anhydride group to be introduced is preferably in the range of 0.1 to 60 mol%, particularly preferably 5 to 50 mol%, more preferably 5 to 20 mol%, relative to the tetracarboxylic acid dianhydride component represented by the general formula (4) or (8) or the carboxylic acid component represented by the general formula (5) or (9). The proportion of the agent for blocking the terminals of the amino group to be introduced is preferably in the range of 0.1 to 100 mol%, particularly preferably 5 to 90 mol%, relative to the diamine containing one or more of the diamine represented by the general formula (2) and the diamine represented by the general formula (3), and the diamine component represented by the general formula (43). By reacting a plurality of terminal

blocking agents, plural different terminal groups may be introduced.

(B) Photoacid Generator

Next, the photoacid generator as the component (B) of the negative photosensitive resin composition of the present invention is described.
A photoacid generator that generates an acid upon exposure to light having a wavelength of 190 to 500 nm to serve as a crosslinking catalyst may be used. Examples include onium salts, diazomethane derivatives, glyoxime derivatives, β-ketosulfone derivatives, disulfone derivatives, nitrobenzyl sulfonate derivatives, sulfonic acid ester derivatives, imidoyl sulfonate derivatives, oxime sulfonate derivatives, imino sulfonate derivatives, triazine derivatives, and the like.
Examples of the onium salts include the compound represented by the following general formula (60),

$$(R^{20})_nM^+ U^- \qquad (60)$$

wherein $R^{20}$ is a linear, branched, or cyclic alkyl group having 1 to 12 carbon atoms, an aryl group having 6 to 12 carbon atoms or aralkyl group having 7 to 12 carbon atoms, which may have a substituent; $M^+$ is an iodonium cation or sulfonium cation; $U^-$ is a non-nucleophilic counter ion; and n is 2 or 3.
Examples of the alkyl group of $R^{20}$ include a methyl group, an ethyl group, a propyl group, a butyl group, a cyclohexyl group, a 2-oxocyclohexyl group, a norbornyl group, an adamantyl group, and the like. Examples of the aryl group include a phenyl group; an alkoxyphenyl group such as o-, m- or p-methoxyphenyl group, an ethoxyphenyl group, or an m- or p-tert-butoxyphenyl group; and an alkylphenyl group such as a 2-, 3-, or 4-methylphenyl group, an ethylphenyl group, a 4-tert-butylphenyl group, a 4-butylphenyl group, or a dimethylphenyl group. Examples of the aralkyl group include a benzyl group, a phenethyl group, and the like.
Examples of the non-nucleophilic counter ion represented by $U^-$ include halide ions such as chloride ion or bromide ion; fluoroalkylsulfonate such as triflate, 1,1,1-trifluoroethanesulfonate, or nonafluorobutanesulfonate; arylsulfonate such as tosylate, benzenesulfonate, 4-fluorobenzenesulfonate, or 1,2,3,4,5-pentafluorobenzenesulfonate; alkylsulfonate such as mesylate or butanesulfonate, and the like.
Here, as described above, the anion of the acid generated from the photoacid generator undergoes anion exchange with the organic carboxylic acid anion that is suitable as the anion of the onium salt of the component (D), thereby increasing the dissolution contrast and the resolution; therefore, the component (B) is particularly preferably the organic sulfonic acid represented by the following general formula (7),

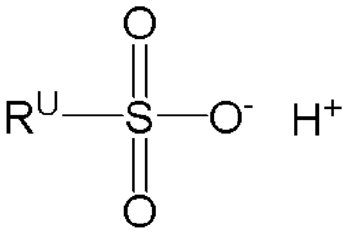

(7)

wherein $R^U$ represents a hydrocarbon group having 1 to 100 carbon atoms, which may be substituted with a heteroatom or intervened by a heteroatom.
That is, sulfonate is preferable as the non-nucleophilic counter ion of $U^-$.
Examples of the diazomethane derivative of the photoacid generator as the component (B) of the present invention include the compound represented by the following general formula (60),

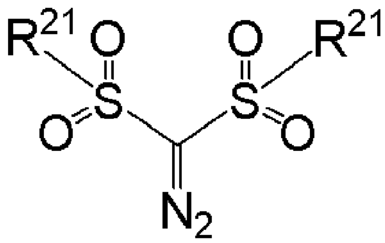

(60)

wherein each $R^{21}$ may be identical to or different from one another, and represents a linear, branched, or cyclic alkyl group or halogenated alkyl group having 1 to 12 carbon atoms, an aryl group or aryl halide group having 6 to 12 carbon

atoms, or an aralkyl group having 7 to 12 carbon atoms.

Examples of the alkyl group of $R^{21}$ include a methyl group, an ethyl group, a propyl group, a butyl group, an amyl group, a cyclopentyl group, a cyclohexyl group, a norbornyl group, an adamantyl group, and the like. Examples of the halogenated alkyl group include a trifluoromethyl group, a 1,1,1-trifluoroethyl group, a 1,1,1-trichloroethyl group, a nonafluorobutyl group, and the like. Examples of the aryl group include a phenyl group; an alkoxyphenyl group such as o-, m- or p-methoxyphenyl group, an ethoxyphenyl group, or an m- or p-tert-butoxyphenyl group; and an alkylphenyl group such as a 2-, 3-, or 4-methylphenyl group, an ethylphenyl group, a 4-tert-butylphenyl group, a 4-butylphenyl group, or a dimethylphenyl group. Examples of the aryl halide group include a fluorophenyl group, a chlorophenyl group, a 1,2,3,4,5-pentafluorophenyl group, and the like. Examples of the aralkyl group include a benzyl group, a phenethyl group, and the like.

Specific examples of such a photoacid generator include: onium salts such as diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, and diphenyl(4-thiophenoxyphenyl)sulfonium hexafluoroantimonate; diazomethane derivatives such as bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-amylsulfonyl)diazomethane, bis(isoamylsulfonyl)diazomethane, bis(sec-amylsulfonyl)diazomethane, bis(tert-amylsulfonyl)diazomethane, 1-cyclohexylsulfonyl-1-(tert-butylsulfonyl)diazomethane, 1-cyclohexylsulfonyl-1-(tert-amylsulfonyl)diazomethane, and 1-tert-amylsulfonyl-1-(tert-butylsulfonyl)diazomethane; glyoxime derivatives such as bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime, and bis-o-(camphorsulfonyl)-α-dimethylglyoxime; oxime sulfonate derivatives such as α-(benzenesulfoniumoxyimino)-4-methylphenylacetonitrile; β-ketosulfone derivatives such as 2-cyclohexylcarbonyl-2-(p-toluenesulfonyl)propane and 2-isopropylcarbonyl-2-(p-toluenesulfonyl)propane; disulfone derivatives such as diphenyl disulfone and dicyclohexyl disulfone; nitrobenzyl sulfonate derivatives such as 2,6-dinitrobenzyl p-toluenesulfonate and 2,4-dinitrobenzyl p-toluenesulfonate; sulfonate ester derivatives such as 1,2,3-tris(methanesulfonyloxy)benzene, 1,2,3-tris(trifluoromethanesulfonyloxy)benzene, and 1,2,3-tris(p-toluenesulfonyloxy)benzene; and imidoyl sulfonate derivatives such as phthalimidoyl triflate, phthalimidoyl tosylate, 5-norbornene-2,3-dicarboxyimidoyl triflate, 5-norbornene-2,3-dicarboxyimidoyl tosylate, 5-norbornene-2,3-dicarboxyimidoyl n-butylsulfonate, and n-trifluoromethylsulfonyloxynaphthylimide; iminosulfonate such as (5-(4-methylphenyl)sulfonyloxyimino-5H-thiophen-2-ylidene)-(2-methylphenyl)acetonitrile and (5-(4-(4-methylphenylsulfonyloxy)phenylsulfonyloxyimino)-5H-thiophen-2-ylidene)-(2-methylphenyl)acetonitrile; 2-methyl-2[(4-methylphenyl)sulfonyl]-1-[(4-methylthio)phenyl]-1-propane; and the like. Among them, imidoyl sulfonates, imino sulfonates, oxime sulfonates, and the like are preferred. These photoacid generators may be used singly or in a combination of two or more.

In this case, the acid generated from the photoacid generator is preferably an organic sulfonic acid represented by the general formula (7) for the same reason as above.

The incorporation amount of the photoacid generator as the component (B) is preferably 0.05 to 20 parts by mass, and particularly preferably 0.2 to 5 parts by mass relative to 100 parts by mass of the component (A) in the negative photosensitive resin composition of the present invention from the viewpoint of light absorption of the photoacid generator itself and photocurability in a thick film.

(C) Crosslinking Agent

The component (C) of the negative photosensitive resin composition of the present invention is one or two or more kinds of crosslinking agent selected from an amino condensate modified with formaldehyde or formaldehyde-alcohol, a phenol compound having on average two or more methylol groups or alkoxymethylol groups within one molecule, a compound in which a hydrogen atom of a hydroxyl group of polyhydric phenol is substituted with a glycidyl group or a group having a glycidyl group, a compound in which a hydrogen atom of polyhydric phenol is substituted with a group represented by the following formula (C-1), a compound represented by the following formula (C-15) having a substituent (C-1), and a compound containing two or more nitrogen atoms having a glycidyl group represented by the following formula (C-2),

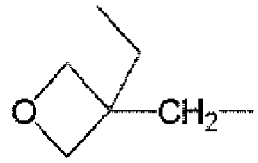

(C-1)

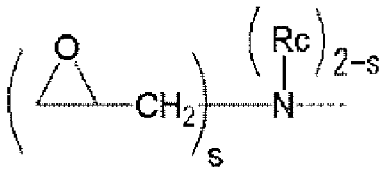

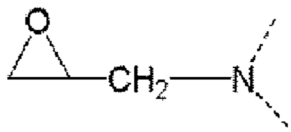

(C-2)

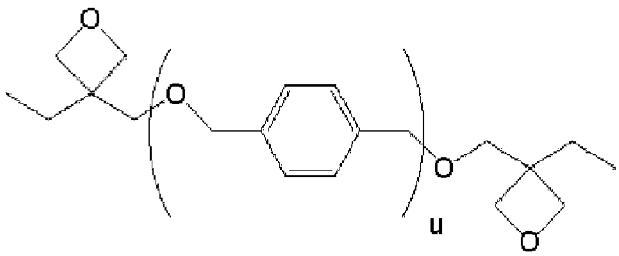

(C-15)

wherein the broken line represents a bond, Rc represents a linear, branched, or cyclic alkyl group having 1 to 6 carbon atoms; s represents 1 or 2; u is a number satisfying $1 \leq u \leq 3$.

Examples of the amino condensate modified with formaldehyde or formaldehyde-alcohol include a melamine condensate modified with formaldehyde or formaldehyde-alcohol, and a urea condensate modified with formaldehyde or formaldehyde-alcohol.

The melamine condensate modified with formaldehyde or formaldehyde-alcohol is prepared, for example, by modifying a melamine monomer with formalin into a methylol form by a known method, and optionally, further modifying it with an alcohol into an alkoxy form, thereby obtaining the modified melamine represented by the general formula (45). The alcohols used herein are preferably lower alcohols, for example, alcohols having 1 to 4 carbon atoms,

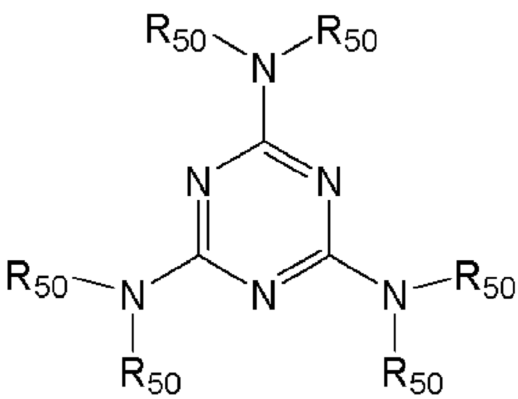

(45)

wherein each $R_{50}$ may be identical to or different from one another, and represents a methylol group, an alkoxymethyl group containing an alkoxy group having 1 to 4 carbon atoms, or a hydrogen atom; and at least one $R_{50}$ is a methylol group or the alkoxymethyl group. Examples of $R_{50}$ include a methylol group, an alkoxymethyl group such as a methoxymethyl group or an ethoxymethyl group, a hydrogen atom, and the like.

Specific examples of the modified melamine represented by the general formula (45) include trimethoxymethyl monomethylol melamine, dimethoxymethyl monomethylol melamine, trimethylol melamine, hexamethylol melamine, hexamethoxymethylol melamine, and the like. Subsequently, the modified melamine represented by the general formula (45) or a multimer thereof (e.g., oligomer such as a dimer or trimer) is subjected to addition condensation polymerization with formaldehyde according to a standard method until a desired molecular weight is obtained, thereby obtaining a melamine condensate modified with formaldehyde or formaldehyde-alcohol.

Also, the urea condensate modified with formaldehyde or formaldehyde-alcohol is prepared, for example, by modifying a urea condensate having a desired molecular weight with formaldehyde into a methylol form according to a known method, and optionally, further modifying it with an alcohol into an alkoxy form. Specific examples of the urea condensate modified with formaldehyde or formaldehyde-alcohol include methoxymethylated urea condensates, ethoxymethylated urea condensates, propoxymethylated urea condensates, and the like.

Only one kind of these modified melamine condensates and modified urea condensates may be used or a combination of two or more kinds of them may be mixed.

Examples of the phenol compound having on average two or more methylol groups or alkoxymethylol groups within one molecule include (2-hydroxy-5-methyl)-1,3-benzenedimethanol, 2,2',6,6'-tetramethoxymethylbisphenol A, the compounds represented by the following formulae (C-3) to (C-7), and the like.

C-3

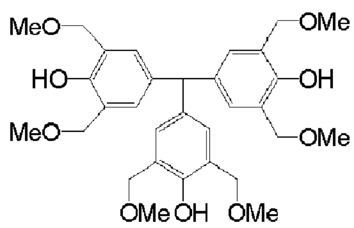

C-4

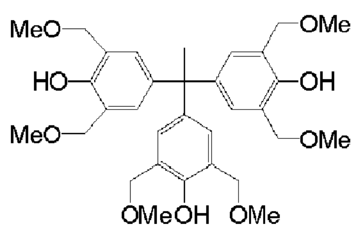

C-5

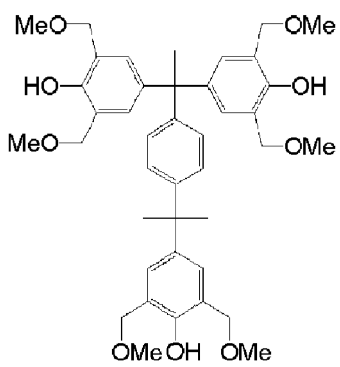

C-6

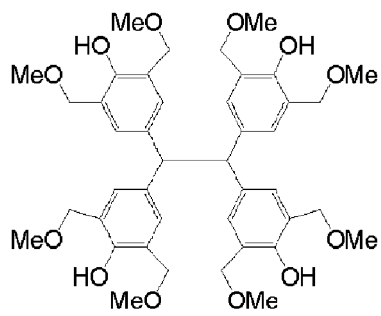

C-7

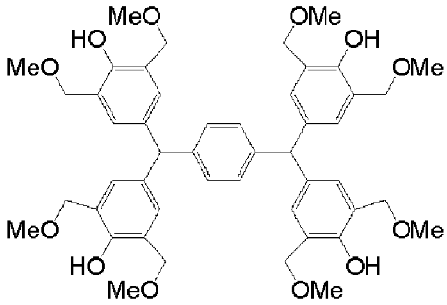

These crosslinking agents may be used singly or in a combination of two or more.

Examples of the compounds in which the hydrogen atom of the hydroxyl group of polyhydric phenol is substituted with a glycidyl group include compounds obtained by reacting hydroxyl groups of bisphenol A, tris(4-hydroxyphenyl)methane, and 1,1,1-tris(4-hydroxyphenyl)ethane with epichlorohydrin in the presence of a base. Preferable examples of the compound in which the hydrogen atom of the hydroxyl group of polyhydric phenol is substituted with a glycidyl group or substituted with a group having a glycidyl group include the compounds represented by the following formulae (C-8) to (C-14),

C-8

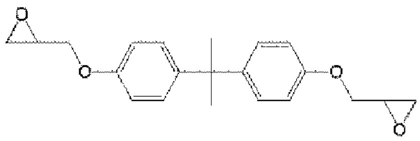

C-9

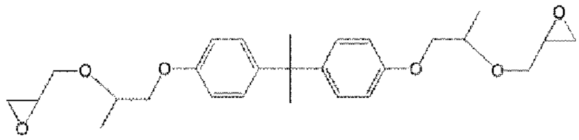

C-10

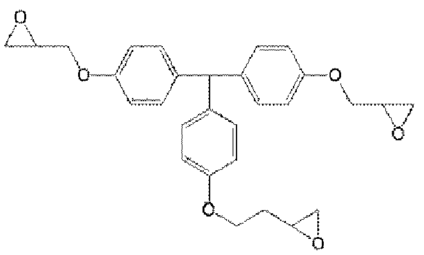

C-11

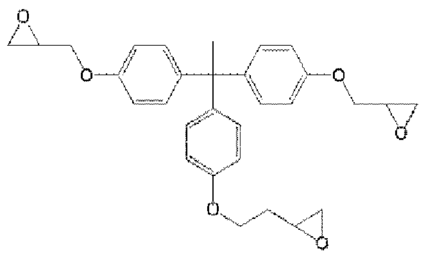

C-12

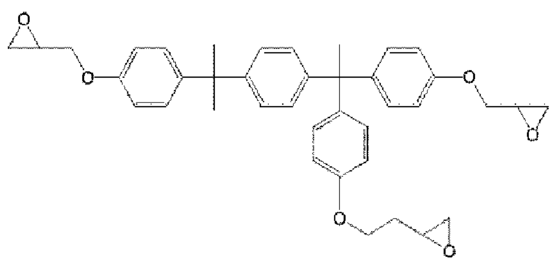

C-13

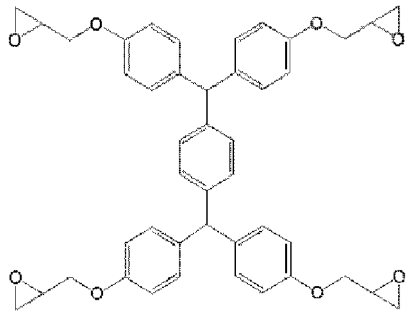

C-14

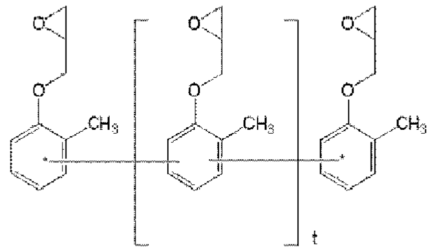

wherein t satisfies 2≤t≤3.

These compounds in which the hydroxyl group of polyhydric phenol is substituted with a glycidoxy group may also be used individually or in a combination of two or more as the crosslinking agent.

Examples of the compound in which the hydrogen atom of the hydroxyl group of polyhydric phenol is substituted with the substituent represented by the following formula (C-1) contains two or more of this substituent, and examples thereof include those represented by the following formulae C-22 to C-24.

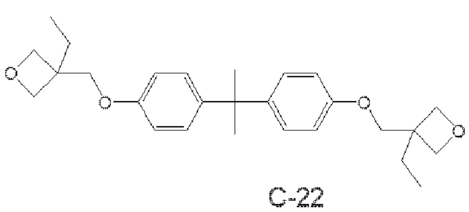

C-22

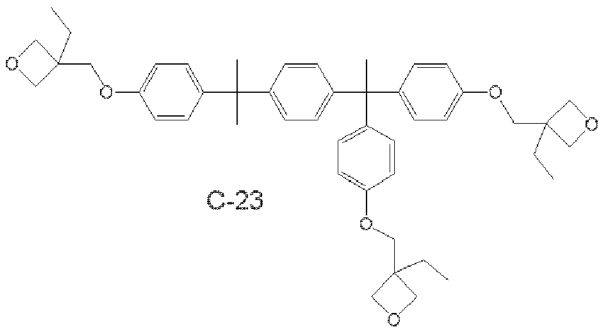

C-23

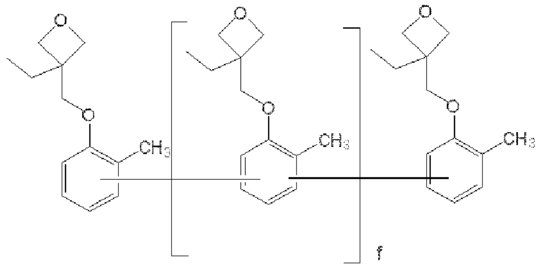

C-24

Further, examples of the compound represented by the following formula (C-15) having the substituent (C-1) include the following formula,

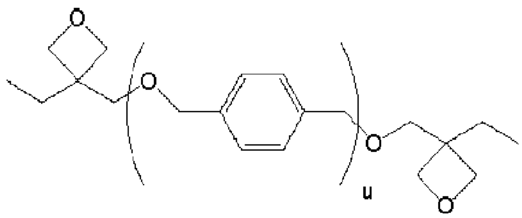

(C-15)

wherein u is a number satisfying 1≤u≤3.

On the other hand, examples of the compound containing two or more nitrogen atoms having a glycidyl group represented by the following formula (C-2) include the compound represented by the following formula (C-16),

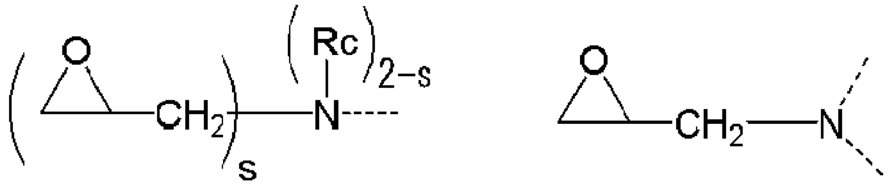

(C-2)

wherein the broken line represents a bond, Rc represents a linear, branched, or cyclic alkyl group having 1 to 6 carbon atoms; and s represents 1 or 2,

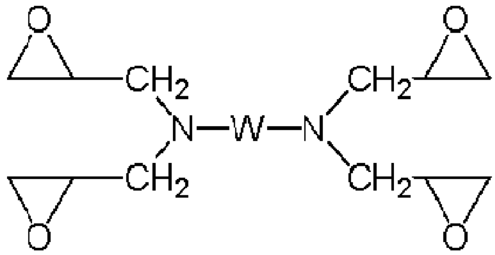

(C-16)

wherein W represents a linear, branched, or cyclic alkylene group having 2 to 12 carbon atoms, or a divalent aromatic group.

Examples of the compound represented by the formula (C-16) include the compounds represented by the following formulae (C-17) to (C-20) .

C-17

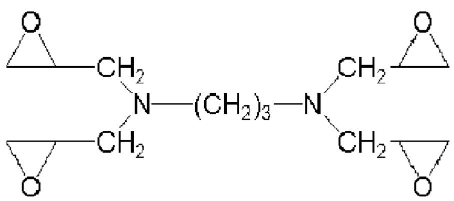

C-18

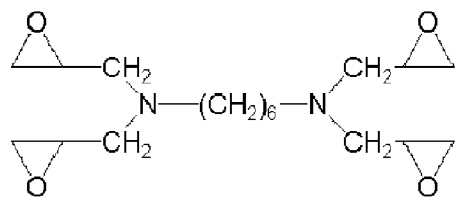

C-19

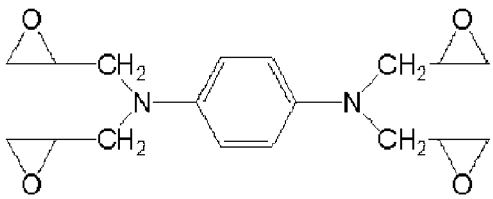

C-20

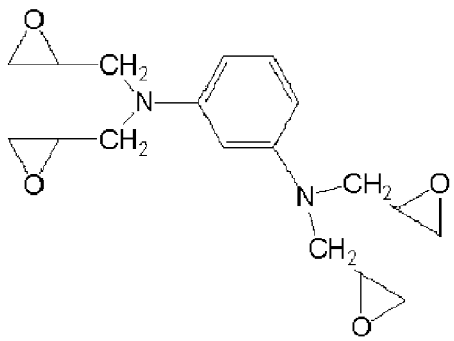

On the other hand, suitable examples of the compound containing two or more nitrogen atoms having a glycidyl group represented by the formula (C-2) include the compound represented by the following formula (C-21) .

C-21

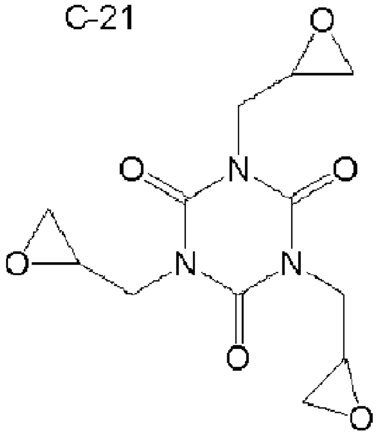

These compounds containing two or more nitrogen atoms having a glycidyl group represented by the formula (C-2) may be used singly or in a combination of two or more as the crosslinking agent.

The component (C) is a component that induces a crosslinking reaction in post-curing after the patterning of the negative photosensitive resin composition using the polymer containing a polyimide precursor of the present invention, thereby further increasing the strength of the cured product. The weight average molecular weight of such a component (C) is preferably 150 to 10,000 and particularly preferably 200 to 3,000, in view of photocurability and heat resistance.

The incorporation amount of the component (C) is 0.5 to 50 parts by mass, preferably 1 to 30 parts by mass, and more preferably 5 to 20 parts by mass, relative to 100 parts by mass of the component (A).

(E) Solvent

The component (E) of the photosensitive resin composition of the present invention is a solvent. The solvent as the component (E) is not limited insofar as it dissolves the components (A) and (B), the component (C), and the component (D). Examples of the solvent include one or more of ketones such as cyclohexanone, cyclopentanone, or methyl-2-n-amyl ketone; alcohols such as 3-methoxybutanol, 3-methyl-3-methoxybutanol, 1-methoxy-2-propanol, or 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, or diethylene glycol dimethyl ether; esters such as propylene glycol monomethylether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butylether acetate, or γ-butyrolactone; and the like. In particular, ethyl lactate, cyclohexanone, cyclopentanone (CyPn), propylene glycol monomethylether acetate, γ-butyrolactone (GBL), and a mixed solvent thereof are preferable.

The incorporation amount of the component (E) is preferably 50 to 2,000 parts by mass, particularly preferably 100 to 1,000 parts by mass, relative to 100 parts by mass of the component (A).

The negative photosensitive resin composition of the present invention may further include components other than the component (A), the component (B), the component (C), the component (D), and the component (E). Examples of other components include adhesion aids, (F) thermal crosslinking agents, (G) surfactants, and the like.

Examples of (F) thermal crosslinking agent include polymers obtained by radical polymerization of (meth)acrylate monomers represented by the following general formula (61-1) or (61-2),

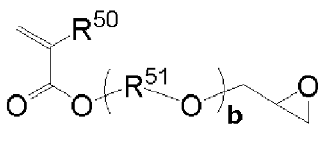 (61−1)

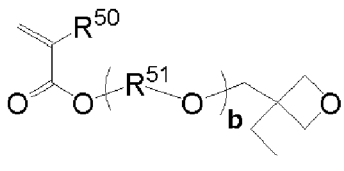 (61−2)

wherein $R^{50}$ represents a hydrogen atom or a methyl group; $R^{51}$ represents a linear, branched or cyclic alkylene group having 1 to 15 carbon atoms, which may contain an ester group, an ether group, or an aromatic hydrocarbon group; and b represents 0 or an integer from 1 to 4.

Suitable examples of (F) thermal crosslinking agent include polymers obtained by radical polymerization of the monomer represented by the following general formula (61-3).

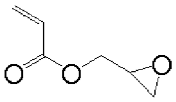 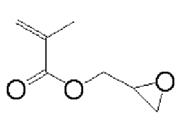 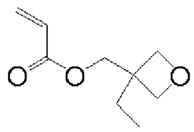 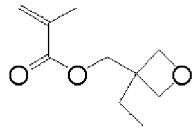

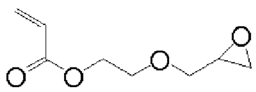 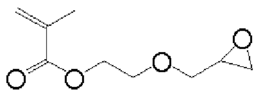

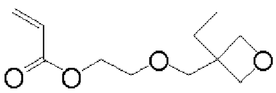 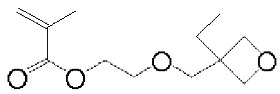

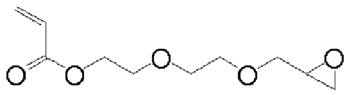 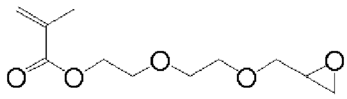

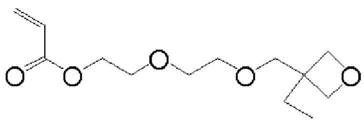 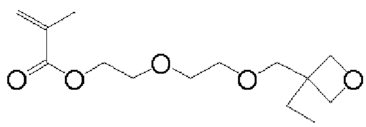

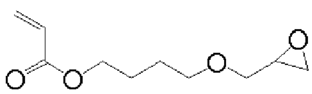 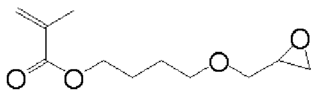

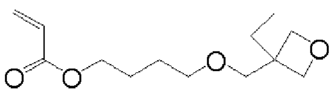 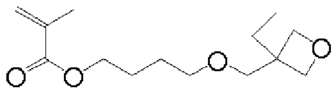

(61－3)

As the polymer obtained by radical polymerization of the (meth)acrylate monomer represented by the general formula (61-1) or (61-2) as the (F) thermal crosslinking agent, homopolymers obtained by individually polymerizing the (meth)acrylate monomer represented by the general formula (61-1) or (61-2), and copolymers obtained by polymerization with other monomers that can be copolymerized with the (meth)acrylate monomer represented by the general formula (61-1) or (61-2) can also be preferably used.

The incorporation amount of the (F) thermal crosslinking agent that can be used for the negative photosensitive resin composition of the present invention is preferably 5 to 200 parts by mass, particularly preferably 10 to 100 parts by mass, and further preferably 20 to 50 parts by mass relative to 100 parts by mass of the component (A).

Preferable examples of (G) surfactants include nonionic surfactants, e.g., fluorine-based surfactants such as perfluoroalkyl polyoxyethylene ethanols, fluorinated alkyl esters, perfluoroalkylamine oxides, fluorine-containing organosiloxane-based compounds, and the like.

These surfactants may be commercially available surfactants, such as Fluorad FC-4430 (manufactured by Sumitomo 3M Ltd.), Surflon S-141 and S-145 (manufactured by Asahi Glass Co., Ltd.), Unidyne DS-401, DS-4031, and DS-451 (manufactured by Daikin Industries Ltd.), Megaface F-8151 (manufactured by DIC Corporation), X-70-093 (manufactured by Shin-Etsu Chemical Co., Ltd), and the like. Among them, Fluorad FC-4430 (manufactured by Sumitomo 3M Ltd.) and X-70-093 (manufactured by Shin-Etsu Chemical Co., Ltd.) are preferable. The incorporation amount of the (G) surfactant that can be used in the negative photosensitive resin composition of the present invention is 0.01 to 1.0 parts by mass, preferably 0.01 to 0.1 parts by mass, more preferably 0.01 to 0.05 parts by mass, relative to 100 parts by mass of the component (A).

Patterning Process

Next, a patterning process using the negative photosensitive resin composition of the present invention is described.

Any known lithography may be used in the patterning using the negative photosensitive resin composition of the present invention. For example, the photosensitive resin composition is applied onto a silicon wafer, $SiO_2$ substrate, SiN substrate, or a substrate on which a copper wire pattern or the like is formed, by a spin coating technique (spin coat method), followed by prebaking at 80 to 130°C for about 50 to 600 seconds, to form a photosensitive material film having a thickness of 1 to 50 um, preferably 1 to 30 um, more preferably 5 to 20 μm.

In the spin coat method, about 5 mL of the photosensitive resin composition is dispensed on the silicon substrate and then the substrate is spined, thereby coating the substrate with the photosensitive resin composition. In this method, the thickness of the photosensitive material film on the substrate can be easily adjusted by adjusting the rotation rate.

Subsequently, a mask for forming the desired pattern is held over the photosensitive material film, followed by exposure to electron beams or high-energy rays having a wavelength of 190 to 500 nm, such as i-line, g-line or the like, at an exposure dose of about 1 to 5,000 mJ/cm$^2$, preferably about 100 to 2,000 mJ/cm$^2$.

Then, the pattern thus exposed is developed. The negative photosensitive resin composition of the present invention can be developed with an aqueous alkaline solution.

On the other hand, a 2.38% tetramethyl hydroxy ammonium (TMAH) aqueous solution is suitable as an aqueous alkaline solution for alkaline development. The development can be performed by a standard method, such as a spray method or a puddle method, or immersion in a developer. The development is followed by washing, rinsing, drying and the like as necessary, thereby obtaining a resin composition film having a desired pattern.

Further, by heating and post-curing the film on which the pattern is formed by the patterning process above at a temperature of 100 to 300°C, preferably 150 to 300°C, and more preferably 180 to 250°C using an oven or a hotplate, a cured film can be formed. By performing the post-curing step at a temperature of 100 to 300°C, it is possible to increase the crosslinking density of the film of the photosensitive resin composition and remove any residual volatile components; thus, it is preferable in terms of adhesion to substrates, heat resistance, strength, and electric properties. The post-curing time may range from 10 minutes to 10 hours.

Protective Coating and Interlayer Insulating Film for Covering Electronic Components such as Wiring, Circuit, Substrate, and the like.
The pattern thus formed is used for the purpose of protective coating and interlayer insulating film for covering electronic components such as wiring, circuits, substrates, and the like. The formed pattern and the protective coating have excellent insulating properties, and exhibit excellent adhesion ability on a metal layer such as a Cu layer of wiring or a circuit to be coated, a metal electrode on a substrate, or an insulating substrate such as SiN present in wiring or a circuit to be coated, and also can greatly improve resolution performance for enabling formation of a finer pattern while keeping the mechanical strength suitable as protective coating or an interlayer insulating film.

The cured film thus obtained has adhesion to substrates, heat resistance, electric properties, mechanical strength, excellent chemical resistance in alkaline stripping solutions, as well as reliability of semiconductor devices coated with the protective coating, and, in particular, also prevents cracks upon the temperature cycling test; therefore, it can be suitably used as protective coating and interlayer insulating film of electric and electronic components, semiconductor devices, and the like.

The protective coating and the interlayer insulating film described above are effective for insulating films for semiconductor devices including rewiring applications, insulating films for multilayer printed circuit boards, solder masks, coverlay film applications, and the like, due to their heat resistance, chemical resistance, and insulating properties.

EXAMPLE

The present invention is specifically described below with reference to Examples and Comparative Examples. However, the present invention is not limited to these Examples.

Synthesis Examples, Comparative Synthesis Examples, Examples, and Comparative Examples are shown below to specifically describe the present invention. However, the present invention is not limited to these Examples.

I. Synthesis of Resin

In Synthesis Examples below, the compounds having the following chemical structures and names were used.

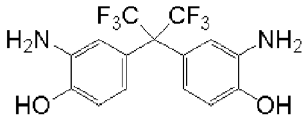
6FAP

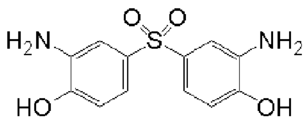
BPS

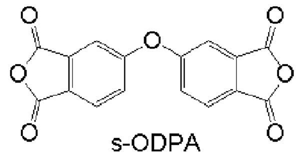
s-ODPA

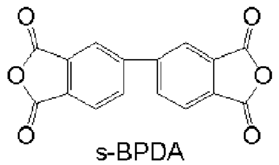
s-BPDA

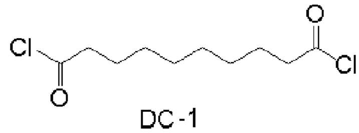
DC-1

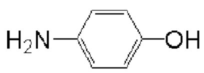
PAP

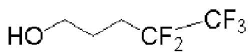
Rf-1

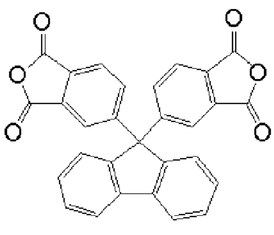
AN-1

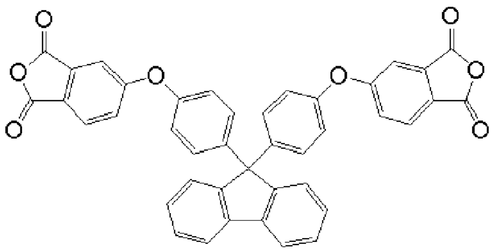
AN-2

6FAP: 2,2-bis(3-amino-4-hydroxyphenyl)hexafluoropropane BPS: bis(3-amino-4-hydroxyphenyl)sulfone s-ODPA: 3,3',4,4'-oxydiphthalic acid dianhydride s-BPDA: 3,3',4,4'-biphenyl tetracarboxylic acid dianhydride DC-1: Dichloride sebacate PAP: 4-aminophenol Rf-1: 4,4,5,5,5-pentafluoropentanol

Synthesis Example 1: Synthesis of Polyimide Resin (A-1)

30g (81.9 mmol) of 2,2-bis(3-amino-4-hydroxyphenyl)hexafluoropropane (6FAP) and 170 g of N-methyl-2-pyrrolidone were placed in a 1L flask equipped with a stirrer and a thermometer, and dissolved by stirring at room temperature. Subsequently, a solution obtained by dissolving 12.7 g (41.0 mmol) of 3,3',4,4'-oxydiphthalic acid dianhydride (s-ODPA), and 18.8 g (41.0 mmol) of tetracarboxylic acid dianhydride (AN-1) in 320 g of N-methyl-2-pyrrolidone was added dropwise at room temperature. Following completion of the dropwise addition, the mixture was stirred for 3 hours at room temperature. Thereafter, 40 g of xylene was added to the reaction solution, and the mixture was heated under reflux at 170°C for 3 hours while removing the produced water from the system. After cooling to room temperature, the resulting reaction solution was added dropwise to 2L of ultrapure water under stirring, and the precipitate was collected by filtration and washed with water as necessary, followed by drying under reduced pressure at 40°C for 48 hours to obtain a polyimide resin (A-1). The molecular weight of this polymer was measured by GPC, and the weight average molecular weight was 35,000 on polystyrene basis.

Synthesis Example 2: Synthesis of Polyimide Resin (A-2)

The same formulation as that in Synthesis Example 1 was used, except that 26.3 g of the tetracarboxylic acid dianhydride (AN-2) having the weight shown in Table 1 below was used instead of 18.8 g of the tetracarboxylic acid dianhydride (AN-1) to obtain a polyimide resin (A-2). The molecular weight of this polymer was measured by GPC, and

the weight average molecular weight was 34,000 on polystyrene basis.

Synthesis Example 3: Synthesis of Polyimide Resin (A-3)

The same formulation as that in Synthesis Example 1 was used, except that 23.0 g of bis(3-amino-4-hydroxyphenyl)sulfone (BPS) was used instead of 30.0 g of 2,2-bis(3-amino-4-hydroxyphenyl)hexafluoropropane (6FAP) to obtain a polyimide resin (A-3). The molecular weight of this polymer was measured by GPC, and the weight average molecular weight was 33,000 on polystyrene basis as shown in Table 1.

Synthesis Example 4: Synthesis of Tetracarboxylic Acid Diester Dichloride (X-1)

100 g (322 mmol) of 3,3',4,4'-oxydiphthalic acid dianhydride (s-ODPA), 65.2 g (644 mmol) of triethylamine, 39.3 g (322 mmol) of N,N-dimethyl-4-aminopyridine, and 400 g of $\gamma$-butyrolactone were placed in a 3L flask equipped with a stirrer and a thermometer, and, during the stirring of the mixture at room temperature, 114.7 g (644 mmol) of 4,4,5,5,5-pentafluoropentanol (Rf-1) was added dropwise, followed by stirring at room temperature for 24 hours. The reaction was then stopped by adding 370 g of 10% aqueous hydrochloric acid solution dropwise under ice-cooling. 800 g of 4-methyl-2-pentanone was added to the reaction solution, and the organic layer was separated and washed six times with 600 g of ultrapure water. The solvent of the obtained organic layer was removed by distillation to obtain 193 g of tetracarboxylic acid diester compound (X-1). 772 g of N-methyl-2-pyrrolidone was added to the obtained tetracarboxylic acid diester compound and the compound was dissolved by stirring at room temperature. Next, under ice-cooling, 75.8 g (637 mmol) of thionyl chloride was added dropwise to keep the temperature of the reaction solution at 10°C or less. After completion of the dropwise addition, the reaction solution was stirred under ice-cooling for 2 hours to obtain a tetracarboxylic acid diester dichloride (X-1) dissolved in N-methyl-2-pyrrolidone.

Synthesis Example 5: Synthesis of Polyamideimide Resin (A-4)

30.0 g (81.9 mmol) of 2,2-bis(3-amino-4-hydroxyphenyl)hexafluoropropane (6FAP) and 170 g of N-methyl-2-pyrrolidone were placed in a 500 ml flask equipped with a stirrer and a thermometer, and dissolved by stirring at room temperature. Subsequently, a solution obtained by dissolving 12.7 g (41.0 mmol) of 3,3',4,4'-oxydiphthalic acid dianhydride (s-ODPA), and 5.6 g (12.3 mmol) of tetracarboxylic acid dianhydride (AN-1) in 185 g of N-methyl-2-pyrrolidone was added dropwise at room temperature. Following completion of the dropwise addition, the mixture was stirred for 3 hours at room temperature. Thereafter, 40 g of xylene was added to the reaction solution, and the mixture was heated under reflux at 170°C for 3 hours while removing the produced water from the system. After cooling to room temperature, 1.4 g (18.0 mmol) of pyridine was added, and a separately prepared mixed solution of 14.7 g (4.1 mmol on the basis of tetracarboxylic acid diester dichloride) of tetracarboxylic acid diester dichloride (X-1) dissolved in N-methyl-2-pyrrolidone and 5.9 g (24.6 mmol) of sebacic acid dichloride (DC-1) was added dropwise to keep the mixture at 5°C or less. After the dropwise addition, the reaction solution was returned to room temperature, and the reaction solution was added dropwise to 2L of ultrapure water under stirring, and the precipitate was collected by filtration and washed with water as necessary, followed by drying under reduced pressure at 40°C for 48 hours to obtain a polyamideimide resin (A-4). The molecular weight of this polymer was measured by GPC, and the weight average molecular weight was 38,000 on polystyrene basis.

Synthesis Example 6: Synthesis of Polyamideimide Resin (A-5)

The same formulation as that in Synthesis Example 5 was used, except that 7.9 g of the tetracarboxylic acid dianhydride (AN-2) was used instead of 5.6 g of the tetracarboxylic acid dianhydride (AN-1) to obtain a polyimide resin (A-5). The molecular weight of this polymer was measured by GPC, and the weight average molecular weight was 39,000 on polystyrene basis as shown in Table 1.

Synthesis Example 7: Synthesis of Polyamideimide Resin (A-6)

The same formulation as that in Synthesis Example 5 was used, except that 23.0 g of bis(3-amino-4-hydroxyphenyl)sulfone (BPS) was used instead of 30 g of 2,2-bis(3-amino-4-hydroxyphenyl)hexafluoropropane (6FAP) to obtain a polyimide resin (A-6). The molecular weight of this polymer was measured by GPC, and the weight average molecular weight was 35,000 on polystyrene basis as shown in Table 1.

Synthesis Example 8: Synthesis of Polyamideimide Resin (A-7)

27.0 g (73.7 mmol) of 2,2-bis(3-amino-4-hydroxyphenyl)hexafluoropropane (6FAP) and 108 g of N-methyl-2-pyrrolidone were placed in a 500 ml flask equipped with a stirrer and a thermometer, and dissolved by stirring at room temperature. Subsequently, a solution obtained by dissolving 12.7 g (41.0 mmol) of 3,3',4,4'-oxydiphthalic acid dianhydride (s-ODPA), and 5.6 g (12.3 mmol) of tetracarboxylic acid dianhydride (AN-1) in 185 g of N-methyl-2-pyrrolidone was added dropwise at room temperature. Following completion of the dropwise addition, the mixture was stirred for 3 hours at room temperature. Thereafter, 40 g of xylene was added to the reaction solution, and the mixture was heated under reflux at 170°C for 3 hours while removing the produced water from the system. After cooling to room temperature, 0.9 g (8.2 mmol) of 4-aminophenol (PAP) and 1.4 g (18.0 mmol) of pyridine were added, and a separately prepared mixed solution of 14.7 g (4.1 mmol on the basis of tetracarboxylic acid diester dichloride) of tetracarboxylic acid diester dichloride (X-1) dissolved in N-methyl-2-pyrrolidone and 5.9 g (24.6 mmol) of sebacic acid dichloride (DC-1) was added dropwise to keep the mixture at 5°C or less. After the dropwise addition, the reaction solution was returned to room temperature, and the reaction solution was added dropwise to 2L of ultrapure water under stirring, and the precipitate was collected by filtration and washed with water as necessary, followed by drying under reduced pressure at 40°C for 48 hours to obtain a polyamideimide resin (A-7). The molecular weight of this polymer was measured by GPC, and the weight average molecular weight was 30,000 on polystyrene basis as shown in Table 1.

Synthesis Example 9: Synthesis of Polyamideimide Resin (A-8)

The same formulation as that in Synthesis Example 8 was used, except that not 12.7 g (41.0 mmol) but 14.0 g (45.1 mmol) of 3,3',4,4'-oxydiphthalic acid dianhydride (s-ODPA) was used without using the tetracarboxylic acid diester dichloride (X-1) dissolved in N-methyl-2-pyrrolidone to obtain a polyimide resin (A-8). The molecular weight of this polymer was measured by GPC, and the weight average molecular weight was 31,000 on polystyrene basis as shown in Table 1.

Synthesis Example 10: Synthesis of Polyamideimide Resin (A-9)

The same formulation as that in Synthesis Example 8 was used, except that not 12.7 g (41.0 mmol) but 11.4 g (36.9 mmol) of 3,3',4,4'-oxydiphthalic acid dianhydride (s-ODPA) was used and 1.2 g (4.1 mmol) of 3,3',4,4'-biphenyl tetracarboxylic acid dianhydride was added to obtain a polyimide resin (A-9). The molecular weight of this polymer was measured by GPC, and the weight average molecular weight was 30,000 on polystyrene basis as shown in Table 1.

Synthesis Example 11: Synthesis of Polyamideimide Resin (A-10)

The same formulation as that in Synthesis Example 10 was used, except that not 11.4 g (36.9 mmol) but 12.6 g (40.6 mmol) of 3,3',4,4'-oxydiphthalic acid dianhydride (s-ODPA) was used and not 1.2 g (4.1 mmol) but 1.35 g (4.6 mmol) of 3,3',4,4'-biphenyl tetracarboxylic acid dianhydride was used without using the tetracarboxylic acid diester dichloride (X-1) dissolved in N-methyl-2-pyrrolidone to obtain a polyimide resin (A-10). The molecular weight of this polymer was measured by GPC, and the weight average molecular weight was 30,000 on polystyrene basis as shown in Table 1.

[Table 1]

| | | Diamine Compound | | Monoamine Compound | Tetracarboxylic Acid Dianhydride | | | | Dicarboxylic Acid Dichloride | Tetracarboxylic Acid Diester Dichloride NMP Solution (Molar Amount of Tetracarboxylic Acid Dichloride) SynthesisExample **4** | Molecular Weight |
|---|---|---|---|---|---|---|---|---|---|---|---|
| | | 6 FAP | BPS | PAP | s-ODPA | s-BPDA | AN-1 | AN-2 | DC-1 | x-1 | |
| Synthesis Example 1 | A-1 | 30.0g (81.9mmol) | | | 12.7g (41.0mmol) | | 18.8g (41.0mmol) | | | | 35,000 |
| Synthesis Example 2 | A-2 | 30.0g (81.9mmol) | | | 12.7g (41.0mmol) | | | 26. 3g (41mmol) | | | 34,000 |
| Synthesis Example 3 | A-3 | | 23.0g (81. 9mmol | | 12.7g (41.0mmol) | | 18.8g (41.0mmol) | | | | 33,000 |
| Synthesis Example 5 | A-4 | 30.0g (81.9mmol) | | | 12.7g (41.0mmol) | | 5.6g (12.3mmol) | | 5.9g (24.6mmol) | 14.7g (9.1mmo1) | 38,000 |
| Synthesis Example 6 | A-5 | 30.0g (81.9mmol) | | | 12.7g (41.0mmol) | | | 7.9g (12.3mmo | 5.9g (24.6mmol) | 14.7g (9.1mmo1) | 39,000 |
| Synthesis Example 7 | A-6 | | 23.0g (81.9mmol | | 12.7g (41.0mmol) | | 5.6g (12.3mmol) | | 5.9g (24.6mmol) | 14.7g (9.1mmo1) | 35,000 |
| Synthesis Example 8 | A-7 | 27.0g (73.7mmol) | | 0.9g (8.2 mmol) | 12.7g (41.0mmol) | | 5.6g (12.3mmol) | | 5.9g (24.6mmol) | 14.7g (9.1mmo1) | 30,000 |
| Synthesis Example 9 | A-8 | 27.0g (73.7mmol) | | 0.9g (8.2 mmol) | 14.0g (45.1mmol) | | 5.6g (12.3mmol) | | 5.9g (24.6mmol) | | 31,000 |
| Synthesis Example 10 | A-9 | 27.0g (73.7mmol) | | 0.9g (8.2 mmol) | 11.4g (36.9mmol) | 1.2g (9.1mmol) | 5.6g (12.3mmol) | | 5.9g (24.6mmol) | 14.7g (9.1mmol) | 30,000 |
| Synthesis Example 11 | A-10 | 27.0g (73.7mmol) | | 0.9g (8.2 mmol) | 12.6g (40.6mmol) | 1.35g (9.6mmol) | 5.6g (12.3mmol) | | 5.9g (24.6mmol) | | 30,000 |

II. Preparation of Photosensitive Resin Composition

Resin compositions with a resin equivalent of 20 mass% were prepared according to the formulations and incorporation amounts in Tables 2 and 3 using the polyimide resins (A-1) to (A-3) synthesized in Synthesis Examples 1 to 3 above and polyamideimide resins (A-4) to (A-10) synthesized in Synthesis Examples 5 to 11 above as base resins. After subsequent stirring and mixing for dissolution, precision filtering through a Teflon (registered trademark) filter with a pore size of 0.5 um was performed to obtain a photosensitive resin composition. In the Tables, the solvent PGMEA stands for propylene glycol monomethyl ether acetate and CyPn stands for cyclopentanone.

[Table 2]

| | Resin | Photoacid Generator | Crosslinking Agent-1 | Crosslinking Agent-2 | Onium Salt | Solvent-1 | Solvent-2 |
|---|---|---|---|---|---|---|---|
| | Component (A) | Component (B) | Component (C) | | Component (D) | Component (E) | |
| Photosensitive Resin Composition 1 | A-1 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 2 | A-2 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 3 | A-3 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 4 | A-4 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 5 | A-5 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 6 | A-6 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 7 | A-7 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 8 | A-8 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 9 | A-9 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |
| Photosensitive Resin Composition 10 | A-10 (100 Parts By Weight) | B-1 (2 Parts By Weight) | CL-1 (5 Parts By Weight) | CL-2 (10 Parts By Weight) | D-1 (0.5 Parts By Weight) | PGMEA (96 Parts By Weight) | CyPn (24 Parts By Weight) |

[Table 3]

| | Resin | Photoacid Generator | Crosslinking Aaent-1 | Crosslinking Aaent-2 | Crosslinking Agent-3 | Onium Salt | Basic Comoound | Solvent-1 | Solvent-2 |
|---|---|---|---|---|---|---|---|---|---|
| | Component (A) | Component (B) | Component (C) | | | Component (D) | | Component (E) | |
| Photosensitive Resin Composition 11 | A-7 (100 Parts By Weiaht) | B-1 (2 Parts By Weioht) | CL-1 (5 Parts By Weioht) | CL-2 (10 Parts By Weight) | CL-3 (15 Parts By Weiaht) | D-1 (0.5 Parts By Weight) | | PGMEA (96 Parts By Weight) | CyPn (24 Parts By Weight) |
| Photosensitive Resin Composition 12 | A-7 (100 Parts By Weight) | B-1 (2 Parts By Weight) | CL-1 (5 Parts By Weight) | CL-2 (10 Parts By Weight) | CL-4 (15 Parts By Weight) | D-1 (0.5 Parts By Weight) | | PGMEA (96 Parts By Weight) | CyPn (24 Parts By Weight) |
| Photosensitive Resin Composition 13 | A-7 (100 Parts By Weight) | B-1 (2 Parts By Weight) | CL-1 (5 Parts By Weight) | CL-2 (10 Parts By Weight) | CL-3 (15 Parts By Weight) | D-2 (0.3 Parts By Weight) | | PGMEA (96 Parts By Weight) | CyPn (24 Parts By Weight) |
| Photosensitive Resin Composition 14 | A-7 (100 Parts By Weight) | B-1 (2 Parts By Weight) | CL-1 (5 Parts By Weight) | CL-2 (10 Parts By Weight) | CL-3 (15 Parts By Weight) | 0-3 (0.6 Parts By Weight) | | PGMEA (96 Parts By Weight) | CyPn (24 Parts By Weight) |
| Photosensitive Resin Composition 15 | A-7 (100 Parts By Weight) | B-1 (2 Parts By Weight) | CL-1 (5 Parts By Weight) | CL-2 (10 Parts By Weight) | CL-3 (15 Parts By Weight) | D-4 (0.9 Parts By Weight) | | PGMEA (96 Parts By Weight) | CyPn (24 Parts By Weight) |
| Photosensitive Resin Composition 16 | A-7 (100 Parts By Weight) | B-1 (2 Parts By Weight) | CL-1 (5 Parts By Weight) | CL-2 (10 Parts By Weight) | CL-3 (15 Parts By Weight) | D-5 (0.3 Parts By Weight) | | PGMEA (96 Parts By Weight) | CyPn (24 Parts By Weight) |
| Photosensitive Resin Composition 17 | A-7 (100 Parts By Weight) | B-1 (2 Parts By Weight) | CL-1 (5 Parts By Weight) | CL-2 (10 Parts By Weight) | CL-3 (15 Parts By Weight) | D-6 (0.5 Parts By Weight) | | PGMEA (96 Parts By Weight) | CyPn (24 Parts By Weight) |

(continued)

| | Resin | Photoacid Generator | Crosslinking Aaent-1 | Crosslinking Aaent-2 | Crosslinking Agent-3 | Onium Salt | Basic Comoound | Solvent-1 | Solvent-2 |
|---|---|---|---|---|---|---|---|---|---|
| | Component (A) | Component (B) | Component (C) | | | Component (D) | | Component (E) | |
| Photosensitive Resin Composition 18 | A-7 (100 Parts By Weight) | B-1 (2 Parts By Weight) | CL-1 (5 Parts By Weight) | CL-2 (10 Parts By Weight) | CL-3 (15 Parts By Weight) | D- 7 (0.6 Parts By Weight) | | PGMEA (96 Parts By Weight) | CyPn (24 Parts By Weight) |
| Comparative Photosensitive Resin Comoosition 1 | A-7 (100 Parts By Weight) | B-1 (2 Parts By Weight) | CL-1 (5 Parts By Weight) | CL-2 (10 Parts By Weight) | CL-3 (15 Parts By Weight) | | Amine-1 (0.5 Parts By Weight) | PGMEA (96 Parts By Weight) | CyPn (24 Parts By Weight) |
| Comparative Photosensitive Resin Comoosition 2 | A-7 (100 Parts By Weight) | B-1 (2 Parts By Weight) | CL-1 (5 Parts By Weight) | CL-2 (10 Parts By Weight) | CL-3 (15 Parts By Weight) | | Amine-2 (0.5 Parts By Weight) | PGMEA (96 Parts By Weight) | CyPn (24 Parts By Weight) |
| Comparative Photosensitive Resin Comoosition 3 | A-7 (100 Parts By Weight) | B-1 (2 Parts By Weight) | CL-1 (5 Parts By Weight) | CL-2 (10 Parts By Weight) | CL-3 (15 Parts By Weight) | | Amine-3 (0.5 Parts By Weight) | PGMEA (96 Parts By Weight) | CyPn (24 Parts By Weight) |

The details of the acid generator (B-1), the crosslinking agent (CL-1), (CL-2), (CL-3), and (CL-4), the ammonium and sulfonium salts (D-1) to (D-7), the basic compounds (Amine-1), (Amine-2), and (Amine-3) used as comparative photosensitive resin compositions in Table 2 are as follows.

Acid generator (B-1)

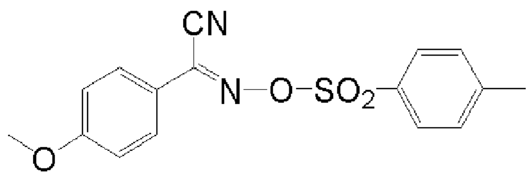

Crosslinking agent (CL-1)

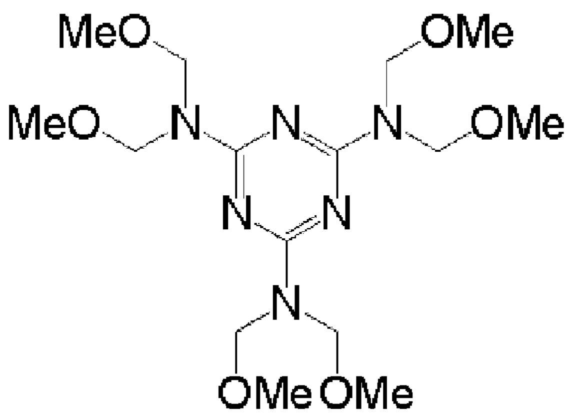

Crosslinking agent (CL-2)

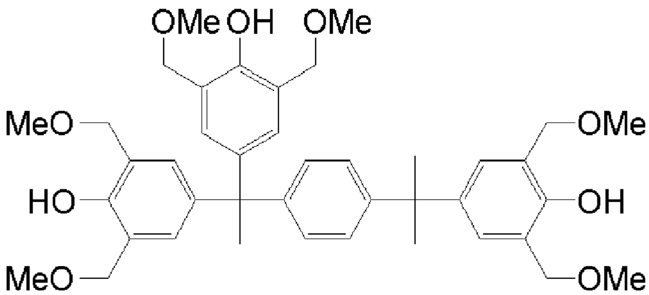

Crosslinking agent (CL-3)

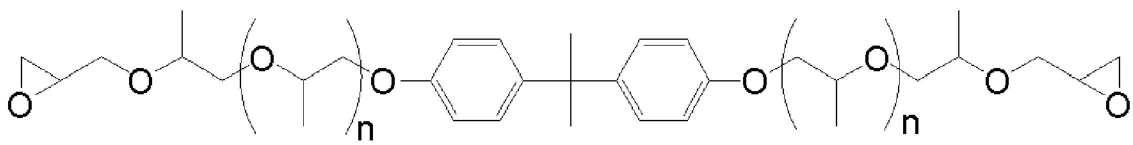

(n=0.9 to 1)

Epoxy resin: EP4000L manufactured by Adeka Corporation

Crosslinking agent (CL-4)

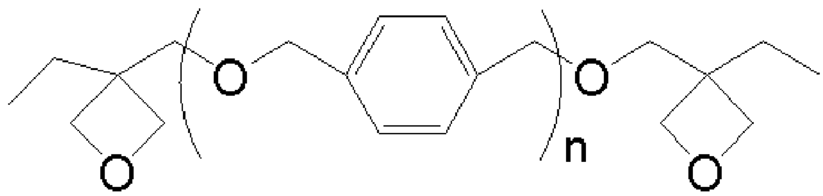

(n=1 to 3) OXT-121 manufactured by Toagosei Co., Ltd.

Onium salt (D-1)

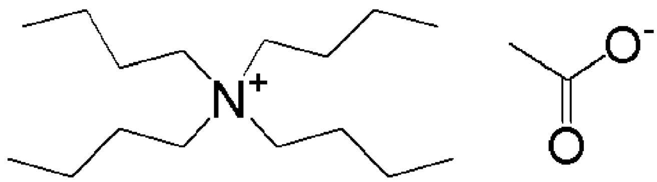

Onium salt (D-2)

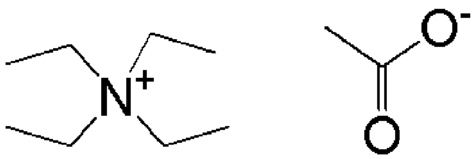

Onium salt (D-3)

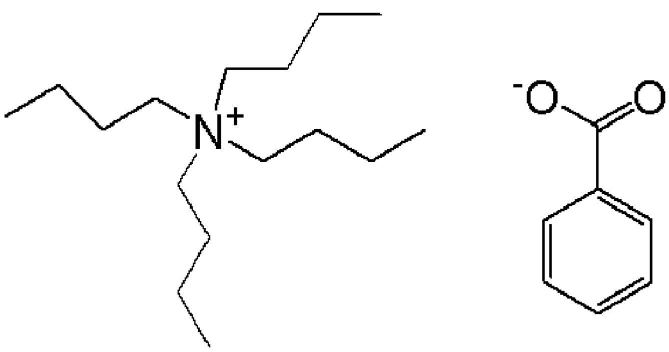

Onium salt (D-4)

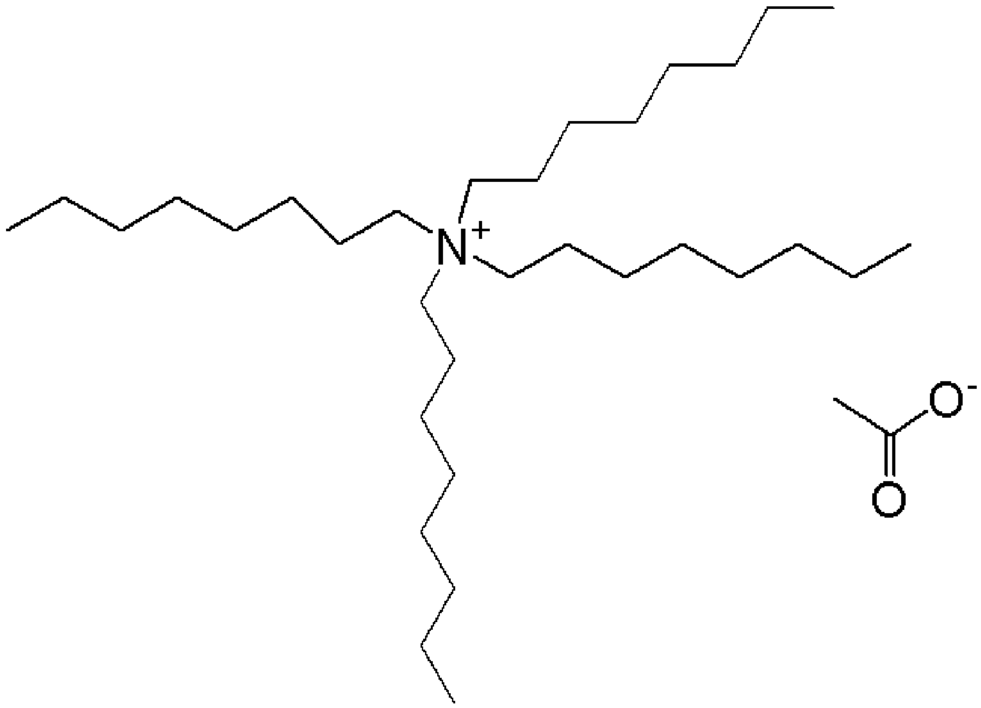

Onium salt (D-5)

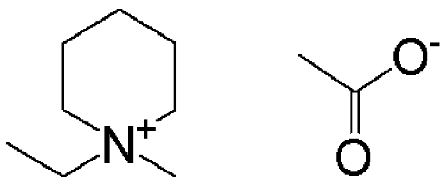

Onium salt (D-6)

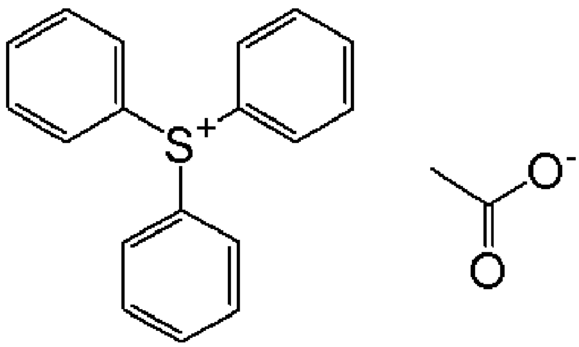

Onium salt (D-7)

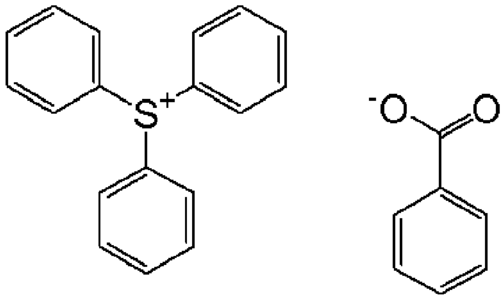

Basic Compound (Amine-1)

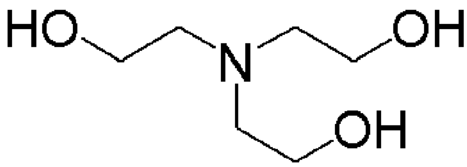

Basic Compound (Amine-2)

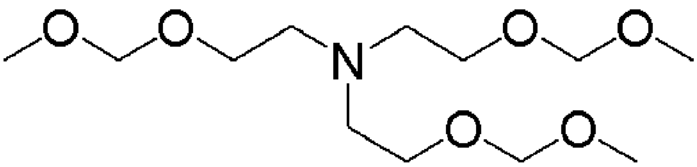

Basic Compound (Amine-3)

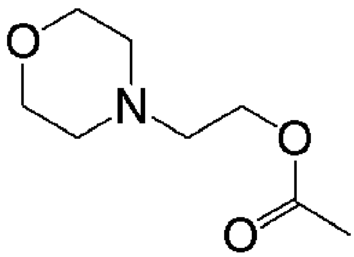

III. Storage Stability

After the photosensitive resin compositions 1-18 and the comparative photosensitive resin compositions 1-3 were stirred, mixed, and dissolved as described above, precision filtering through a Teflon (registered trademark) filter with a pore size of 0.5 um was performed; then, immediately after that, 5 mL of the mixture was dispensed onto a silicon wafer, followed by rotation, i.e., spin coating of the wafer to form a film. Subsequently, prebaking was performed on a hotplate at 100°C for 2 minutes. The rotation number was adjusted so that the film thickness after prebaking was 6 um.

The film thickness was measured and this thickness was used as the initial film thickness.

The filtered solutions of the photosensitive resin compositions 1-18 and the comparative photosensitive resin compositions 1-3 were stored at room temperature for 3 weeks, and films were formed at the same rotation number as above so that the film thickness after prebaking was 6 um. Subsequently, prebaking was performed on a hotplate at 100°C for 2 minutes. The film thicknesses after the solutions were stored for 3 weeks were measured and the amount of change was evaluated using the following formula. The results are summarized in Table 4 below.

$$\text{Amount of change (\%)} = \frac{\text{film thickness after 3 weeks} - \text{initial film thickness}}{\text{Initial film thickness}} \times 100$$

IV. Patterning

5 mL each of the photosensitive resin compositions 1-18 and the comparative photosensitive resin compositions 1-3 were applied by dispensing onto a silicon wafer, followed by rotation, i.e., spin coating, so that the film thickness was 6 um after heating for post-curing, which is performed after the patterning. Specifically, considering the expected decrease in film thickness after the post-curing step, the rotation number during the application was adjusted so that the finished film thickness after the post-curing was 5 μm.

Subsequently, prebaking was performed on a hotplate at 100°C for 2 minutes. Next, exposure to i-line and patterning were performed using an AP-300E i-line exposure machine manufactured by Veeco Japan. In the patterning, negative pattern masks were used. Each of the mask has a pattern enabling formation of holes in a 1:1 vertical and horizontal array, with 10-pm increments from 50 um to 20 um, 5-um increments from 20 um to 10 um, and 1-um increments from 10 um to 1 um for hole pattern formation.

In the development step, an aqueous alkaline solution was used as the developer, and a 2.38% aqueous tetramethyl ammonium hydroxide solution was used as the developer. A 1-minute puddle development with the 2.38% aqueous tetramethyl ammonium hydroxide (TMAH) solution was performed for appropriate number of times as shown in Table 4, followed by rinsing with ultrapure water.

Then, the obtained pattern on the wafer was post-cured in an oven at 180°C for 2 hours while the oven was purged with nitrogen.

To observe the shape of the resulting hole pattern, each substrate was sectioned, and the hole pattern shape was observed using a scanning electron microscope (SEM). The pattern shape was evaluated by determining the diameter of the smallest aperture hole at a film thickness of 5 um after the post-curing. Together with these results, Table 4 shows the sensitivity with which the minimum pattern was formed.

The hole pattern shapes were evaluated using the following criteria, and the evaluation results are shown in Table 4.

Good: rectangular or forward-tapered (the top dimension of the hole is larger than the bottom dimension) holes were observed.
Defective: inverse-tapered (the top dimension of the hole is smaller than the bottom dimension) holes, overhang-shaped (a shape with the top of the hole protruding) holes, significant film loss, or residues at the bottom of the hole were observed.

V. Breaking Elongation, Breaking Strength

Each of the photosensitive resin compositions 1-18 and the comparative photosensitive resin compositions 1-3 was spin-coated onto an aluminum substrate so that the finished film thickness was 10 um after curing. Next, the coated substrate was pre-baked on a hotplate at 110°C for 4 minutes to obtain a photosensitive resin film.

Thereafter, the obtained photosensitive resin film was cured at 200°C for 2 hours using an oven while the oven was purged with nitrogen to obtain a photosensitive resin cured film. Next, the wafer with the cured film was broken into strips each having a width of 10 mm and a length of 60 mm, and the cured film was peeled off from the substrate by immersing it in 20 mass% hydrochloric acid. The breaking elongation and the breaking strength of the obtained cured films were measured using Autograph AGX-1KN (manufactured by Shimadzu Corporation). The measurements were performed ten times for each sample. Table 4 shows the average values. A large breaking elongation is preferable; specifically, a breaking elongation of 20% or more is more preferable. A large breaking strength is preferable; specifically,

a breaking strength of 100 MPa or more is more preferable.

[Table 4]

| | | Amount of Change in Storage Stability (%) | Hole Shape | Minimum Hole Dimension (um) | Sensitivity (mJ/cm2) | Breaking Strength (Mpa) | Breaking Elongation (%) |
|---|---|---|---|---|---|---|---|
| Example 1 | Photosensitive Resin Composition 1 | 0.3 | Good | 5.0 | 900 | 111 | 30 |
| Example 2 | Photosensitive Resin Composition 2 | 0.5 | Good | 5.0 | 850 | 113 | 32 |
| Example 3 | Photosensitive Resin Composition 3 | -0.1 | Good | 5.0 | 800 | 110 | 33 |
| Example 4 | Photosensitive Resin Composition 4 | 0. 1 | Good | 5.0 | 900 | 111 | 30 |
| Example 5 | Photosensitive Resin Composition 5 | 0.2 | Good | 5.0 | 900 | 113 | 30 |
| Example 6 | Photosensitive Resin Composition 6 | 0.4 | Good | 5.0 | 850 | 115 | 32 |
| Example 7 | Photosensitive Resin Composition 7 | 0.2 | Good | 4.0 | 800 | 110 | 35 |
| Example 8 | Photosensitive Resin Composition 8 | -0.1 | Good | 5.0 | 800 | 115 | 30 |
| Example 9 | Photosensitive Resin Composition 9 | -0.3 | Good | 5.0 | 850 | 117 | 32 |
| Example 10 | Photosensitive Resin Composition 10 | 0.1 | Good | 5.0 | 750 | 111 | 33 |
| Example 11 | Photosensitive Resin Composition 11 | 0.3 | Good | 5.0 | 800 | 120 | 38 |
| Example 12 | Photosensitive Resin Composition 12 | 0. 8 | Good | 5.0 | 800 | 107 | 30 |
| Example 13 | Photosensitive Resin Composition 13 | 0.9 | Good | 5.0 | 850 | 121 | 38 |
| Example 14 | Photosensitive Resin Composition 14 | -0.2 | Good | 5.0 | 900 | 120 | 37 |

(continued)

| | | Amount of Change in Storage Stability (%) | Hole Shape | Minimum Hole Dimension (um) | Sensitivity (mJ/cm2) | Breaking Strength (Mpa) | Breaking Elongation (%) |
|---|---|---|---|---|---|---|---|
| Example 15 | Photosensitive Resin Composition 15 | 0 | Good | 5.0 | 800 | 122 | 36 |
| Example 16 | Photosensitive Resin Composition 16 | 0.5 | Good | 5.0 | 900 | 120 | 38 |
| Example 17 | Photosensitive Resin Composition 17 | 0. 1 | Good | 5.0 | 850 | 121 | 38 |
| Example 18 | Photosensitive Resin Composition 18 | 0.2 | Good | 5.0 | 800 | 120 | 35 |
| Comparative Example 1 | Comparative Photosensitive Resin Composition 1 | 10.2 | Good | 5.0 | 900 | 122 | 38 |
| Comparative Example 2 | Comparative Photosensitive Resin Composition 2 | 9.8 | Good | 5.0 | 950 | 123 | 36 |
| Comparative Example 3 | Comparative Photosensitive Resin Composition 3 | 11.0 | Good | 5.0 | 900 | 121 | 36 |

As shown in Table 4, it was found that the negative photosensitive resin composition of the present invention exhibits desirable pattern shapes in alkaline solvent development, and the minimum hole dimension, i.e., the opening, was 5 um or less at a finished film thickness of 5 um, thereby capable of achieving an aspect ratio 1.

The above results revealed that the present invention is comparable to the comparative photosensitive resin compositions in which a basic compound was added to achieve high resolution.

More specifically, by using an onium salt which can improve the resolution performance in the negative photosensitive resin composition of the present invention using a polymer containing a polyamide, polyamideimide, polyimide, polyimide precursor, polybenzoxazole, polybenzoxazole precursor as the base resin, it is possible to ensure resolution performance equivalent to that in the case of using a basic compound; further, by using the onium salt of the present invention, it is also possible to prevent poor storage stability that occurs when the polymer containing a polyamide, polyamideimide, polyimide, polyimide precursor, polybenzoxazole, polybenzoxazole precursor is used as the base resin in a combination with a basic compound.

Further, since the base resin of the negative photosensitive resin composition of the present invention is a polymer containing a polyamide, polyamideimide, polyimide, polyimide precursor, polybenzoxazole, polybenzoxazole precursor, it exhibits desirable mechanical strength and can be suitably used for an interlayer insulating film or a surface protection film.

Furthermore, it was also revealed that the polymer containing a polyamide, polyamideimide, polyimide, polyimide precursor, polybenzoxazole, polybenzoxazole precursor used as the base resin of the negative photosensitive resin composition of the present invention is easily soluble in versatile and safe organic solvents.

The present invention encompasses the following embodiments.

[1]: A negative photosensitive resin composition, comprising:

(A) an alkali-soluble resin including at least one or more structures selected from a polyimide structure, a polyamide structure, a polybenzoxazole structure, a polyamideimide structure, and precursor structures thereof;
(B) a photoacid generator;
(C) one or two or more kinds of crosslinking agent selected from an amino condensate modified with formaldehyde or formaldehyde-alcohol, a phenol compound having on average two or more methylol groups or alkoxymethylol groups within one molecule, a compound in which a hydrogen atom of a hydroxyl group of polyhydric phenol is substituted with a glycidyl group or a group having a glycidyl group, a compound in which a hydrogen atom of a hydroxyl group of polyhydric phenol is substituted with a substituent represented by the following formula (C-1), a compound represented by the following formula (C-15) having a substituent (C-1), and a compound containing two or more nitrogen atoms having a glycidyl group represented by the following formula (C-2);

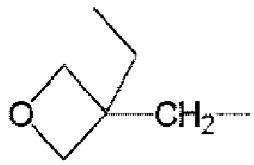 (C-1)

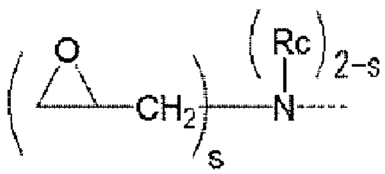 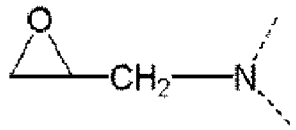 (C-2)

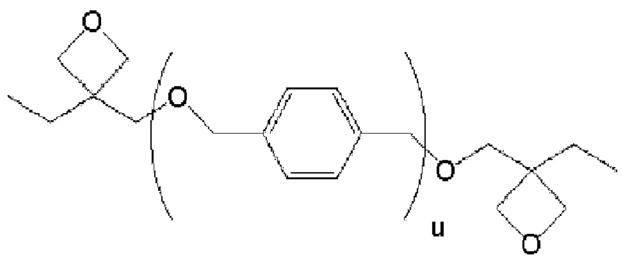 (C-15)

wherein the broken line represents a bond, Rc represents a linear, branched, or cyclic alkyl group having 1 to 6 carbon atoms; s represents 1 or 2; u is a number satisfying $1 \leq u \leq 3$,
(D) an onium salt represented by the following general formula (1); and

$$\left( Q - \right)_m A^{+} \quad E^{-} \qquad (1)$$

wherein A represents iodine, sulfur, phosphorus, or nitrogen; each Q is identical to or different from one another and represents a monovalent hydrocarbon group having 1 to 100 carbon atoms, which may be linked, substituted, or intervened by a heteroatom; $E^-$ represents an anion of an organic or inorganic acid salt; and m represents 2 when A is iodine, m represents 3 when A is sulfur, and m represents 4 when A is phosphorus or nitrogen,
(E) a solvent.

[2]: The negative photosensitive resin composition of the [1], wherein the component (D) is a quaternary ammonium salt represented by the following general formula (1-1), in which A in the general formula (1) is nitrogen,

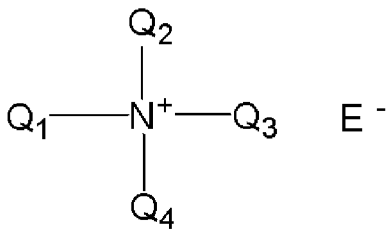

(1－1)

wherein each of $Q_1$, $Q_2$, $Q_3$, and $Q_4$ is identical to or different from one another and represents a monovalent hydrocarbon group having 1 to 100 carbon atoms, which may be linked, substituted, or intervened by a heteroatom; and $E^-$ represents an anion of an organic or inorganic acid salt as defined above.

[3]: The negative photosensitive resin composition of the [1] or [2], wherein, in the component (D), $E^-$ in the general formula (1) is an anion of an organic carboxylic acid represented by the following general formula (6),

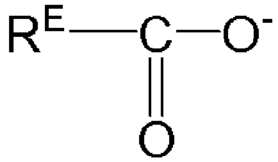

(6)

wherein $R^E$ represents a hydrocarbon group having 1 to 100 carbon atoms, which may be substituted with a heteroatom or intervened by a heteroatom.

[4]: The negative photosensitive resin composition of the [1], [2], or [3], wherein the component (A) is an alkali-soluble resin, comprising at least one or more structures selected from a polyimide structure, a polyamide structure, a polybenzoxazole structure, a polyamideimide structure, and precursor structures thereof, each of which is a reaction product of a diamine comprising one or more of a diamine represented by the following general formula (2) and a diamine represented by the following general formula (3), and one or more of a tetracarboxylic acid dianhydride represented by the following general formula (4) and a dicarboxylic acid or dicarboxylic acid halide represented by the following general formula (5),

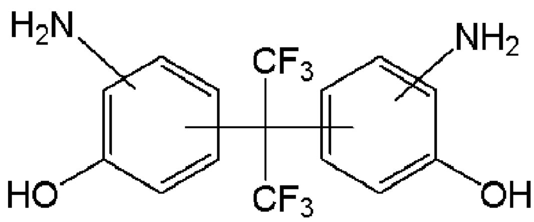

(2)

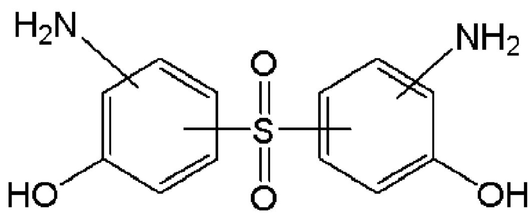

(3)

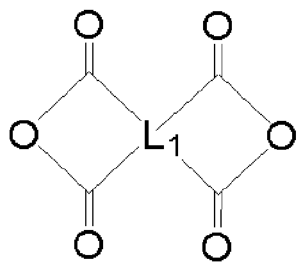

(4)

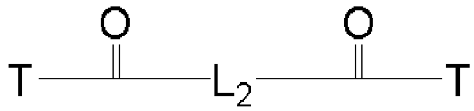

(5)

wherein $L_1$ represents a tetravalent hydrocarbon group having 1 to 100 carbon atoms, which may be substituted with a heteroatom or intervened by a heteroatom, wherein $L_2$ represents a divalent hydrocarbon group having 1 to 100 carbon atoms, which may be substituted with a heteroatom or intervened by a heteroatom, T represents any of a hydroxy group, a fluorine atom, a chlorine atom, a bromine atom, an iodine atom, $-OCO_2R^T$, $-OSO_2R^T$, and $-OSO_3R^T$, provided that $R^T$ represents a monovalent hydrocarbon group having 1 to 10 carbon atoms, which may be substituted with a heteroatom or intervened by a heteroatom.

[5]: The negative photosensitive resin composition of the [1], [2], [3], or [4], wherein, in the component (B), an acid generated by a photoacid generator is an organic sulfonic acid represented by the following general formula (7),

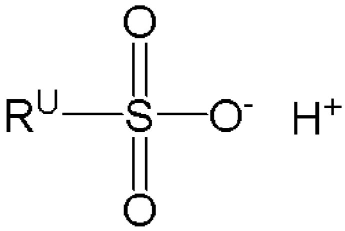

(7)

wherein $R^U$ represents a hydrocarbon group having 1 to 100 carbon atoms, which may be substituted with a heteroatom or intervened by a heteroatom.

[6]: The negative photosensitive resin composition of the [1], [2], [3], [4], or [5], wherein the component (A) is an alkali-soluble resin, comprising at least one or more structures selected from a polyimide structure, a polyamide structure, a polybenzoxazole structure, a polyamideimide structure, and precursor structures thereof, each of which is a reaction product of one or more of a tetracarboxylic acid dianhydride represented by the following general formula (8) and a dicarboxylic acid or dicarboxylic acid halide represented by the following general formula (9),

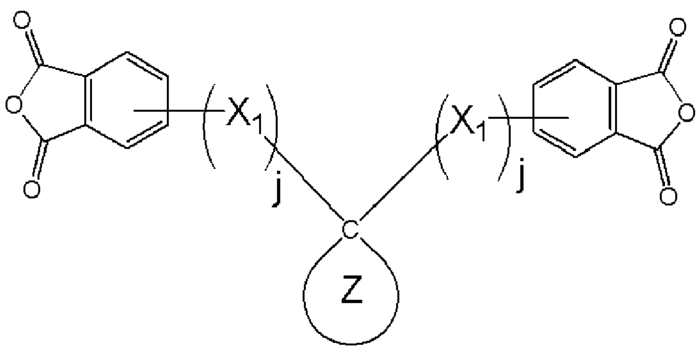

(8)

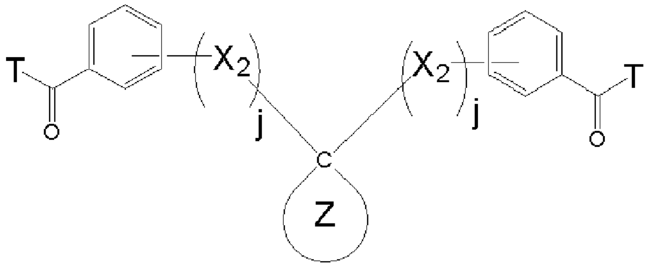

(9)

wherein Z represents an alicyclic structure, an alicyclic structure connected to an aromatic ring, a heteroatom-containing or heteroatom-intervened alicyclic structure, or a heteroatom-containing or heteroatom-intervened alicyclic structure connected to an aromatic ring, each of which has 3 to 20 carbon atoms, T represents any of a hydroxy group, a fluorine atom, a chlorine atom, a bromine atom, an iodine atom, $-OCO_2R^T$, $-OSO_2R^T$, and $-OSO_3R^T$; j

represents 0 or 1; when j is 0, the phthalic anhydride structure and the cyclic structure Z in the general formula (8) and the benzoic acid structure and the cyclic structure Z in the general formula (9) are directly bonded; and when j is 1, $X_1$ and $X_2$ represent a divalent linkage group.

[7]: The negative photosensitive resin composition of the [6], wherein the alicyclic structure Z in the general formulae (8) and (9) is a structure represented by the following general formula (10) or (11),

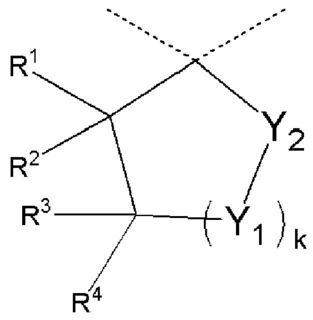
(1 0)

wherein the broken line represents a bond; and k represents 0 or an integer of 1 or more, when k = 0, $Y_2$ represents a divalent group selected from any of the following general formulae (13), (14), (15), and (16),

when k = 1, $Y_1$ represents a divalent group selected from any of the following general formulae (17), (18), and (19), and $Y_2$ represents a divalent group selected from any of the following general formulae (13), (14), (15), and (16), when k is 2 or more, $Y_1$ represents the following general formula (17), and $Y_2$ represents a divalent group selected from any of the following general formulae (13), (14), (15), and (16),

$R^1$, $R^2$, $R^3$, and $R^4$, and $R^5$ and $R^6$ in the following formula (16) represent identical or different substituents, each representing a hydrogen atom, a methyl group, an ethyl group, a linear, branched, or cyclic alkyl group having 3 to 12 carbon atoms; or $R^1$, $R^2$, $R^3$, $R^4$, $R^5$ and $R^6$ are bonded together to form an alicyclic or aromatic ring,

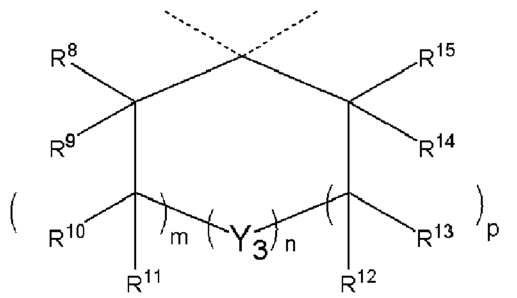
(1 1)

wherein the broken line represents a bond, and $R^8$, $R^9$, $R^{10}$, $R^{11}$, $R^{12}$, $R^{13}$, $R^{14}$, and $R^{15}$ represent identical or different substituents, each representing a hydrogen atom, a methyl group, an ethyl group, a linear, branched, or cyclic alkyl group having 3 to 12 carbon atoms,

m and p represent 0 or an integer of 1 to 9; and n represents 0 or 1,

$Y_3$ represents a divalent group selected from any of the following general formulae (12), (13), (14), (15), (16), (17), (18) and (19),

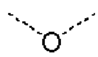
(1 2)
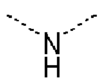
(1 3)
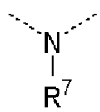
(1 4)
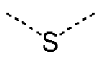
(1 5)

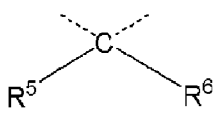
(1 6)
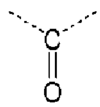
(1 7)
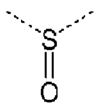
(1 8)
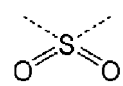
(1 9)

wherein the broken line represents a bond; and $R^5$ and $R^6$ are as defined above, $R^7$ represents a methyl group,

an ethyl group, a linear, branched, or cyclic alkyl group having 3 to 12 carbon atoms.

[8]: The negative photosensitive resin composition of the [6] or [7], wherein divalent linkage groups $X_1$ and $X_2$ in the general formulae (8) and (9) have a structure represented by any of the following general formulae (20), (21), (22), (23), (24), and (25),

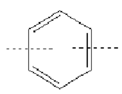 (20) 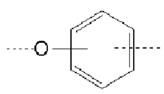 (21) 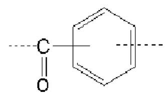 (22)

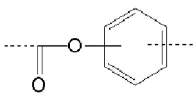 (23) 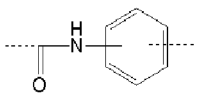 (24) 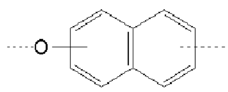 (25)

wherein the broken line represents a bond.

[9]: The negative photosensitive resin composition of the [4], [5], [6], [7], or [8], wherein the diamine represented by the general formula (2) is a diamine represented by the following general formula (26).

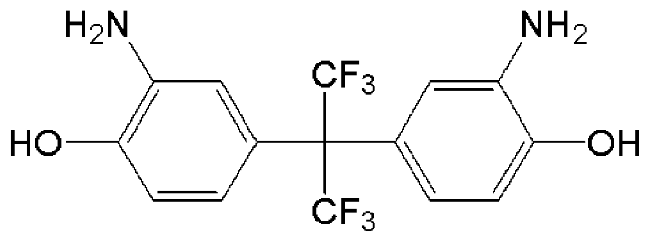 (26)

[10]: The negative photosensitive resin composition of the [1], [2], [3], [4], [5], [6], [7], [8], or [9], wherein the component (A) is an alkali-soluble resin, comprising at least one or more structures selected from a polyimide structure, a polyamide structure, a polybenzoxazole structure, a polyamideimide structure, and precursor structures thereof, each of which is a reaction product further comprising a tetracarboxylic acid diester compound represented by the following general formula (27),

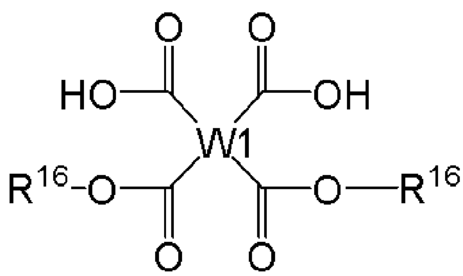 (27)

wherein W1 is a tetravalent organic group; and $R^{16}$ is represented by the following general formula (28),

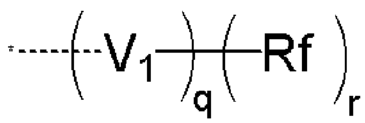 (28)

wherein the broken line represents a bond; $V_1$ represents a (r+1)-valent organic group; Rf represents a linear, branched or cyclic alkyl group or an aromatic group having 1 to 20 carbon atoms in which a part or all of the hydrogen atoms are substituted with a fluorine atom; r represents 1, 2 or 3; and q represents 0 or 1.

[11]: The negative photosensitive resin composition of the [10], wherein $R^{16}$ in the general formula (27) is an organic group selected from any of groups represented by the following general formulae (29), (30), (31), and (32),

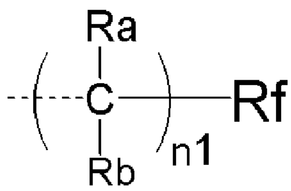

(2 9)

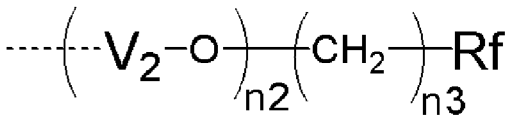

(3 0)

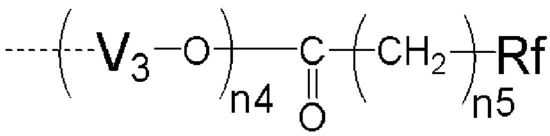

(3 1)

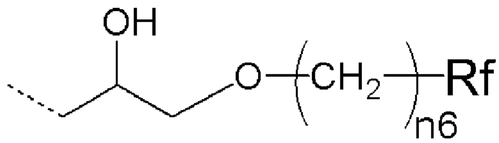

(3 2)

wherein the broken line represents a bond; and Rf is as defined above; each of Ra and Rb is a hydrogen atom or an alkyl group having 1 to 3 carbon atoms; each of $V_2$ and $V_3$ is a linear or branched alkylene group having 1 to 6 carbon atoms; n1 is an integer of 0 to 6; n2 is an integer of 1 to 6; n3 is an integer of 0 to 6; n4 is an integer of 1 to 6; n5 is an integer of 0 to 6; and n6 is 0 or 1.

[12]: The negative photosensitive resin composition of the [10], wherein $R^{16}$ in the general formula (27) is a group represented by the following general formula (28-1),

*--------$CH_2$-$CH_2$-Rf (28-1)

wherein the broken line represents a bond; and Rf is as defined above.

[13]: The negative photosensitive resin composition of the [6], [7], [8], [9], [10], [11], or [12], wherein the component (A) is an alkali-soluble resin, comprising at least one or more structures selected from a polyimide structure, a polyamide structure, a polybenzoxazole structure, a polyamideimide structure, and precursor structures thereof, each of which is a reaction product of one or more of a tetracarboxylic acid dianhydride in which the alicyclic structure Z of the general formula (8) is represented by the following general formula (33) or (34) and/or a dicarboxylic acid or dicarboxylic acid halide in which the alicyclic structure Z of the general formula (9) is selected from any of structures represented by the following general formulae (35), (36), (37), (38), (39), and (40),

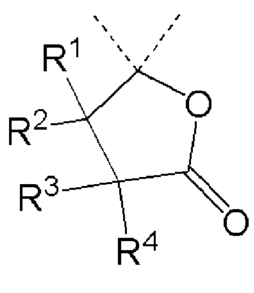

(3 3)

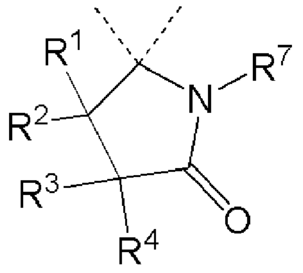

(3 4)

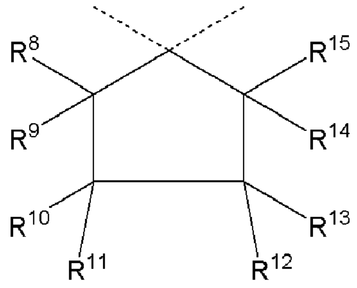

(3 5)

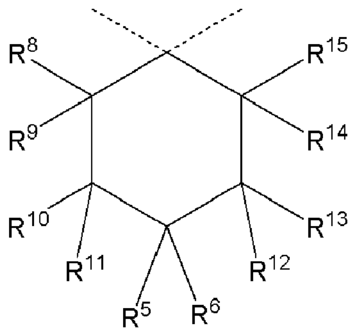

(3 6)

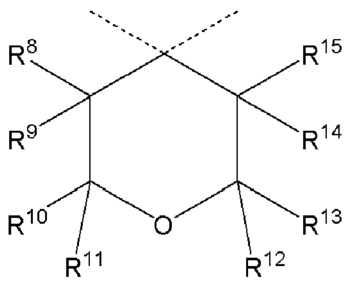

(3 7)

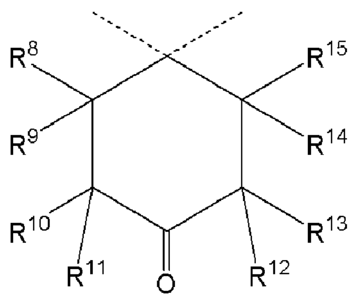

(3 8)

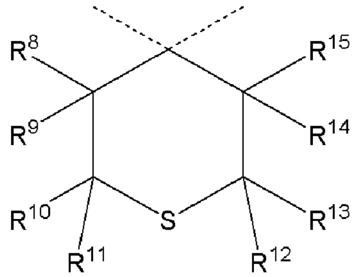

(39)

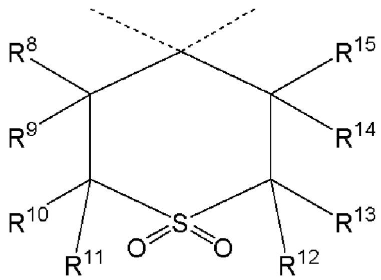

(40)

wherein the broken line represents a bond; $R^1$, $R^2$, $R^3$, $R^4$, $R^5$ and $R^6$ represent identical or different substituents, each representing a hydrogen atom, a methyl group, an ethyl group, a linear, branched, or cyclic alkyl group having 3 to 12 carbon atoms; or $R^1$, $R^2$, $R^3$, $R^4$, $R^5$ and $R^6$ are bonded together to form an alicyclic or aromatic ring, $R^7$ represents a methyl group, an ethyl group, a linear, branched, or cyclic alkyl group having 3 to 12 carbon atoms, wherein $R^8$, $R^9$, $R^{10}$, $R^{11}$, $R^{12}$, $R^{13}$, $R^{14}$, and $R^{15}$ represent identical or different substituents, each representing a hydrogen atom, a methyl group, an ethyl group, a linear, branched, or cyclic alkyl group having 3 to 12 carbon atoms.
[14]: A patterning process, comprising the steps of:

(1) applying the negative photosensitive resin composition of the [1], [2], [3], [4], [5], [6], [7], [8], [9], [10], [11], [12], or [13] onto a substrate to form a photosensitive material film;
(2) after heating the photosensitive material film, exposing the photosensitive material film to a high-energy beam having a wavelength of 190 to 500 nm or an electron beam through a photomask; and
(3) developing the exposed photosensitive material film using an aqueous alkaline solution as a developer.

[15]: The patterning process of the [14], further comprising the step of:
(4) post-curing the developed photosensitive material film by heating at a temperature of 100 to 300°C.
[16]: An interlayer insulating film, comprising a cured product of the negative photosensitive resin composition of the [1], [2], [3], [4], [5], [6], [7], [8], [9], [10], [11], [12], or [13].
[17]: A surface protection film, comprising a cured product of the negative photosensitive resin composition of the [1], [2], [3], [4], [5], [6], [7], [8], [9], [10], [11], [12], or [13].
[18]: An electronic component, comprising the interlayer insulating film of the [16].
[19]: An electronic component, comprising the surface protection film of the [17].

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

**1.** A negative photosensitive resin composition, comprising:

(A) an alkali-soluble resin including at least one or more structures selected from a polyimide structure, a polyamide structure, a polybenzoxazole structure, a polyamideimide structure, and precursor structures thereof;
(B) a photoacid generator;
(C) one or two or more kinds of crosslinking agent selected from an amino condensate modified with formaldehyde or formaldehyde-alcohol, a phenol compound having on average two or more methylol groups or

alkoxymethylol groups within one molecule, a compound in which a hydrogen atom of a hydroxyl group of polyhydric phenol is substituted with a glycidyl group or a group having a glycidyl group, a compound in which a hydrogen atom of a hydroxyl group of polyhydric phenol is substituted with a substituent represented by the following formula (C-1), a compound represented by the following formula (C-15) having a substituent (C-1), and a compound containing two or more nitrogen atoms having a glycidyl group represented by the following formula (C-2);

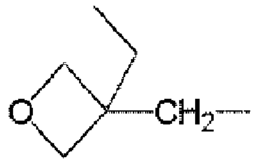

(C-1)

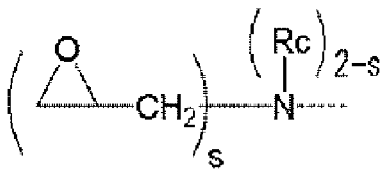

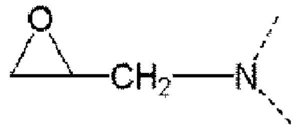

(C-2)

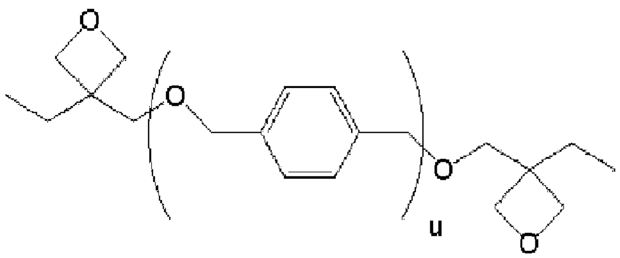

(C-15)

wherein the broken line represents a bond, Rc represents a linear, branched, or cyclic alkyl group having 1 to 6 carbon atoms; s represents 1 or 2; u is a number satisfying $1 \leq u \leq 3$,
(D) an onium salt represented by the following general formula (1); and

$$\left( Q \right)_m A^+ \quad E^- \qquad (1)$$

wherein A represents iodine, sulfur, phosphorus, or nitrogen; each Q is identical to or different from one another and represents a monovalent hydrocarbon group having 1 to 100 carbon atoms, which may be linked, substituted, or intervened by a heteroatom; E- represents an anion of an organic or inorganic acid salt; and m represents 2 when A is iodine, m represents 3 when A is sulfur, and m represents 4 when A is phosphorus or nitrogen,
(E) a solvent.

**2.** The negative photosensitive resin composition according to claim 1, wherein the component (D) is a quaternary ammonium salt represented by the following general formula (1-1), in which A in the general formula (1) is nitrogen,

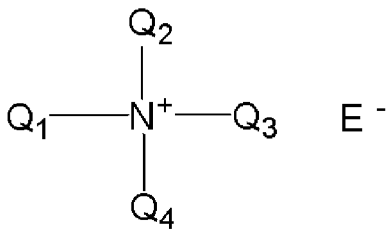

(1 − 1)

wherein each of $Q_1$, $Q_2$, $Q_3$, and $Q_4$ is identical to or different from one another and represents a monovalent hydrocarbon group having 1 to 100 carbon atoms, which may be linked, substituted, or intervened by a heteroatom; and $E^-$ represents an anion of an organic or inorganic acid salt as defined above.

**3.** The negative photosensitive resin composition according to claim 1, wherein, in the component (D), $E^-$ in the general formula (1) is an anion of an organic carboxylic acid represented by the following general formula (6),

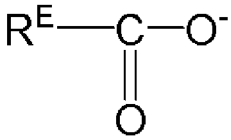

(6)

wherein $R^E$ represents a hydrocarbon group having 1 to 100 carbon atoms, which may be substituted with a heteroatom or intervened by a heteroatom.

**4.** The negative photosensitive resin composition according to claim 1, wherein the component (A) is an alkali-soluble resin, comprising at least one or more structures selected from a polyimide structure, a polyamide structure, a polybenzoxazole structure, a polyamideimide structure, and precursor structures thereof, each of which is a reaction product of a diamine comprising one or more of a diamine represented by the following general formula (2) and a diamine represented by the following general formula (3), and one or more of a tetracarboxylic acid dianhydride represented by the following general formula (4) and a dicarboxylic acid or dicarboxylic acid halide represented by the following general formula (5),

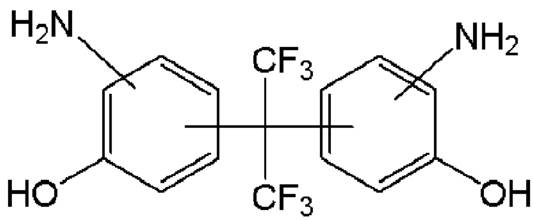

(2)

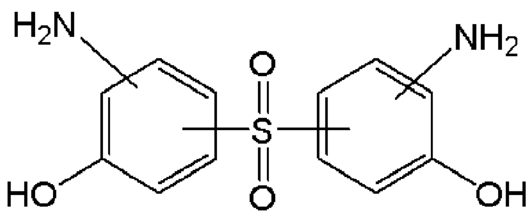

(3)

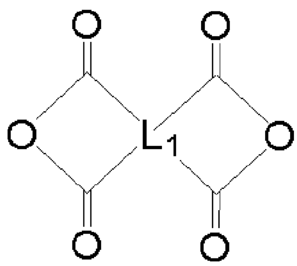

(4)

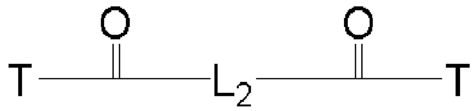

(5)

wherein $L_1$ represents a tetravalent hydrocarbon group having 1 to 100 carbon atoms, which may be substituted with a heteroatom or intervened by a heteroatom, wherein $L_2$ represents a divalent hydrocarbon group having 1 to 100 carbon atoms, which may be substituted with a heteroatom or intervened by a heteroatom, T represents any of a hydroxy group, a fluorine atom, a chlorine atom, a bromine atom, an iodine atom, $-OCO_2R^T$, $-OSO_2R^T$, and $-OSO_3R^7$, provided that $R^T$ represents a monovalent hydrocarbon group having 1 to 10 carbon atoms, which may be substituted with a heteroatom or intervened by a heteroatom.

**5.** The negative photosensitive resin composition according to claim 1, wherein, in the component (B), an acid generated by a photoacid generator is an organic sulfonic acid represented by the following general formula (7),

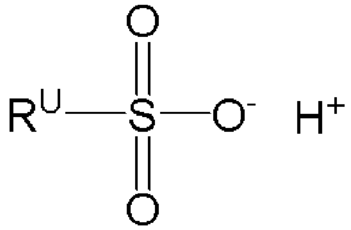

(7)

wherein $R^U$ represents a hydrocarbon group having 1 to 100 carbon atoms, which may be substituted with a heteroatom or intervened by a heteroatom.

**6.** The negative photosensitive resin composition according to claim 1, wherein the component (A) is an alkali-soluble resin, comprising at least one or more structures selected from a polyimide structure, a polyamide structure, a polybenzoxazole structure, a polyamideimide structure, and precursor structures thereof, each of which is a reaction product of one or more of a tetracarboxylic acid dianhydride represented by the following general formula (8) and a dicarboxylic acid or dicarboxylic acid halide represented by the following general formula (9),

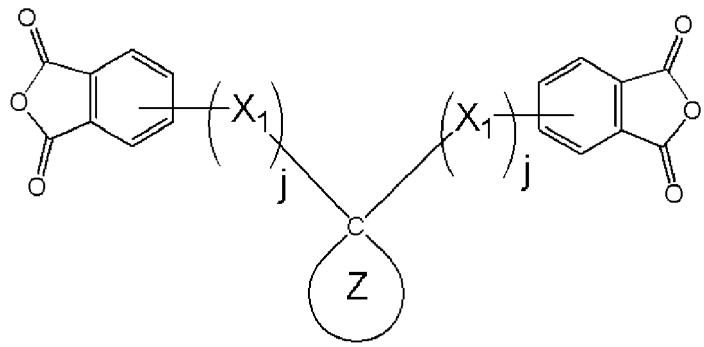

(8)

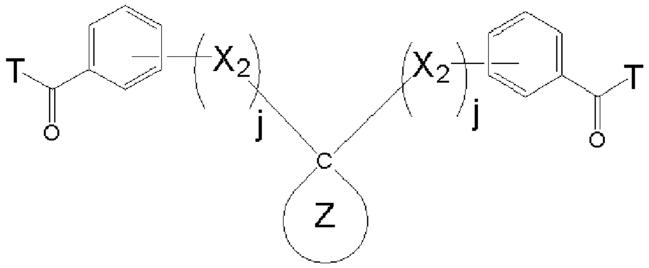

(9)

wherein Z represents an alicyclic structure, an alicyclic structure connected to an aromatic ring, a heteroatom-containing or heteroatom-intervened alicyclic structure, or a heteroatom-containing or heteroatom-intervened alicyclic structure connected to an aromatic ring, each of which has 3 to 20 carbon atoms, T represents any of a hydroxy group, a fluorine atom, a chlorine atom, a bromine atom, an iodine atom, $-OCO_2R^T$, $-OSO_2R^T$, and $-OSO_3R^T$; j represents 0 or 1; when j is 0, the phthalic anhydride structure and the cyclic structure Z in the general formula (8) and the benzoic acid structure and the cyclic structure Z in the general formula (9) are directly bonded; and when j is 1, $X_1$ and $X_2$ represent a divalent linkage group.

**7.** The negative photosensitive resin composition according to claim 6, wherein the alicyclic structure Z in the general formulae (8) and (9) is a structure represented by the following general formula (10) or (11),

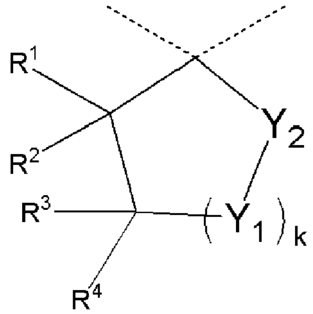

(10)

wherein the broken line represents a bond; and k represents 0 or an integer of 1 or more,

when k = 0, $Y_2$ represents a divalent group selected from any of the following general formulae (13), (14), (15), and (16),
when k = 1, $Y_1$ represents a divalent group selected from any of the following general formulae (17), (18), and (19), and $Y_2$ represents a divalent group selected from any of the following general formulae (13), (14), (15), and (16),
when k is 2 or more, $Y_1$ represents the following general formula (17), and $Y_2$ represents a divalent group selected from any of the following general formulae (13), (14), (15), and (16),
$R^1$, $R^2$, $R^3$, and $R^4$, and $R^5$ and $R^6$ in the following formula (16) represent identical or different substituents, each representing a hydrogen atom, a methyl group, an ethyl group, a linear, branched, or cyclic alkyl group having 3 to 12 carbon atoms; or $R^1$, $R^2$, $R^3$, $R^4$, $R^5$ and $R^6$ are bonded together to form an alicyclic or aromatic ring,

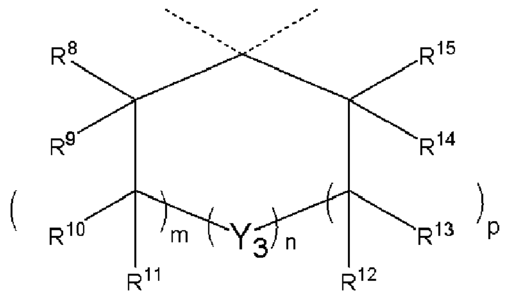

(11)

wherein the broken line represents a bond, and $R^8$, $R^9$, $R^{10}$, $R^{11}$, $R^{12}$, $R^{13}$, $R^{14}$, and $R^{15}$ represent identical or different substituents, each representing a hydrogen atom, a methyl group, an ethyl group, a linear, branched, or cyclic alkyl group having 3 to 12 carbon atoms,
m and p represent 0 or an integer of 1 to 9; and n represents 0 or 1,
$Y_3$ represents a divalent group selected from any of the following general formulae (12), (13), (14), (15), (16), (17), (18) and (19),

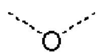 (12) 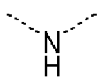 (13) 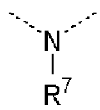 (14) 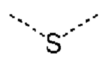 (15)

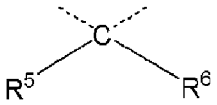 (16) 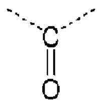 (17) 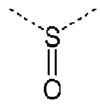 (18) 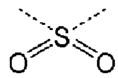 (19)

wherein the broken line represents a bond; and $R^5$ and $R^6$ are as defined above, $R^7$ represents a methyl group, an ethyl group, a linear, branched, or cyclic alkyl group having 3 to 12 carbon atoms.

**8.** The negative photosensitive resin composition according to claim 6, wherein divalent linkage groups $X_1$ and $X_2$ in the general formulae (8) and (9) have a structure represented by any of the following general formulae (20), (21), (22), (23), (24), and (25),

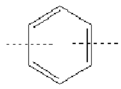 (20) 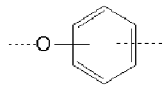 (21) 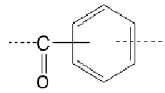 (22)

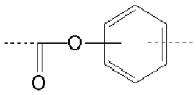 (23) 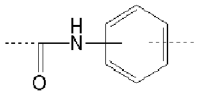 (24) 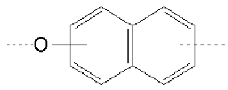 (25)

wherein the broken line represents a bond.

**9.** The negative photosensitive resin composition according to claim 4, wherein the diamine represented by the general formula (2) is a diamine represented by the following general formula (26).

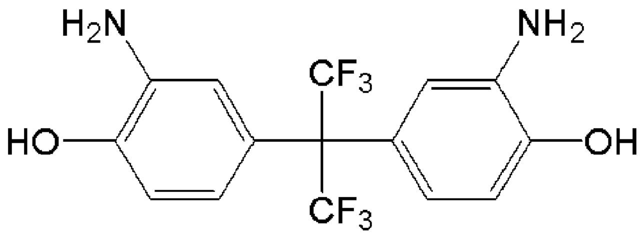 (26)

**10.** The negative photosensitive resin composition according to claim 1, wherein the component (A) is an alkali-soluble resin, comprising at least one or more structures selected from a polyimide structure, a polyamide structure, a polybenzoxazole structure, a polyamideimide structure, and precursor structures thereof, each of which is a reaction product further comprising a tetracarboxylic acid diester compound represented by the following general formula (27),

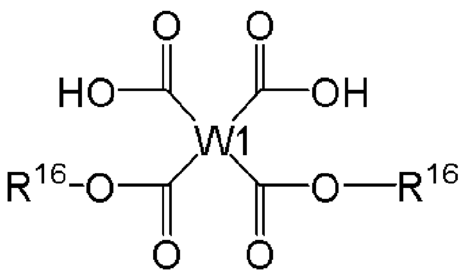 (27)

wherein W1 is a tetravalent organic group; and $R^{16}$ is represented by the following general formula (28),

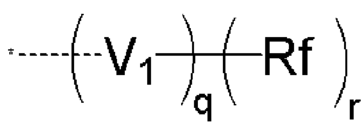 (28)

wherein the broken line represents a bond; $V_1$ represents a (r+1)-valent organic group; Rf represents a linear, branched or cyclic alkyl group or an aromatic group having 1 to 20 carbon atoms in which a part or all of the hydrogen atoms are substituted with a fluorine atom; r represents 1, 2 or 3; and q represents 0 or 1.

**11.** The negative photosensitive resin composition according to claim 10,
wherein $R^{16}$ in the general formula (27) is an organic group selected from any of groups represented by the following general formulae (29), (30), (31), and (32),

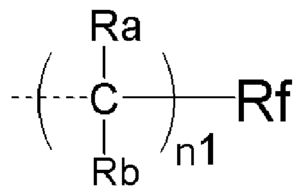

(2 9)

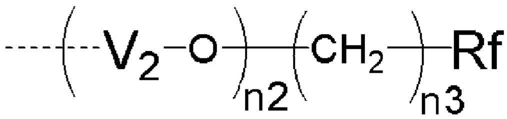

(3 0)

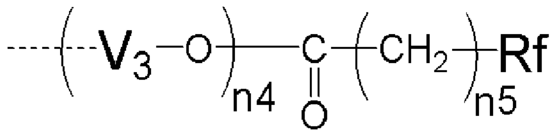

(3 1)

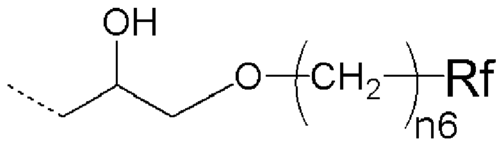

(3 2)

wherein the broken line represents a bond; and Rf is as defined above; each of Ra and Rb is a hydrogen atom or an alkyl group having 1 to 3 carbon atoms; each of $V_2$ and $V_3$ is a linear or branched alkylene group having 1 to 6 carbon atoms; n1 is an integer of 0 to 6; n2 is an integer of 1 to 6; n3 is an integer of 0 to 6; n4 is an integer of 1 to 6; n5 is an integer of 0 to 6; and n6 is 0 or 1, or
wherein $R^{16}$ in the general formula (27) is a group represented by the following general formula (28-1),

$$*\text{--------}CH_2\text{-}CH_2\text{-}Rf \qquad (28 - 1)$$

wherein the broken line represents a bond; and Rf is as defined above.

**12.** The negative photosensitive resin composition according to claim 6, wherein the component (A) is an alkali-soluble resin, comprising at least one or more structures selected from a polyimide structure, a polyamide structure, a polybenzoxazole structure, a polyamideimide structure, and precursor structures thereof, each of which is a reaction product of one or more of a tetracarboxylic acid dianhydride in which the alicyclic structure Z of the general formula (8) is represented by the following general formula (33) or (34) and/or a dicarboxylic acid or dicarboxylic acid halide in which the alicyclic structure Z of the general formula (9) is selected from any of structures represented by the following general formulae (35), (36), (37), (38), (39), and (40),

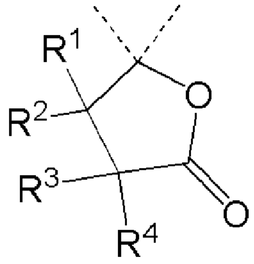

（３３）

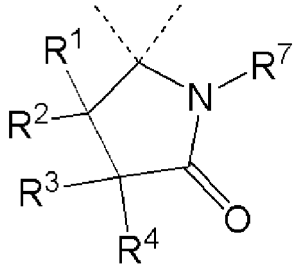

（３４）

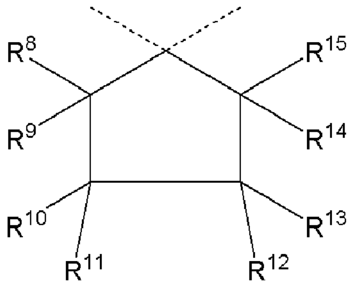

（３５）

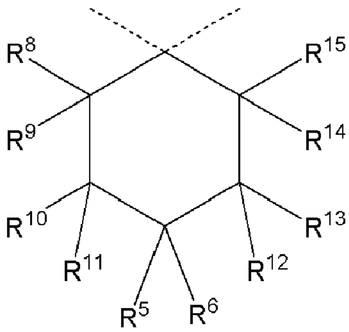

（３６）

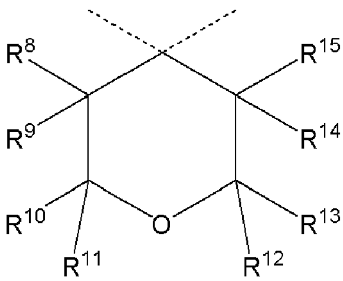

（３７）

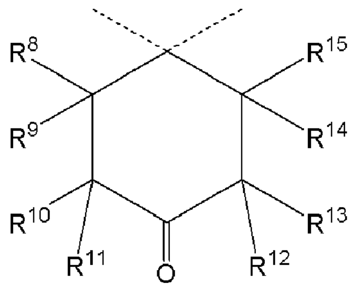

(38)

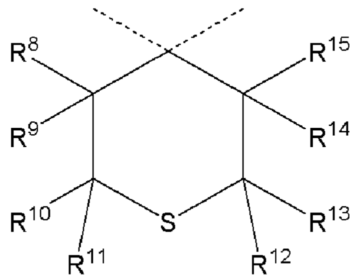

(39)

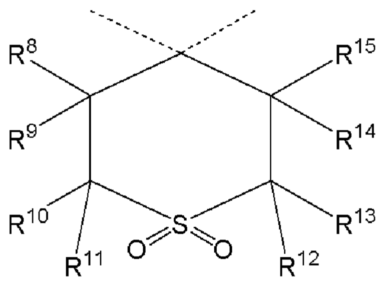

(40)

wherein the broken line represents a bond; $R^1$, $R^2$, $R^3$, $R^4$, $R^5$ and $R^6$ represent identical or different substituents, each representing a hydrogen atom, a methyl group, an ethyl group, a linear, branched, or cyclic alkyl group having 3 to 12 carbon atoms; or $R^1$, $R^2$, $R^3$, $R^4$, $R^5$ and $R^6$ are bonded together to form an alicyclic or aromatic ring, $R^7$ represents a methyl group, an ethyl group, a linear, branched, or cyclic alkyl group having 3 to 12 carbon atoms, wherein $R^8$, $R^9$, $R^{10}$, $R^{11}$, $R^{12}$, $R^{13}$, $R^{14}$, and $R^{15}$ represent identical or different substituents, each representing a hydrogen atom, a methyl group, an ethyl group, a linear, branched, or cyclic alkyl group having 3 to 12 carbon atoms.

**13.** A patterning process, comprising the steps of:

(1) applying the negative photosensitive resin composition according to any one of claims 1 to 12 onto a substrate to form a photosensitive material film;
(2) after heating the photosensitive material film, exposing the photosensitive material film to a high-energy beam having a wavelength of 190 to 500 nm or an electron beam through a photomask; and
(3) developing the exposed photosensitive material film using an aqueous alkaline solution as a developer, preferably, further comprising the step of:
(4) post-curing the developed photosensitive material film by heating at a temperature of 100 to 300°C.

**14.** An interlayer insulating film, comprising a cured product of the negative photosensitive resin composition according to any one of claims 1 to 12, or
a surface protection film, comprising a cured product of the negative photosensitive resin composition according to any one of claims 1 to 12.

**15.** An electronic component, comprising the interlayer insulating film according to claim 14, or comprising the surface protection film according to claim 14.

Europäisches Patentamt
European Patent Office
Office européen des brevets

# EUROPEAN SEARCH REPORT

Application Number
EP 23 17 0359

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | EP 3 951 499 A1 (SHINETSU CHEMICAL CO [JP]) 9 February 2022 (2022-02-09)<br>* claims *<br>* para. [0001], [0195]-[0253] *<br>----- | 1,4,5,8, 13-15<br>2,3,6,7, 9-11 | INV.<br>G03F7/038<br>G03F7/004 |
| Y | JP 2014 142458 A (SHINETSU CHEMICAL CO) 7 August 2014 (2014-08-07)<br>* the whole document *<br>----- | 1-15 | |
| Y | EP 3 604 390 A1 (SHINETSU CHEMICAL CO [JP]) 5 February 2020 (2020-02-05)<br>* claims *<br>* para. [0001], [0223-[0225] *<br>* example *<br>----- | 1-15 | |
| A | EP 3 893 054 A1 (FUJIFILM CORP [JP]) 13 October 2021 (2021-10-13)<br>* claims *<br>* examples *<br>----- | 1-15 | |
| A | US 2019/369496 A1 (KAWABATA TAKESHI [JP] ET AL) 5 December 2019 (2019-12-05)<br>* claims *<br>* page Table 2 *<br>----- | 1-15 | TECHNICAL FIELDS SEARCHED (IPC)<br>G03F |

The present search report has been drawn up for all claims

1

| Place of search | Date of completion of the search | Examiner |
|---|---|---|
| Munich | 22 September 2023 | Borowczak, Baptiste |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 17 0359

This annex lists the patent family members relating to the patent documents cited in the above-mentioned European search report. The members are as contained in the European Patent Office EDP file on
The European Patent Office is in no way liable for these particulars which are merely given for the purpose of information.

22-09-2023

| Patent document cited in search report | Publication date | Patent family member(s) | Publication date |
|---|---|---|---|
| EP 3951499 A1 | 09-02-2022 | CN 114063387 A | 18-02-2022 |
| | | EP 3951499 A1 | 09-02-2022 |
| | | JP 2022029427 A | 17-02-2022 |
| | | KR 20220017362 A | 11-02-2022 |
| | | TW 202210944 A | 16-03-2022 |
| | | US 2022043348 A1 | 10-02-2022 |
| JP 2014142458 A | 07-08-2014 | JP 5920229 B2 | 18-05-2016 |
| | | JP 2014142458 A | 07-08-2014 |
| EP 3604390 A1 | 05-02-2020 | CN 110790928 A | 14-02-2020 |
| | | EP 3604390 A1 | 05-02-2020 |
| | | JP 7145126 B2 | 30-09-2022 |
| | | JP 2020023666 A | 13-02-2020 |
| | | KR 20200014709 A | 11-02-2020 |
| | | TW 202012498 A | 01-04-2020 |
| | | US 2020041903 A1 | 06-02-2020 |
| EP 3893054 A1 | 13-10-2021 | CN 113168093 A | 23-07-2021 |
| | | EP 3893054 A1 | 13-10-2021 |
| | | JP 7261818 B2 | 20-04-2023 |
| | | JP WO2020116238 A1 | 14-10-2021 |
| | | KR 20210090205 A | 19-07-2021 |
| | | PH 12021551275 A1 | 06-12-2021 |
| | | SG 11202105555V A | 29-06-2021 |
| | | TW 202032267 A | 01-09-2020 |
| | | US 2021302836 A1 | 30-09-2021 |
| | | WO 2020116238 A1 | 11-06-2020 |
| US 2019369496 A1 | 05-12-2019 | CN 110325911 A | 11-10-2019 |
| | | JP 6813602 B2 | 13-01-2021 |
| | | JP WO2018151195 A1 | 21-11-2019 |
| | | KR 20190103391 A | 04-09-2019 |
| | | TW 201840645 A | 16-11-2018 |
| | | US 2019369496 A1 | 05-12-2019 |
| | | WO 2018151195 A1 | 23-08-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 49115541 A
- JP 55045746 A
- JP 3232022 B
- JP 2005049504 A
- WO 2013168675 A
- JP 5417623 B
- JP 5981465 B
- JP 6352853 B